# EUROPEAN PATENT APPLICATION

(11) **EP 4 775 114 A2**
(43) Date of publication of application: **15.07.2026**
(21) Application number: 26181752.2
(22) Date of filing: 27.02.2023
(51) Int. Cl.: A47L 11/40, A47L 11/282, A47L 11/30, H02J 7/00, H05K 7/20, H02K 5/20, A47L 7/00, A47L 11/08, A47L 11/292

(54) **CLEANING SYSTEM, CHARGING ASSEMBLY, CLEANING APPARATUS AND TRAY**

(30) Priority: 20.03.2022 CN 202210274127; 20.03.2022 CN 202210274029; 20.03.2022 CN 202210274047; 20.03.2022 CN 202210274075; 25.03.2022 CN 202210306734
(62) Divisional of application: 23773560.0
(71) Applicant: Tineco Intelligent Technology Co., Ltd., Suzhou, Jiangsu 215168 (CN)
(72) Inventor: CAO, Jianhua, SUZHOU, JIANGSU, 215168 (CN); CAO, Fei, SUZHOU, JIANGSU, 215168 (CN); MA, Zhuang, SUZHOU, JIANGSU, 215168 (CN); CHAO, Fu, SUZHOU, JIANGSU, 215168 (CN); WU, Huiguo, SUZHOU, JIANGSU, 215168 (CN); DANG, Yazhou, SUZHOU, JIANGSU, 215168 (CN); XU, Jiaxin, SUZHOU, JIANGSU, 215168 (CN); LIU, Yonghai, SUZHOU, JIANGSU, 215168 (CN); ZHOU, Chunfeng, SUZHOU, JIANGSU, 215168 (CN); REN, Huaiqiang, SUZHOU, JIANGSU, 215168 (CN)
(74) Representative: Dondi, Silvia

(57) **Abstract**

A cleaning system, a charging assembly, a cleaning device, and a tray. The cleaning system comprises a cleaning device(1), a tray (2), and a charging assembly. The cleaning device (1) comprises a body (11) and a floor brush assembly (12).The floor brush assembly (12) is provided with rollers (120) which are configured to rotate around an X-axis, the floor brush assembly (12) is configured to be able to rotate at least in the X-axis direction relative to the body (11);the charging assembly comprises a male charging end (3) and a female charging end (4) which are matched with each other, wherein one of the male charging end (3) and the female charging end (4) is provided on the body (11), and the other one is provided on the tray (2); two opposite sides of the male charging end (3) in the X-axis direction are respectively provided with first electrode sheets (31); and the positions of the female charging end (4) corresponding to the male charging end (3) are respectively provided with second electrode sheets (41). In the cleaning system, the body (11) rotates in the X-axis direction and thus causes abrasion, and the first electrode sheets (31) of the male charging end (3) are provided on either side of the X-axis direction, thereby avoiding the problem of poor contact between the male charging end (3)and the female charging end (4) caused by the shaking of the body (11) relative to the floor brush assembly (12) along the X-axis.

## Description

This application claims priorities to the following Chinese Patent Application:
Chinese Patent Application No. 202210274029.3 titled "CLEANING SYSTEM, CHARGING ASSEMBLY, CLEANING APPARATUS, AND TRAY", filed on March 20, 2022 with the China National Intellectual Property Administration (CNIPA);
Chinese Patent Application No. 202210274047.1 titled "CLEANING APPARATYS", filed on March 20, 2022 with the CNIPA;
Chinese Patent Application No. 202210274075.3 titled "CLEANING APPARATUS AND MOTOR ASSEMBLY", filed on March 20, 2022 with the CNIPA;
Chinese Patent Application No. 202210274127.7 titled "CLEANING APPARATUS AND CLEANING ASSEMBLY", filed on March 20, 2022 with the CNIPA; and
Chinese Patent Application No. 202210306734.7 titled "CHARGING STATION, UPRIGHT ARM, AND CLEANING SYSTEM" filed on March 25, 2022 with the CNIPA.

### FIELD

The present disclosure relates to the field of cleaning technologies, and in particular to a cleaning system; the disclosure further relates to a charging assembly applied to an electrical apparatus, and further relates to a cleaning apparatus and a tray.

### BACKGROUND

At present, most household floor cleaning machines and other cleaning apparatuses adopt charging trays. When charging, a cleaning apparatus needs to be simply placed on a charging tray, without plugging in and out of an adapter, which simplifies a charging process for users. A cleaning machine generally includes a body and a floor brush for cleaning a floor. The body is rotatable relative to the floor brush to facilitate user manipulation.

When placed on the charging tray, the body of the cleaning machine may shake to a certain extent relative to the floor brush, which may result in poor contact between the cleaning machine and a contact on the charging tray. In addition, the body may be worn after a long-term use of the cleaning machine, and thus the body may tilt when placed on the charging tray, resulting in poor contact between the body and a charging part of the tray. Hence, poor charging or failure to charge is caused, so that consumer experience is significantly degraded.

### SUMMARY

In order to solve the problems in the conventional technology, a cleaning system, a charging assembly, a cleaning apparatus, and a tray are provided in the present disclosure.

According to a first aspect of the present disclosure, a cleaning system is provided. The cleaning system includes:
a cleaning apparatus, including a body and a floor brush assembly, where the floor brush assembly is provided with a roller, the roller is configured to rotate around an X-axis, and the floor brush assembly is configured to be rotatable relative to the body at least around an X-axis direction;
a tray, configured for holding the cleaning apparatus; and
a charging assembly, including a charging male plug and a charging female plug fit to the charging male plug, one of the charging male plug and the charging female plug is arranged on the body, and the other one is arranged on the tray; a first pole piece is provided on each of opposite sides of the charging male plug in the X-axis direction; and a second pole piece is provided on the charging female plug at a position corresponding to the charging male plug.

In an embodiment of the present disclosure, the charging male plug is provided with an elastic device, and the elastic device is configured to drive the first pole piece to pre-press against the second pole piece.

In an embodiment of the present disclosure, the charging male plug includes a housing with a receiving cavity, and an opening communicating with the receiving cavity is provided on each of opposite sides of the housing, the first pole piece is configured to at least partially stretch out of the opening of the receiving cavity under an elastic force from the elastic device, and to at least partially retract into the receiving cavity, overcoming the elastic force from the elastic device, in response to compression by the second pole piece.

In an embodiment of the present disclosure, the elastic device is disposed in the receiving cavity, and opposite ends of the elastic device fit to two first pole pieces respectively, and push the two first pole pieces to move in opposite directions, until the two first pole pieces at least partially stretch out of the openings.

In an embodiment of the present disclosure, a moving block is movably connected in the receiving cavity of the housing, and the first pole piece is fixed on an end surface of the moving block extending out of the opening; two ends of the elastic device are respectively fitted to two moving blocks.

In an embodiment of the present disclosure, the end surface of the moving block extending out of the opening is configured as an inclined guide surface, and the first pole piece is disposed on the guide surface.

In an embodiment of the present disclosure, the charging male plug is configured as a wedge-shaped structure, and the charging female plug is configured in a shape adapted to the charging male plug.

In an embodiment of the present disclosure, a protrusion is provided on an end surface of the first pole piece for fitting to the second pole piece, and the protrusion is configured for fitting to the second pole piece.

In an embodiment of the present disclosure, the tray includes a base for fitting to the floor brush assembly, and a positioning seat provided on the base, the charging female plug is provided on the positioning seat and is configured to fit to the charging male plug on the body; or
the charging male plug is provided on the positioning seat and is configured to fit to the charging female plug on the body.

In an embodiment of the present disclosure, the charging female plug or charging male plug on the positioning seat is configured as extending vertically upward or obliquely upward.

In an embodiment of the present disclosure, a limiting part is further provided on the positioning seat, and the limiting part is configured for blocking a rotation of the body in the X-axis direction.

In an embodiment of the present disclosure, the limiting part defines a semi-open groove, a wall of the groove is configured as an inclined surface, and at least part of the body is limited within an interval between the inclined surface and the charging male plug or charging female plug on the positioning seat.

According to a second aspect of the present disclosure, a charging assembly is further provided. The charging assembly includes a charging male plug and a charging female plug for fitting to the charging male plug, where the charging male plug is configured to be rotatable relative to the charging female plug at least around an X-axis direction;
at least two first pole pieces are provided on opposite sides of the charging male plug in the X-axis direction; at least two second pole pieces are provided on the charging female plug at positions corresponding to the charging male plug.

According to a third aspect of the present disclosure, a cleaning apparatus is further provided. The cleaning apparatus is configured to be placed on a tray. The cleaning apparatus includes a body and a floor brush assembly, the floor brush assembly is provided with a roller, the roller is configured to rotate around an X-axis, and the floor brush assembly is configured to be rotatable relative to the body at least around an X-axis direction;
a charging male plug is provided on the body, and a first pole piece is provided on each of opposite sides of the charging male plug in the X-axis direction; or
a charging female plug is provided on the body, and a second pole piece is provided on each of opposite sides of the charging female plug in the X-axis direction.

According to a fourth aspect of the present disclosure, a tray is further provided. The tray is configured to hold a cleaning apparatus. A charging male plug is provided on the tray, and the first pole piece is provided on each of opposite sides of the charging male plug in an X-axis direction; or
a charging female plug is provided on the tray, and the second pole pieces is provided on each of opposite sides of the charging female plug in the X-axis direction.

A beneficial effect of the present disclosure is that: by arranging the first pole pieces of the charging male plug on both sides of the X-axis direction, the problem of poor contact between the charging male plug and the charging female plug caused when the body shakes along the X-axis relative to the floor brush assembly is avoided.

Other features and advantages of the present disclosure will become apparent from the following detailed description of exemplary embodiments of the present disclosure with reference to the accompanying drawings.

### BRIEF DESCRIPTION OF THE DRAWINGS

Figure 1 is a schematic diagram of an overall structure of a cleaning system according to an embodiment of the present disclosure;
Figure 2 is a schematic diagram of an overall structure of a cleaning system according to an embodiment of the present disclosure viewed from another perspective;
Figure 3 is a schematic structural diagram of a body and a charging male plug according to an embodiment of the present disclosure;
Figure 4 is a sectional view of a charging assembly according to an embodiment of the present disclosure;
Figure 5 is a sectional view of a charging male plug according to an embodiment of the present disclosure;
Figure 6 is a schematic diagram of a body and a positioning base according to an embodiment of the present disclosure;
Figure 7 is a schematic structural diagram of a positioning base according to an embodiment of the present disclosure;
Figure 8 is a schematic three-dimensional structural diagram of a charging base station according to an embodiment of the present disclosure;
Figure 9 is a sectional view of a charging base station according to an embodiment of the present disclosure;
Figure 10 is a schematic three-dimensional structural diagram of an upright arm according to an embodiment of the present disclosure;
Figure 11 is a sectional view of an upright arm according to an embodiment of the present disclosure;
Figure 12 is a schematic three-dimensional structural diagram of a trigger according to an embodiment of the present disclosure;
Figure 13 is a schematic three-dimensional structural diagram of a microswitch according to an embodiment of the present disclosure;
Figure 14 is a schematic three-dimensional structural diagram of an upright arm according to an embodiment of the present disclosure;
Figure 15 is a sectional view of an upright arm according to an embodiment of the present disclosure;
Figure 16 is a schematic three-dimensional structural diagram of a cleaning system according to an embodiment of the present disclosure;
Figure 17 is a partial sectional view of a cleaning system, in a first position, according to an embodiment of the present disclosure;
Figure 18 is a partial sectional view of a cleaning system, in a second position, according to an embodiment of the present disclosure;
Figure 19 schematically shows a three-dimensional structural diagram of a scraper assembly according to an embodiment of the present disclosure;
Figure 20 schematically shows a side view of a scraper assembly according to an embodiment of the present disclosure;
Figure 21 schematically shows a front view of fit between a scraper assembly and a spray assembly according to an embodiment of the present disclosure;
Figure 22 schematically shows a three-dimensional structural view of fit between a scraper assembly and a spray assembly according to an embodiment of the present disclosure;
Figure 23 is a partial enlarged view of part A in Figure 22;
Figure 24 schematically shows a sectional view of fit between a scraper assembly and a water spray assembly according to an embodiment of the present disclosure;
Figure 25 schematically shows a first sectional view of a cleaning apparatus according to an embodiment of the present disclosure;
Figure 26 is a partial enlarged view of part B in Figure 25;
Figure 27 schematically shows a second sectional view of a cleaning apparatus according to an embodiment of the present disclosure;
Figure 28 is a partial enlarged view of part C in Figure 27;
Figure 29 schematically shows a three-dimensional diagram of a partial structure of a cleaning apparatus according to an embodiment of the present disclosure;
Figure 30 schematically shows a three-dimensional diagram of a partial structure of a cleaning apparatus according to an embodiment of the present disclosure;
Figure 31 is a partial enlarged view of part D in Figure 30;
Figure 32 is a schematic structural diagram of a cleaning apparatus according to an embodiment of the present disclosure;
Figure 33 is a schematic structural diagram of a cleaning apparatus according to another embodiment of the present disclosure;
Figure 34 is a sectional view of a cleaning apparatus according to an embodiment of the present disclosure;
Figure 35 is a sectional view of a cleaning apparatus and a driving device thereof according to an embodiment of the present disclosure;
Figure 36 is a partial enlarged view of a motor assembly as in Figure 3;
Figure 37 is a partial enlarged view of a motor assembly as in Figure 4;
Figure 38 is another sectional view of a cleaning apparatus according to an embodiment of the present disclosure;
Figure 39 is a sectional view of a second support arm in a cleaning apparatus according to an embodiment of the present disclosure;
Figure 40 is a schematic structural diagram of a cleaning apparatus according to an embodiment of the present disclosure;
Figure 41 is an exploded view of a second arm and a motor assembly according to an embodiment of the present disclosure;
Figure 42 is a sectional structural view of a cleaning apparatus in use according to an embodiment of the present disclosure;
Figure 43 is an exploded view of a structure as in Figure 42;
Figure 44 is a schematic diagram of an air flow in a cleaning apparatus according to an embodiment of the present disclosure;
Figure 45 is an exploded structural view of a battery pack assembly;
Figure 46 is a schematic structural diagram of a soundproof cover according to an embodiment of the present disclosure;
Figure 47 is a schematic structural diagram of a heat dissipation housing according to an embodiment of the present disclosure;
Figure 48 is a schematic structural diagram of a battery pack assembly according to an embodiment of the present disclosure; and
Figure 49 is a sectional structural view of a cleaning apparatus including a soundproof plate according to an embodiment of the present disclosure.

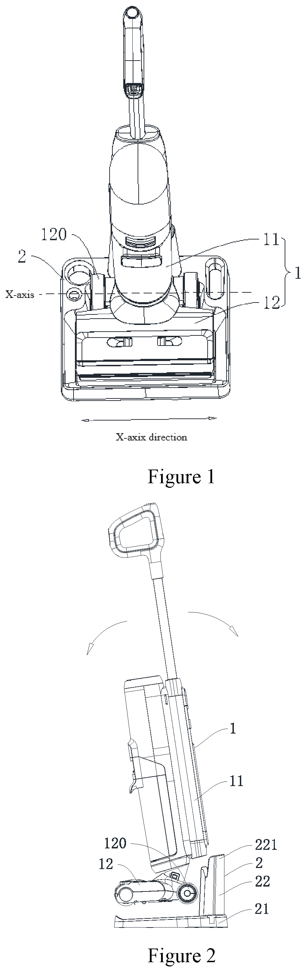

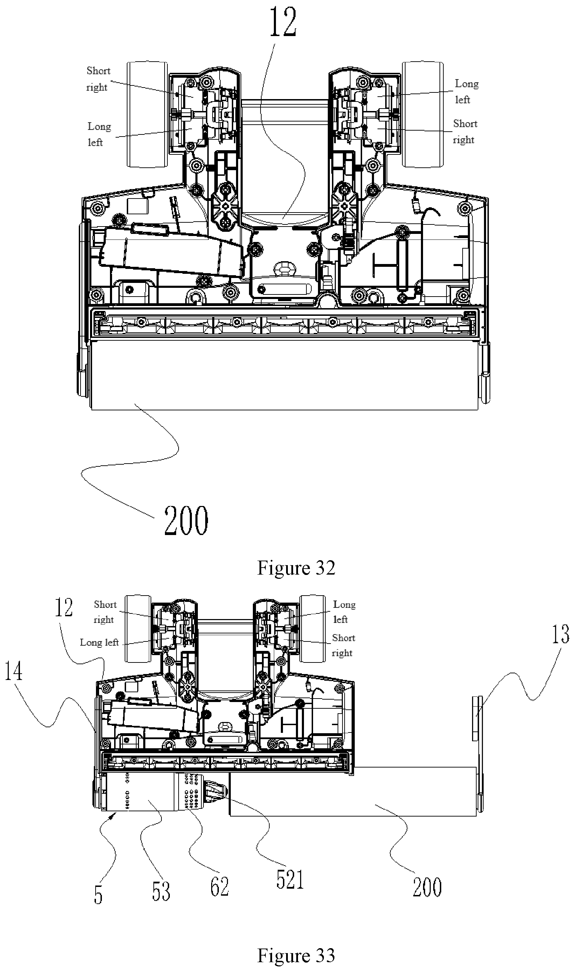

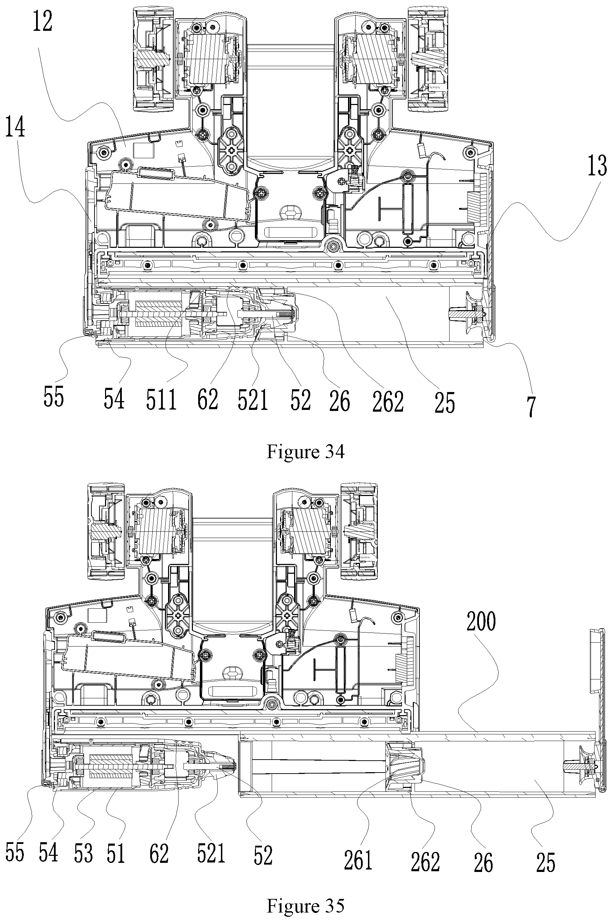

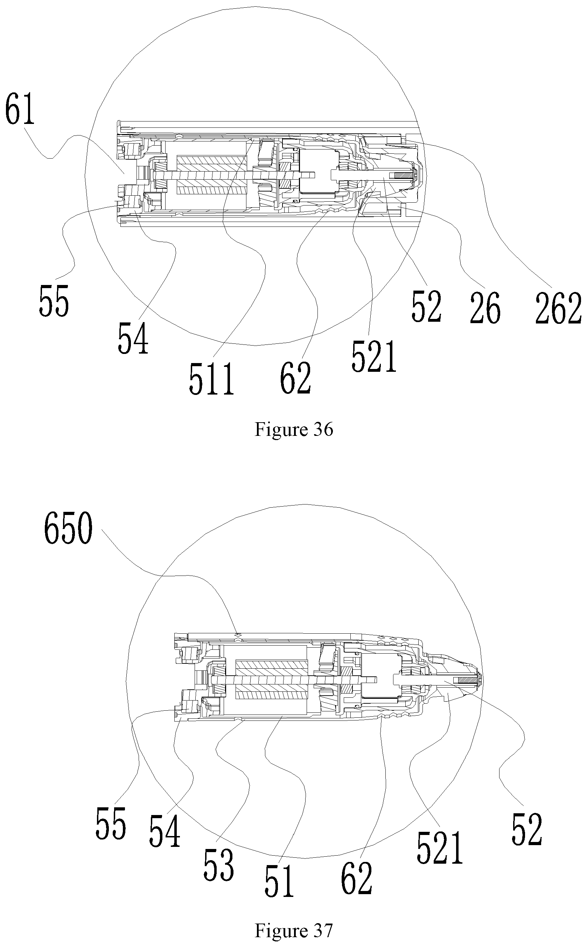

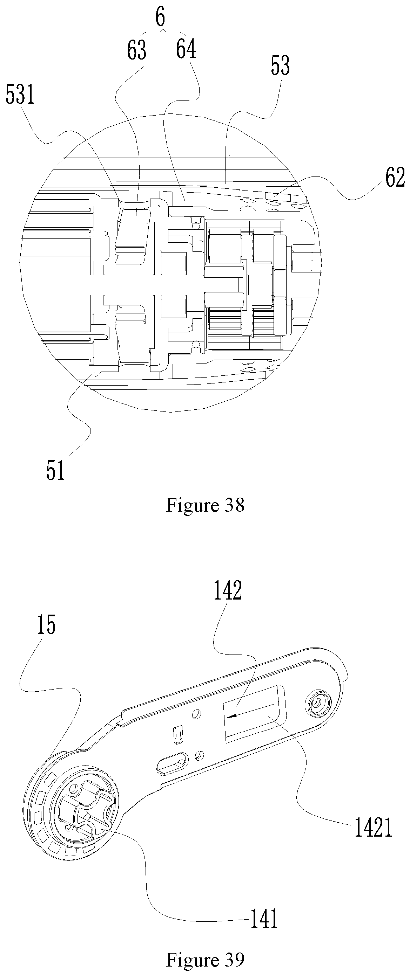

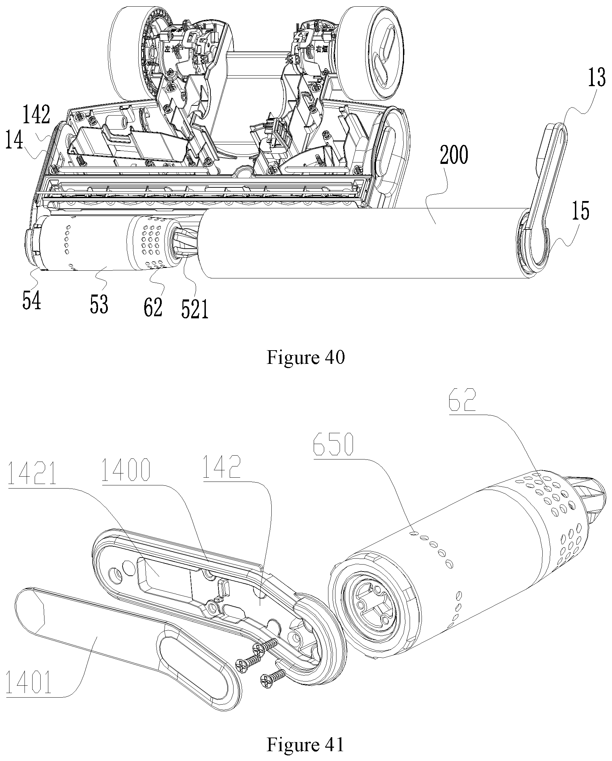

Reference sings in Figure 1 to Figure 49 and components corresponding thereto are listed below.

| | | | | | |
|---|---|---|---|---|---|
| 1 | Cleaning apparatus; | 100 | Floor brush base; | | |
| 10 | Air inlet duct; | 102 | Heat dissipation channel; | | |
| 103 | First enclosure part; | 104 | Connection part; | | |
| 105 | Second enclosure part; | 106 | Motor; | 11 | Body; |
| 110 | Casing; | 111 | Decorative cover; | | |
| 112 | Fitting part; | 12 | Floor brush assembly; | | |
| 120 | Roller; | 12 | Floor brush assembly; | | |
| 120 | Upright arm; | 121 | Supporter; | | |
| 1211 | Receiving groove; | 1212 | Blocking part; | | |
| 122 | Trigger; | 1221 | First section; | | |
| 1222 | Second section; | 1223 | Third section; | | |
| 123 | Microswitch; | 1231 | Moving part; | | |
| 124 | Elastic part; | 13 | First support arm; | | |
| 14 | Second support arm; | 141 | Connecting sleeve; | | |
| 142 | Communication channel; | 1400 | Main body; | | |
| 1401 | Cover plate; | 1421 | Communication channel entrance; | | |
| 15 | Buffer; | | | | |
| 20 | Cleaning equipment; | 200 | Rolling brush assembly; | | |
| 201 | Rolling brush; | 202 | Rolling brush motor; | | |
| 203 | Shock-absorbing pad; | 204 | Partition; | | |
| 2 | Tray; | 21 | Base; | 22 | Positioning seat; |
| 221 | Limiting part; | 2210 | Inclined surface; | | |
| 24 | Pusher; | 25 | Inner cavity; | | |
| 26 | Transmission base; | 261 | Transmission cavity; | | |
| 262 | Through hole; | 27 | Cooling fan; | | |
| 300 | Suction port; | 301 | Mounting base; | | |
| 302 | Main air inlet; | 303 | Main air outlet; | | |
| 304 | Motor shield; | 3 | Charging male plug; | | |
| 31 | First pole piece; | 311 | Protruding structure; | | |
| 32 | Elasticity device; | 33 | Housing; | | |
| 330 | Receiving cavity; | 3301 | Screen; | | |
| 331 | Opening; | 34 | Moving block; | | |
| 341 | Step groove; | 35 | Spring seat; | | |
| 400 | Scraper assembly; | 401 | Plate; | | |
| 402 | Lug; | 403 | Mounting position; | | |
| 404 | Shaft hole; | 405 | Pivot; | | |
| 406 | Reinforcement rib; | 4 | Charging female plug; | | |
| 41 | Second pole piece; | 410 | Second chamber; | | |
| 420 | First compartment; | 421 | First through hole; | | |
| 430 | Second compartment; | 431 | Second through hole; | | |
| 440 | First chamber; | 450 | First silencing plate; | | |
| 451 | Silencing hole; | 452 | Silencing cavity; | | |
| 460 | Second silencing plate; | 461 | Third through hole; | | |
| 470 | Soundproof plate; | 471, | fourth through hole; | | |
| 480 | Silencing shield; | 481 | first cover shield; | | |
| 482 | Second cover shield; | 483 | End of the silencing shield; | | |
| 500 | Spray assembly; | 501 | Water outlet; | | |
| 502 | Limiting bar; | 503 | Cell assembly; | | |
| 504. | Heat dissipation groove; | 505. | Heat dissipation inlet; | | |
| 506 | Heat dissipation through hole; | 507 | Mylar sheet; | | |
| 508 | Nickel sheet; | 509 | Battery control board; | | |
| 510 | Cell stopper; | 512 | Annular inner cavity; | | |
| 513 | Battery pack assembly; | 514 | Heat dissipation shell; | | |
| 515 | Battery compartment; | 5 | Driving device (motor assembly); | | |
| 51 | Motor housing; | 511 | Communication hole; | | |
| 52 | Output shaft; | 521 | Transmission head; | | |
| 53 | Motor shield; | 54 | Decorative sleeve; | 55 | Bearing; |
| 600 | Driver; | 6 | Heat dissipation channel; | | |
| 61 | Heat dissipation channel entrance; | 62. | Heat dissipation channel exit; | | |
| 63 | First cooling duct; | 64 | Second cooling duct; | | |
| 65 | Third cooling duct; | 650 | Heat dissipation outlet; | | |
| 700 | Sealing strip; | 701 | Drainage opening; | 7 | Air outlet; |
| 800 | Rolling brush cover; | | | | |
| 900 | Scraper blade; | 901 | First portion; | 902 | Second portion. |

### DETAILED DESCRIPTION

Various exemplary embodiments of the present disclosure are described in detail below with reference to the accompanying drawings. It should be noted that relative arrangement of components and steps, numerical expressions, and numerical values set forth in these embodiments do not limit the scope of the disclosure, unless otherwise specifically stated.

The following description of at least one exemplary embodiment is merely illustrative in nature and is in no way intended to limit the present disclosure and applications or uses thereof.

Techniques, methods and apparatuses known to those of ordinary skills in the relevant art may not be discussed in detail, but where appropriate, such techniques, methods and apparatuses should be considered a part of the specification.

In all examples shown and discussed herein, any specific value is to be construed as illustrative only and not as a limitation. Accordingly, other examples of the exemplary embodiments may have different values.

It should be noted that similar reference numerals and letters refer to similar items in the following drawings. Hence, once an item is defined in one figure, the item is not necessarily discussed further in subsequent figures.

In this specification, "upper", "lower", "front", "back", "left", "right", and the like, are merely used to express relative positional relationships between related parts, rather than to limit absolute positions of these related parts.

In this specification, "first", "second", and the like, are merely used to distinguish one from another, rather than to indicate a degree of importance, order, or prerequisite for existence of each other.

In this specification, "equal", "identical", and the like, are not limitations in a strict mathematical and/or geometric sense, but further include errors that are understandable by those skilled in the art and allowed in manufacturing or use.

The present disclosure provides a cleaning system, including a cleaning apparatus and a tray. The cleaning apparatus may be a cleaning machine, a vacuum cleaner, and other handheld cleaning apparatus well known to those skilled in the art. The cleaning apparatus may include a body and a floor brush assembly. The floor brush assembly is for cleaning a work surface. The floor brush assembly is provided with a roller. During a working process of the cleaning apparatus, the roller is configured to rotate around an X-axis. The cleaning apparatus has a predetermined travel direction during the working process, and the X-axis direction is perpendicular to the travel direction of the cleaning apparatus. The floor brush assembly is pivotally connected to the body, and is configured to be rotatable around the X-axis direction relative to the body. During use, the floor brush assembly is in contact with the ground. A user may rotate the body around the X-axis relative to the floor brush assembly, to adjust an angle of the body relative to the floor brush assembly and perform cleaning work with a comforting angle of the body. In order to make the specification clear and concise, the X-axis direction of the cleaning apparatus is defined as a left and right direction. When cleaning the floor, the body rotates around the X-axis in an upward, downward, forward, or backward direction.

The tray is configured to hold the cleaning apparatus, and charging and self-cleaning of the cleaning apparatus are performed through the tray. The cleaning system further includes a charging assembly. The charging assembly includes a charging male plug and a charging female plug, which fit to each other. One of the charging male plug and the charging female plug is disposed on the body, and the other is disposed on the tray. A first pole piece is provided on each of opposite sides of the charging male plug in the X-axis direction. A second pole piece is provided on the charging female plug at each position corresponding to the first pole piece on the charging male plug. When the cleaning apparatus is placed on the tray and the charging male plug and the charging female plug are mated, the first pole piece is in contact and electrical connection with the second pole piece, so that the tray can charge the cleaning apparatus.

The floor brush assembly is supported on the tray, and the body assembly and the floor brush assembly are inclined and extend upward at a predetermined angle. Therefore, when the body rotates relative to the floor brush assembly, the charging male plug and the charging female plug tilt or shake with the body in the same direction. The first pole piece and the second pole piece are arranged on opposite sides in the X-axis direction, so that the first pole piece and the second pole piece can remain in contact with each other when the body shakes relative to the floor brush assembly. Thereby, failure of charging due to poor contact between pole pieces is avoided.

In some embodiments of the present disclosure, as shown in Figure 1 to Figure 3, the cleaning system includes a cleaning apparatus 1 and a tray 2. The cleaning apparatus 1 includes a body 11 and a floor brush assembly 12. The floor brush assembly 12 is provided with a roller 120. The roller 120 is configured to be rotatable around the X-axis, and the floor brush assembly 12 travels on the ground through the roller 120. The roller 120 is in a quantity of two. The two rollers 120 are arranged along the X-axis direction, and a rotation axis of the rollers 120 is marked as an axis in the X-axis direction. When a user holds the cleaning apparatus 1 to clean a work surface, the rollers 120 rotate around the X-axis on the ground, thereby assisting the floor brush assembly 12 in reciprocating movements. The body 11 is movably connected to the floor brush assembly 12, so that the body 11 is rotatable at least around the X-axis direction relative to the floor brush assembly 12. In addition to rotating around the X-axis direction, the body 11 is further movable in other directions relative to the floor brush assembly 12. For example, the body can rotate around a Y-axis direction which is perpendicular to the X-axis. Alternatively, the body 11 is universally connected to the floor brush assembly 12, so that the body 11 is rotatable in an arbitrary direction relative to the floor brush assembly 12.

The cleaning apparatus of the present disclosure may be a floor sweeping robot, a floor washing robot, a handheld floor washing machine and other cleaning apparatus well known to those skilled in the art. The cleaning apparatus includes a body. The body is equipped with a cleaning device for cleaning a to-be-cleaned surface and a driving device connected to the cleaning device in a transmission way for driving the cleaning device. The cleaning device has an inner cavity. An end of the driving device may be fixedly connected to the body, and another end of the driving device extends into the inner cavity of the cleaning device and is connected to the cleaning device in a transmission way. Hence, the driving device can drive the cleaning device to move.

The cleaning apparatus 1 may be placed on the tray 2 for charging. The cleaning system further includes a charging assembly, which includes a charging male plug 3 and a charging female plug 4 that fit to each other. The charging male plug 3 of the charging assembly is disposed on the tray 2 and the charging female plug 4 is disposed on the body 11. Alternatively, the charging male plug 3 is disposed on the body 11 and the charging female plug 4 is disposed on the tray 2. When the cleaning apparatus 1 is placed on the tray 2, the charging male plug 3 can fit to the charging female plug 4, and thereby the body 11 can be charged through the tray 2.

The charging male plug 3 is provided with a first pole piece 31. The first pole piece 31 may be in a quantity of at least two. At least one of the first pole pieces 31 is a positive pole, and at least one of the second pole pieces 41 is a negative pole. The at least two first pole pieces 31 are arranged in the X-axis direction and are respectively located on opposite sides of the charging male plug 3. The structure of the charging female plug 4 fits the charging male plug 3. The charging female plug 4 has an inner cavity, in which at least one second pole piece 41 serving as a positive electrode and at least one second pole piece 41 serving as a negative electrode are disposed. The at least two second pole pieces 41 are arranged in the X-axis direction, and located on opposite sides in the inner cavity of the charging female plug 4, so that positions of the two second pole pieces 41 correspond to positions of the two first pole pieces 31. When the charging male plug 3 and the charging female plug 4 are mated, that is, when the charging male plug 3 is inserted into the inner cavity of the charging female plug 4, the first pole piece 31 on an outer side of the charging male plug 3 is in contact and electrically connected to a corresponding second pole piece 41 in the inner cavity of the charging female plug 4. Thereby, the cleaning apparatus 1 can be charged through the tray 2. The first pole piece 31 and the second pole piece 41 are both made of conductive materials, which is well-known to those skilled in the art and is not described in detail here.

When the cleaning apparatus 1 tilts or shakes on the tray 2, a direction in which the body 11 shakes is perpendicular to the direction in which the pole pieces are arranged. Therefore, the first pole piece and the second pole piece are maintained in contact when the body 11 shakes. Thereby, detaching of the first pole piece from the second pole piece is prevented, so that a charging effect is ensured. In a specific embodiment of the present disclosure, for example, the X-axis direction is defined to be the left and right direction. Since the body 11 and the floor brush assembly 12 are capable of rotating around the X-axis relative to each other, the body 11 may shake forward and backward relative to the floor brush assembly 12. In a case where the floor brush assembly 12 is supported on the tray 2 and the body 11 shakes forward and backward relative to the floor brush assembly 12, the first pole piece 31 and the second pole piece 41 respectively on the left and right sides of the body 11 are maintained in contact, so that the charging effect is ensured.

Another embodiment of the present disclosure is the same as the above embodiment, except that the at least two first pole pieces 31 are arranged in a direction perpendicular to the X-axis, and are respectively located on the front and rear sides of the charging male plug 3. One of the first pole pieces 31 faces a direction in which the cleaning apparatus travels forward, and the other one of the first pole pieces 31 faces a direction in which the cleaning apparatus travels backward. Adaptively, the charging female plug 4 is provided with two second pole pieces 41 in a direction perpendicular to the X-axis direction. One of the second pole pieces 41 faces a direction in which the cleaning apparatus travels forward, and the other one of the second pole pieces 41 faces a direction in which the cleaning apparatus travels backward. In a case where the charging male plug 3 and the charging female plug 4 are jointed, the first pole pieces 31 and the second pole pieces 41 are electrically connected in pairs. In this embodiment, the charging male plug 3 or the charging female plug 4 is provided with an elastic device. Therefore, a good electronic connection between the charging male plug 3 and the charging female plug 4 can be ensured, even if the cleaning apparatus rocks forward or backward.

Another embodiment of the present disclosure is the same as the above embodiment, except that the at least two first pole pieces 31 are arranged in the X-axis direction and are located on a front side of the charging male plug 3. That is, the at least two first pole pieces 31 are arranged at intervals on the front side of the charging male plug 3. Adaptively, the at least two second pole pieces 41 are arranged in the X-axis direction, and are located on a front side of a slot of the charging female plug 4. That is, the at least two second pole pieces 41 are arranged at intervals on the front side of the charging female plug 4. In a case where the charging male plug 3 and the charging female plug 4 are jointed, the at least two first pole pieces 31 and the at least two second pole pieces 41 are electrically connected in pairs. The first pole pieces 31 and the second pole pieces 41 are arranged on a same side, so that the problem of poor electrical connection caused by shaking of the cleaning apparatus on the tray is solved, and the problem of poor electrical connection caused by rust and impurities between pole pieces is solved.

Another embodiment of the present disclosure is the same as the above embodiment, except that the at least two first pole pieces 31 are arranged in the X-axis direction and are located on a rear side of the charging male plug 3. That is, the at least two first pole pieces 31 are arranged at intervals on the rear side of the charging male plug 3. Adaptively, the at least two second pole pieces 41 are arranged in the X-axis direction, and are located on a rear side of a slot of the charging female plug 4. That is, the at least two second pole pieces 41 are arranged at intervals on the rear side of the charging female plug 4. In a case where the charging male plug 3 and the charging female plug 4 are jointed, the at least two first pole pieces 31 and the at least two second pole pieces 41 are electrically connected in pairs. The first pole pieces 31 and the second pole pieces 41 are arranged on a same side, and are located at the rear side of the charging male plug 3 and the charging female plug 4 respectively. Thereby, stability of the electrical connection between the pole pieces are ensured. When the cleaning apparatus is placed on the tray, the cleaning apparatus is tilted toward the forward direction at a predetermined angle, for example, in a range from 5 degrees to 20 degrees. Thereby, the cleaning apparatus is enabled to stand stably on the tray. Therefore, the first pole pieces 31 and the second pole pieces 41 are all arranged on the rear side, and the cleaning apparatus is tilted toward the front side and stands on the tray, so that a stable electrical connection between the pole pieces are ensured. In an embodiment of the present disclosure, the charging female plug 4 has a slot, and the charging male plug 3 can be in plug fit with the charging female plug 4. The second pole pieces 41 are arranged in the slot of the charging female plug 4. After the charging male plug 3 is inserted into the slot, the first pole piece 31 and the second pole piece 41 located on a same side are fitted.

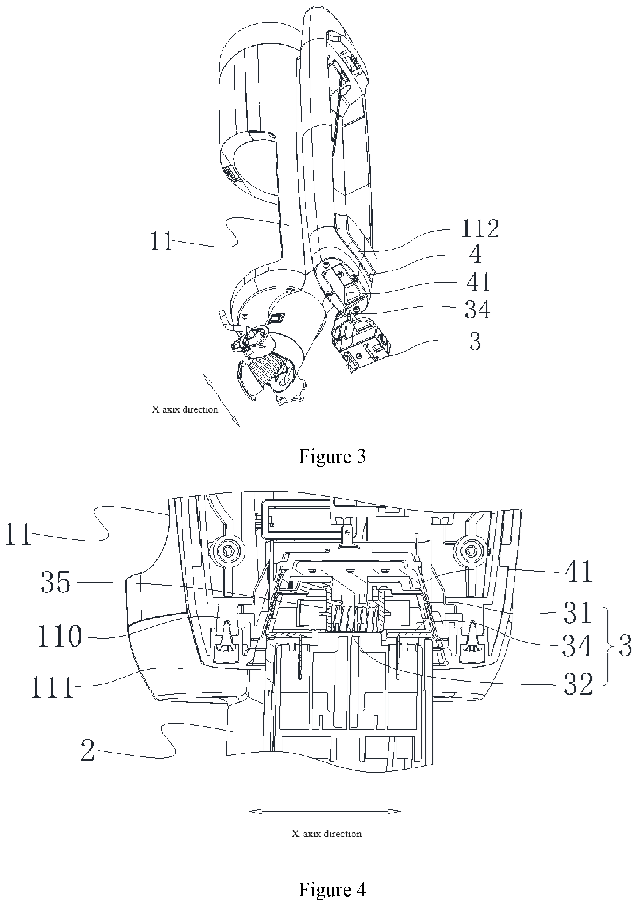

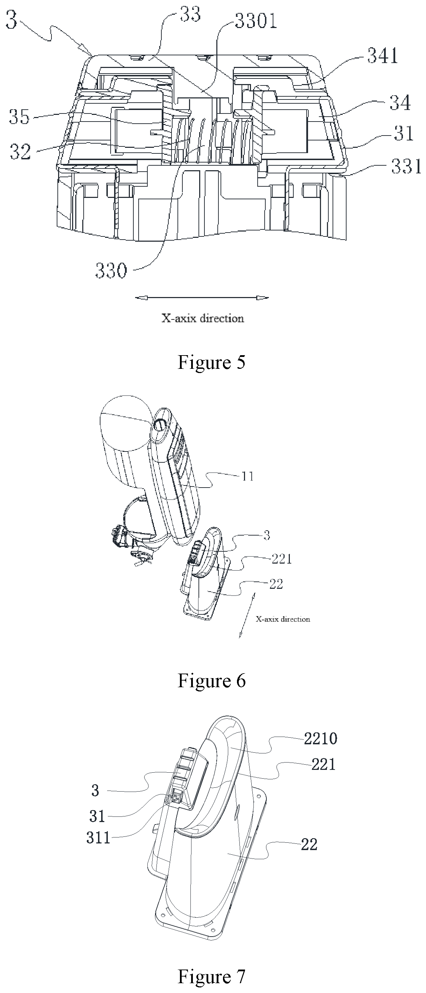

In some embodiments of the present disclosure, as shown in Figure 4 and Figure 5, the charging male plug 3 is provided with an elastic device 32. The elastic device 32 is configured to drive the first pole piece 31 to pre-press against the second pole piece 41. Therefore, it is ensured that the charging male plug 3 and the charging female plug 4 can be maintained in contact with each other after matched, thereby avoiding a problem of poor contact. The elastic device 32 may be configured to act on both the two first pole pieces 31. Alternatively, different elastic devices 32 may be adopted to act on the two first pole pieces 31 respectively. The elastic device 32 includes, but is not limited to, a spring, an elastic piece, an elastic block, or the like.

In an embodiment of the present disclosure, as shown in Figure 5, the charging male plug 3 includes a housing 33 with a receiving cavity 330. An opening 331 communicating with the receiving cavity 330 is provided on each of opposite sides of the housing 33. The first pole piece 31 is configured to at least partially stretch out of the opening 331 of the receiving cavity 330 under an elastic force from the elastic device 32, and to at least partially retract into the receiving cavity 330, overcoming the elastic force from the elastic device 32, in response to compression by the second pole piece 41.

The housing 33 of the charging male plug 3 may be configured in clearance fit with the slot of the charging female plug 4. A space is available for the housing 33 to move after being inserted into the slot. The elastic device 32 drives the first pole piece 31 to be pre-pressed on the second pole piece 41 in the slot. In this way, the charging male plug 3 can be in close fit with the charging female plug 4.

In an embodiment of the present disclosure, as shown in Figure 5, the elastic device 32 is disposed in the receiving cavity 330, and opposite ends of the elastic device 32 fit to two first pole pieces 31 respectively. In this way, the elastic device 32 can push the two first pole pieces 31 in opposite directions, so that the two first pole pieces 31 at least partially stretch out of the openings 331, respectively. The elastic device 32 may be located between the two first pole pieces 31, to provide elastic forces in opposite directions to the two first pole pieces 31. For example, the elastic device 32 may be a compression spring. The two ends of the compression spring are connected to the two first pole pieces 31 respectively, so that the force of the elastic device 32 can act on the two first pole pieces 31 simultaneously.

In another embodiment of the present disclosure, the elastic device 32 may be in a quantity of two, and both the elastic devices are disposed in the receiving cavity 330 of the housing 33. The two elastic devices 32 are fitted with the two first pole pieces 31 respectively, and push the two first pole pieces 31 in opposite directions.

In an embodiment of the present disclosure, as shown in Figure 4 and Figure 5, a moving block 34 is movably connected in the accommodation cavity 330 of the housing 33. The first pole piece 31 is fixed on the moving block 34, and is located on an end surface of a side of the moving block 34 extending out of the opening 331. Two moving blocks 34 may be configured to be in pilot fit with the receiving cavity 330, so as to be able to move in opposite directions along the receiving cavity 330. The first pole piece 31 moves with the moving block 34 in a direction of extending out of or retracting into the opening 331. The elastic device 32 in the receiving cavity 330 can be in fit with the moving block 34. Specifically, the moving block 34 is made of insulating material, and the first pole piece 31 may be connected to the moving block 34 by bonding, snapping, screw connection, or other methods well known to those skilled in the art. The elastic device 32 is disposed between two moving blocks 34. Opposite ends of the elastic device 32 fit to the two moving blocks 34 respectively, to push the two moving blocks 34 in opposite directions, so that the two first pole pieces 31 at least partially stretch out of the openings 331 of the receiving cavity 330.

In a specific implementation, the elastic device 32 is a compression spring connected between the two moving blocks 34. A spring seat 35 is provided on a side of the moving block 34 close to the elastic device 32, and two ends of the compression spring are respectively in contact with spring seats 35 of the two moving blocks 34.

In an embodiment of the present disclosure, as shown in Figure 5, a limiting structure may be provided on the moving block 34. The limiting structure cooperates with the housing 33 to prevent the moving block 34 from leaving the receiving cavity 330 of the housing 33. In a specific implementation, a step groove 341 may be provided on a side of each of the two moving blocks 34 close to the opening of the receiving cavity. The step groove 341 is able to be in snap fit with an inner edge of the opening 331 of the receiving cavity 330. The elastic device 32 is capable of pre-pressing the step grooves 341 of the two moving blocks 34 against corresponding edges of the openings of the receiving cavity. When the two moving blocks 34 are in fit with edges of the opening 331 of the receiving cavity 330, both the first pole pieces 31 at least partially stretch out of the opening 331 of the receiving cavity 330. As the first pole pieces 31 overcome the action of the elastic device 32 and moves toward the receiving cavity 330 under the action of the second pole pieces 41, the step grooves 341 of the moving blocks 34 move along the receiving cavity and leave the edge of the opening 331. In some specific embodiments, the limiting structure may be a flange, a bump, or other structure that can fit to the inner or outer edge of the opening of the receiving cavity, or may be other conventional limiting structures, as long as capable of prevent the moving block 34 from detaching from the receiving cavity 330.

In an embodiment of the present disclosure, as shown in Figure 5, a screen 3301 is provided in the receiving cavity 330. The screen 3301 extends inward from the inner wall of the receiving cavity to a position between the two moving blocks 34 and avoids the elastic device 32. As the two moving blocks 34 are squeezed and move into the receiving cavity 330 against the force of the elastic device 32, the screen 3301 can interfere with the moving blocks 34 and limit movement positions of the moving blocks 34.

In an embodiment of the present disclosure, as shown in Figure 5, the end surface of the moving block 34 extending out of the opening 331 is configured as an inclined guide surface, and the first pole piece 31 is disposed on the guide surface. Specifically, referring to the perspective in Figure 5, the guide surfaces of the two moving blocks 34 gradually approach each other from respective ends close to the tray 2 to the ends far away from the tray 2. The first pole pieces 31 are also arranged to be inclined along the guide surfaces. This is beneficial to the first pole pieces 31 to smoothly enter the slot of the charging female plug 4 and come into fit with the second pole pieces 41.

In order to facilitate the plug fit of the charging male plug 3 and the charging female plug 4, in some embodiments of the present disclosure, as shown in Figure 6, the charging male plug 3 is constructed in a wedge structure. That is, a size of the free end of the charging male plug 3 is less than a size of the connection end of the charging male plug 3 and the tray 2. The charging female plug 4 is configured in a shape adapted to the charging male plug 3. That is, the size of the slot of the charging female plug 4 gradually decreases from a slot opening to the bottom of the slot. The end size of the housing 33 of the charging male plug 3 is small, which is conducive to smooth insertion into the slot with a relatively large slot opening, and is conducive to smooth entry of the first pole piece 31 extending out of the opening 331 into the slot.

In an embodiment of the present disclosure, an inclination angle of the guide surface of the moving block 34 may be consistent with an inclination angle of the side wall of the charging male plug 3. Therefore, a good appearance is allowed, and it is conducive to mating of the charging male plug 3 and the charging female plug 4.

In other embodiments of the present disclosure, the charging male plug 3 may be configured in a tapered structure, an arc structure, or the like. This can facilitate the plug fit of the charging male plug 3 and the charging female plug 4, which is not described in detail here.

In some embodiments of the present disclosure, as shown in Figure 4, the two second pole pieces 41 are disposed in the slot of the charging female plug 4 and are located on inner walls on opposite sides of the slot. The slot structure is configured to be adapted to the wedge-shaped charging male plug 3. The two first pole pieces 31 and the two second pole pieces 41 are both inclined. The first pole piece 31 and the second pole piece 41 located on the same side are tilted in the same direction and can fit to each other.

In an embodiment of the present disclosure, as shown in Figure 4, the body 11 includes a casing 110 configured to form the slot for the charging female plug 4. The charging female plug 4 further includes a fixing bracket for fixing the second pole pieces 41. A decorative cover 111 is further provided on an outer side of the casing 110. The decorative cover 111 can press the fixing bracket against an edge of the slot. The fixing bracket is limited between the casing 110 and the decorative cover 111. The fixing bracket is made of insulating material, and the second pole pieces 41 may be connected to the fixing bracket through bonding, snapping, screw connection, and the like. The decorative cover 111 may be fixed on the casing 110 through screw connection, snap connection, plug connection, and the like.

In an embodiment of the present disclosure, as shown in Figure 7, a protrusion 311 is provided on an end surface of the first pole piece 31 for fitting to the second pole piece 41, and the protrusion 311 is configured for fitting to the second pole piece 41. The protrusion 311 may be configured in a hemispherical structure or rib structure. The protrusion 311 is set in a quantity of at least one. In a specific embodiment, three protrusions 311 are arranged in a triangular structure. The three protrusions 311 can be in contact with the second pole pieces 41, so that stability of the connection is ensured. Hence, it is avoided that a foreign matter enters between the first pole piece 31 and the second pole piece 41 and causes failure of the contact between the first pole pieces 31 and the second pole pieces 41 and thus causes disconnection of the charging circuit.

In an embodiment of the present disclosure, as shown in Figure 1 and Figure 2, the tray 2 includes a base 21 for fitting to the floor brush assembly 12, and a positioning seat 22 provided on the base 21. The charging female plug 4 is provided on the positioning seat 22 and is configured to fit to the charging male plug 3 on the body 11; or the charging male plug 3 is provided on the positioning seat 22 and is configured to fit to the charging female plug 4 on the body 11. Specifically, the base 21 may be provided with a groove and/or protrusion to be in fit with the floor brush assembly 12, in order to ensure a stability of the fir between the base 21 and the floor brush assembly 12. The positioning seat 22 is arranged higher than the base 21 and extends upward from the position connected to the base 21. Hence, the positioning seat 22 can support the body 11 to a certain extent.

In an embodiment of the present disclosure, as shown in Figure 6 and Figure 7, a limiting part 221 is further provided on the positioning seat 22, and the limiting part 221 is configured for blocking a rotation of the body 11 in the X-axis direction. The limiting part 221 may be configured to block the front and/or rear side of the body 11. The body 11 can lean on the limiting part 221 to avoid tipping forward and backward around the X-axis direction.

In an embodiment of the present disclosure, as shown in Figure 7, the charging female plug 4 or charging male plug 3 on the positioning seat 22 is configured as extending vertically upward or obliquely upward. The cleaning apparatus 1 is placed on the tray 2 from top to bottom, and the charging male plug 3 and the charging female plug 4 can be in plug fit vertically for charging. The charging male plug 3 and the charging female plug 4 can be separated from each other by simply lifting the body 11, so that the charging is finished.

In an embodiment of the present disclosure, as shown in Figure 6 and Figure 7, the limiting part 221 of the positioning seat 22 defines a semi-open groove, a wall of the groove is configured as an inclined surface 2210, and at least part of the body 11 is limited within an interval between the inclined surface 2210 and the charging male plug 3 or charging female plug 4 on the positioning seat 22. The semi-open groove provides a larger supporting surface for the body 11, realizing more stable support to the body 11. Specifically, an inner side of the groove is configured as an inclined surface 2210. The inclined surface 2210 gradually slopes outward from the lower end close to the positioning seat 22 to an upper end away from the positioning seat 22. In this way, it is easier for the body 11 to fit into the groove from top to bottom.

Referring to the embodiments shown in Figure 3 and Figure 7, the inclined surface 2210 may be configured in a shape adapted to the body 11. The body 11 may be provided with a fitting portion 112 corresponding to the position of the inclined surface 2210. The fitting portion 112 is configured in a shape adapted to the inclined surface 2210.

In a specific embodiment of the present disclosure, as shown in Figure 6 and Figure 7, the charging male plug 3 is disposed on the positioning seat 22, and the limiting part 221 extends toward the front side of the tray (towards the charging male plug 3) on both sides on the X-axis direction, forming a C-shaped semi-open groove with an opening toward a front side of the limiting part. Thereby, the rear side and the left and right sides of the body 11 can be supported, and the body 11 is prevented from moving left and right or moving to the rear side relative to the floor brush assembly 12.

In a specific embodiment of the present disclosure, as shown in Figure 6 and Figure 7, the charging male plug 3 extends vertically upward or obliquely upward. The body 11 can be fit on the positioning seat 22 from top to bottom, and the charging female plug 4 of the body 11 is in plug fit with the charging male plug 3 extending approximately vertically at a lower position. In addition, the outer wall of a corresponding position of the body 11 may abut against the wall surface of the limiting part 221 to support the body 11 to a certain extent.

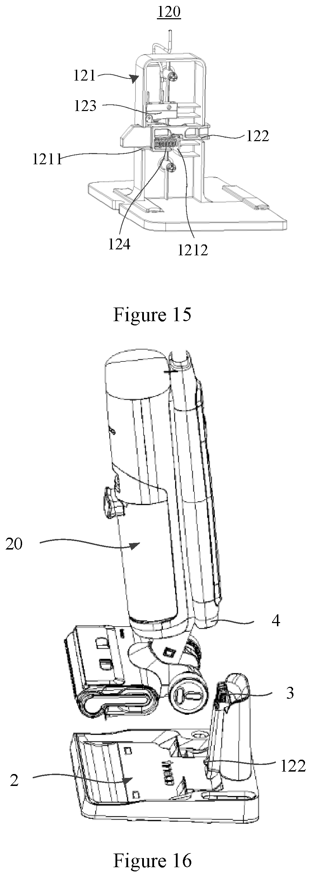

Referring to Figure 16 to Figure 18, a cleaning system is further provided in an embodiment of the present disclosure. The cleaning system includes:
a cleaning apparatus 20, including a charging female plug 4 and a pusher 24;
a tray 2 including a positioning seat 22 and a base 21, where the positioning seat 22 is disposed in the base 21.

The positioning seat 22 includes a charging male plug 3 and an upright arm 120 disposed in the positioning seat 22, where the charging male plug 3 is in contact with the charging female plug 4.

The upright arm 120 includes: a supporter 121 having a receiving groove 1211, where the receiving groove 1211 has a first position and a second position spaced apart from each other; a trigger 122 movably disposed in the receiving groove 1211, where the pusher 24 is capable of abutting against the trigger 122 and pushing the trigger 122 to move linearly between the first position and the second position; and a microswitch 123 connected to the trigger 122, where the microswitch 123 is electrically connected to the charging male plug 3.

The charging female plug 4 is not conductive to the charging male plug 3 in a case where the trigger 122 of the tray 2 is pushed by the pusher 24 to the first position. The charging female plug 4 is conductive to the charging male plug 3 in a case where the trigger 122 is pushed by the pusher 24 to the second position.

In an embodiment, a cleaning system is provided, which includes at least a cleaning apparatus 20 and a tray 2. The specific structure of the tray 2 refers to the above-mentioned embodiments. Since this cleaning system adopts all the technical solutions of all the above-mentioned embodiments, the cleaning system has at least all the beneficial effects brought by the technical solutions of the above-mentioned embodiments, which are not repeated here.

In a possible implementation, a distance between the charging male plug 3 and the trigger 122 is greater than a distance between the charging female plug 4 and the pusher 24.

In this embodiment, some parameters of the cleaning apparatus 20 and the tray 2 used together are optimized. Specifically, in order to ensure the contact between the charging female plug 4 of the cleaning apparatus 20 and the charging male plug 3 of the tray 2 and thereby ensure that the charging spark phenomenon occurs at the microswitch 123, the distance between the charging female plug 4 and the pusher 24 is set to be less than the distance between the charging male plug 3 and the trigger 122. For example, but not limited to, the charging male plug 3 is provided on the top of the tray 2, the trigger 122 is provided on the bottom of the tray 2; and correspondingly, the charging female plug 4 is provided on the top of the cleaning apparatus 20, and the pusher 24 is provided on the bottom of the cleaning apparatus 20.

A charging assembly is further provided in the present disclosure. The charging assembly is applicable to a cleaning equipment or other electrical apparatuses that need charging. The charging assembly includes a charging male plug and a charging female plug, which can be in fit with each other and perform charging. at least two first pole pieces are provided on opposite sides of the charging male plug in the X-axis direction. At least two second pole pieces are provided on the charging female plug at positions corresponding to the first pole pieces on the charging male plug. When the charging male plug rotates around the X-axis relative to the charging female plug, the paired first pole piece and second pole piece can be maintained in contact, so that the charging is not affected. Specific structure and principle of the charging assembly can be referred to the above-described cleaning system, and are not introduced in further detail here.

A cleaning apparatus is further provided in the present disclosure. The cleaning apparatus may be a cleaning machine, a vacuum cleaner, and other handheld cleaning apparatus well known to those skilled in the art. The cleaning apparatus is configured to be placed on the tray. The cleaning apparatus includes a body and a floor brush assembly. The floor brush assembly is provided with a roller configured to rotate around an X-axis. The floor brush assembly is configured to rotate around the X-axis direction relative to the body, to adjust an angle of the body relative to the floor brush assembly and perform cleaning work with a comforting angle of the body. The tray can be connected to the body through the charging assembly, and the charge the body.

A charging male plug is provided on the body, and a first pole piece is provided on each of opposite sides of the charging male plug in the X-axis direction. Alternatively, a charging female plug is provided on the body, and a second pole piece is provided on each of opposite sides of the charging female plug in the X-axis direction.

In an embodiment of the present disclosure, the body 11 is provided with a charging male plug 3, and the tray 2 is provided with a charging female plug 4 in fit with the charging male plug 3. A second pole piece 41 is provided on the charging female plug 4 at a position corresponding to the charging male plug 3. After the charging male plug 3 and the charging female plug 4 are mated, the first pole piece 31 and the second pole piece 41 are in contact and electrically connected, so that the tray 2 can charge the cleaning apparatus.

In an embodiment of the present disclosure, the body 11 is provided with a charging female plug 4, and the tray 2 is provided with a charging male plug 3 fit to the charging female plug 4. A first pole piece 31 is provided on the charging male plug 3 at a position corresponding to the charging female plug 4. After the charging male plug 3 and the charging female plug 4 are mated, the first pole piece 31 and the second pole piece 41 are in contact and electrically connected, so that the tray 2 can charge the cleaning apparatus.

Specific structure and principle of the cleaning apparatus can be referred to the above-described cleaning system, and are not introduced in further detail here.

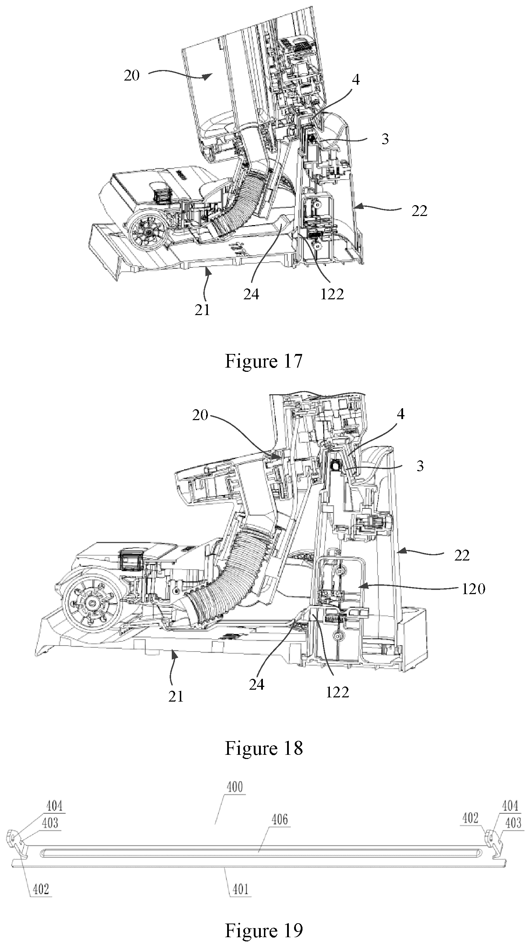

Reference is made to Figure 19 to Figure 31. A cleaning apparatus provided in an embodiment may have a floor brush base 100, a rolling brush assembly 200, a suction port 300, and a suction channel located inside the cleaning apparatus and connected to the suction port 300. The cleaning apparatus can clean a dirt on the floor through the rolling brush assembly 200 and collect the dirt on the floor through the suction port 300. The sucked dirt enters the suction channel through the suction port 300.

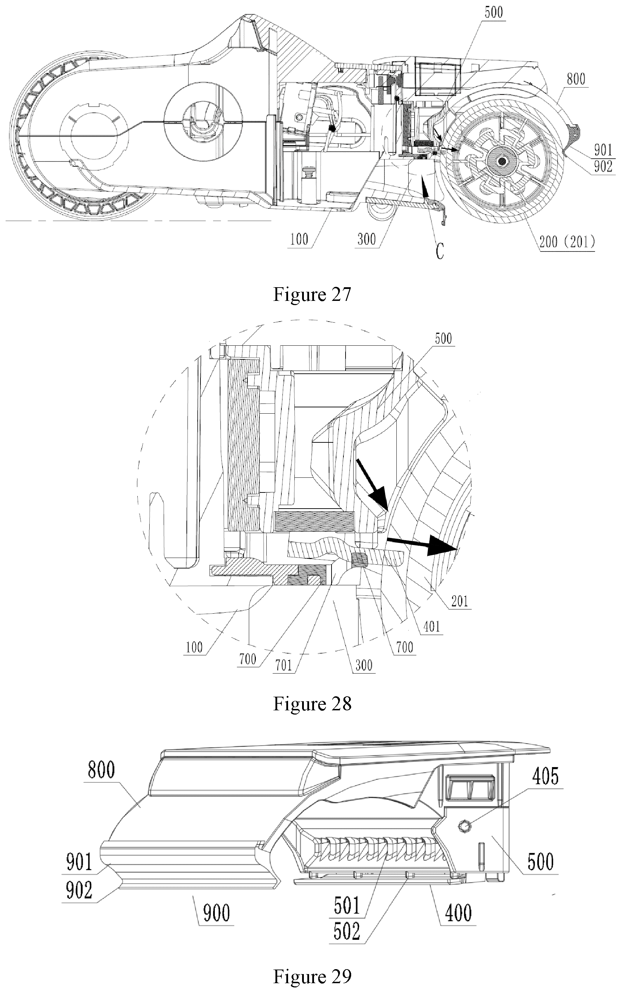

In the cleaning apparatus provided in an embodiment of the present disclosure, a function of the rolling brush assembly 200 is to pick up solids and liquids on the floor. The rolling brush assembly 200 includes a rolling brush 201. The rolling brush 201 can rotate around a first axis. The rolling brush assembly 200 cleans the solids and liquids on the floor through the rolling brush 201, and separates the solids and liquids from each other through a cooperation with a scraper. Specifically, solids and liquids on the floor can be cleaned only based on the contact between the rolling brush 201 and the floor. When the surface of the rolling brush 201 is in contact with the floor, the rolling brush 201 can adsorb the solids and liquids onto the surface of the rolling brush 201, and the solids and liquids rotate following the rotation of the rolling brush 201. Specifically, as shown in Figure 27, the rolling brush 201 rotates in a clockwise direction. During the rotation, some of the solids and liquids on the surface of the rolling brush 201 may first break away from the surface of the rolling brush 201 due to gravity, and the other solids and liquids that are not free may follow the rotation of the rolling brush 201. The surface of the rolling brush 201 with the solids and liquids adsorbed passes through the area where the scraper assembly 400 is located. With the cooperation of the scraper assembly 400, the solids and liquids are scraped off the surface of the rolling brush 201 and are thereby separated from the surface. It should be noted that the scraper assembly 400 is located above the suction port 300. The solids or liquids that are freely detached from the surface of the rolling brush 201 and the solids or liquids that are scraped from the surface of the rolling brush 201 by the scraper assembly 400 are sucked into a suction channel by the suction port 300.

A spray assembly is adopted for supplying liquids to the rolling brush. In a process of cleaning a floor with the cleaning apparatus, the cleaning liquid used is mainly provided by the spray assembly 500 in the cleaning apparatus. Specifically, the spray assembly 500 is provided with outlets 501 facing the rolling brush. The outlets are close to the surface of the rolling brush 201 and are arranged in sequence along an axial direction of the rolling brush 201. The outlets 501 are connected to a water supply device (not shown in the figure) through outlet pipes. Thereby liquid in the water supply device is directed to the surface of the rolling brush 201 through the outlets 501.

In conventional technologies, a cleaning apparatus generally adopts a metal scraper for squeezing the rolling brush 201 and scraping sewage into the suction port 300. Mostly, the metal scraper is fixed, that is, an amount of extrusion interference of the scraper to the rolling brush 201 is constant. When the cleaning apparatus works, fluff on the rolling brush 201 decreases in resilience, water absorption and other properties as a use period becomes longer, resulting in loss of the fluff of the rolling brush 201. Therefore, squeezing of the rolling brush 201 by the scraper is reduced, and a squeezing effect of the rolling brush 201 is degraded, resulting in water marks on the floor.

Based on this, as shown in Figure 19 to Figure 24, the scraper assembly 400 provided in the embodiment of the present disclosure is rotationally connected to the spray assembly 500, and is provided with a driver 600 for driving the plate 401 to rotate relative to the spray assembly 500.

A main structure of the scraper assembly 400 is the plate 401. The plate 401 is located below the spray assembly 500. The plate 401 is rotatable around a second axis, where the second axis is defined to be a rotation axis of the scraper assembly 400. The second axis is parallel to the first axis. In addition, the plate 401 is a long strip structure extending along the axial direction of the rolling brush 201, that is, extending in the first axis direction. An extension length of the plate 401 is consistent with a length of the rolling brush 201, so that full contact between the scraper assembly 400 and the rolling brush 201 is realized.

The driver 600 is configured to exert on the scraper assembly 400 a rotational force toward the rolling brush 201, to drive the plate 401 to rotate relative to the spray assembly 500. Under the driving of the driver 600, the plate 401 has a first position and a second position. At the first position, the plate 401 is maintained abutting against the rolling brush 201 under a driving force from the driver 600. The second position is a limit position that the scraper assembly 400 reaches under an action of the driver 600 in a case where the rolling brush 201 is not installed. In a case where the rolling brush 201 is installed, the plate 401 is pressed by the rolling brush 201 and rotates from the second position in a direction away from the rolling brush 201. In the cleaning apparatus provided in the embodiment of the present disclosure, the scraper assembly 400 is changed from a fixed mode to a rotatable and movable mode, so that the first position is not a unique fixed specific position throughout a use period of the rolling brush. With the reduction of the diameter of the rolling brush 201, the first position of the plate 401 changes accordingly. That is, as the diameter of the rolling brush 201 decreases due to wear and tear, the rotating scraper assembly can always keep squeezing the rolling brush 201. When the rolling brush 201 is used for a long time, the scraper still has a good scraping effect. Hence, occurrence of water marks after use of the apparatus is reduced, and the time for the floor to dry remains short. A use life of a single rolling brush 201 is extended, performance of the entire machine is improved, and user experience is improved. The scraper assembly is changed from a fixed mode to a rotatable and movable mode. As the diameter of the rolling brush decreases due to wear and tear, the rotating scraper assembly can always keep squeezing the rolling brush. When the rolling brush is used for a long time, the scraper still has a good scraping effect. Hence, occurrence of water marks after use of the apparatus is reduced, and the time for the floor to dry remains short. A use life of a single rolling brush is extended, performance of the entire machine is improved, and user experience is improved.

In the above embodiment, the driver 600 is configure to provide a force that drives the plate 401 to rotate relative to the spray assembly 500, so that the plate 401 can always press against the surface of the rolling brush 201 having a changing diameter. A specific driving mode is not specifically limited in the embodiment of the present disclosure, and any driving mechanism that can realize the above functions is possible. A specific form of the driver 600 includes, but is not limited to, a small driving motor, an elastic member or a magnetic member. From the perspective of structural simplicity and energy consumption, the driver 600 is preferably an elastic member or magnetic member.

In a case where the driver 600 is selected to be an elastic member, the elastic member may be a coil spring, a torsion spring, a rubber spring, or the like. The elastic member is preloaded and installed between the spray assembly 500 and the scraper assembly 400, so that the elastic member is in an elastic deformation between the spray assembly 500 and the scraper assembly400, driving the plate 401 to rotate relative to the spray assembly 500 by the elastic force. In a case where the rolling brush 201 is not installed, the plate 401 is driven by the elastic force to rotate to the second position. In a case where the rolling brush 201 is installed, the plate 401 is driven by the elastic force to press against the surface of the rolling brush 201, that is, the plate 401 is at the first position.

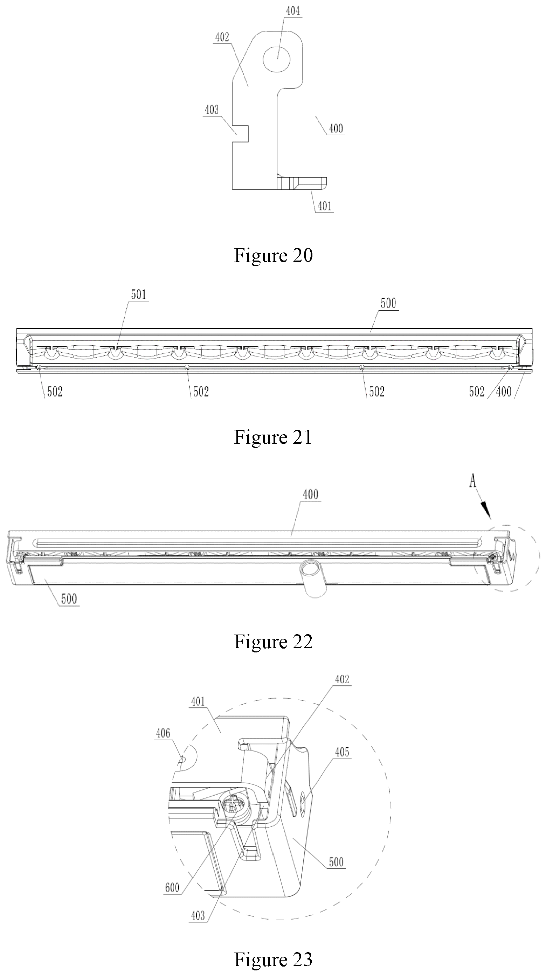

As shown in Figure 22 and Figure 23, the elastic member serving as the driver 600 is preferably a torsion spring. The torsion spring has a small structure and is easy to install, and can provide a large driving force. For example, the torsion spring may be preloaded on the spray assembly 500. Mounting positions 403 are provided on the scraper assembly 400 for fixing an end of the torsion spring. In an implementation, as shown in Figure 19, the plate 401 extends in a direction of the first axis, and lugs 402 are formed on both ends of the plate 401 in the extension direction. The lugs 402 are located on a same side of the plate 401 and are perpendicular to the plate 401. The lugs 402 are rotationally connected to the spray assembly 500 through a pivot 405. A rotation axis of the pivot 405 is the second axis. The mounting positions 403 for fixing an end of the torsion spring are openings or slots on the lugs 402. The other end of the torsion spring is fixed on the spray assembly 500. In order to facilitate installation in a small space, the torsion spring 600 is not sleeved on the pivot 405.

As shown in Figure 20, in order to realize the fit between the pivot 405 and the lugs 402, each lug 402 is provided with a shaft hole 404 that fits the pivot 405. Due to the high requirement for the straightness of the scraper, in order to eliminate the influence of errors in actual manufacturing and assembly, the shaft hole 404 to be in fit with the scraper is designed as an obround hole for error compensation. In a case where the shaft hole 404 is designed as a perfect round hole, the scraper assembly 400 may be fail to install due to a dimensional error in the scraper assembly 400. The design of the obround hole can compensate for a dimensional error so that the scraper can be installed smoothly. It should be noted that the obround hole referred to in the embodiments of the present disclosure include, but are not limited to, oval holes, waist-shaped holes, and racetrack-shaped holes.

In some embodiments of the present disclosure, at the first position, the force exerted by the plate 401 on the rolling brush 201 is in a range of 5N to 15N. In a case where the force exerted by the driver 600 on the scraper assembly 400 is excessively large, the force exerted by the plate 401 on the rolling brush 201 is increased. A large force may cause an increased load of the rolling brush motor 202 that drives the rolling brush 201, affecting a current and temperature rise in the motor. In a case where the force is small, the effect of the scraper squeezing the rolling brush 201 is degraded, affecting a drying time for the machine and other related performances. Based on experimental research, it was found that when the plate 401 exerts on the rolling brush 201 a force in the range of 5N to 15N, the current and temperature rise of the rolling brush motor 202 and the effect of the scraper squeezing the rolling brush 201 are at a better level. From continuous verification of the entire machine, it is found that the force exerted by the plate 401 on the rolling brush 201 is preferably 6N.

In some embodiments of the present disclosure, as shown in Figure 19, a reinforcing rib 406 is provided on the plate 401, and the reinforcing rib 406 is a bulge convex toward the spray assembly 500. Since the scraper and the spray assembly 500 are both long strips, and the scraper and the spray assembly 500 are connected only at both ends through the pivot 405, and there is no other connection structure in a middle position, the device is apt to deform during manufacturing, transportation, and assembly processes. In addition to selecting a more rigid material and increasing a material thickness, a bulge structure as the above-mentioned reinforcing ribs 406 may be additionally provided. The bulge structure is convex toward the spray assembly 500, that is, the bulge protrudes upward during use. With such design structure, dirt can be prevented from accumulating between the scraper and the spray plate. Assuming that the bulge is convex in a direction away from the spray assembly 500, a pit is formed correspondingly on a side facing the spray assembly 500. In this case, dirt is easily accumulated in the pit, cause contamination. On the other hand, the upward protruding bulge is able to, to a certain extent, prevent sewage or solids on the surface of the scraper from crossing the bulge and entering the inside of the cleaning apparatus.

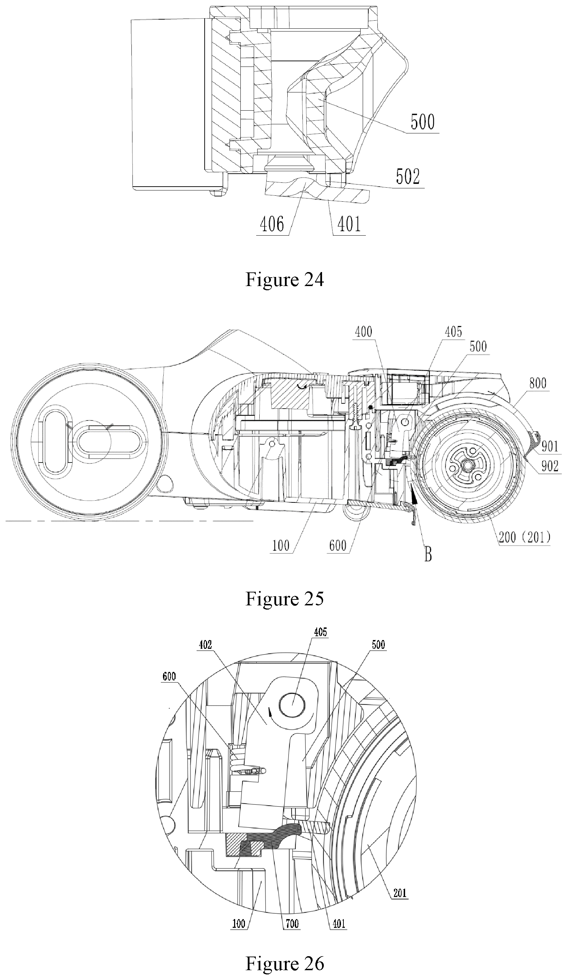

In an embodiment of the present disclosure, as shown in Figure 25 to Figure 28, when in the first position, the plate 401 is tilted relative to a horizontal plane, and a height of the plate 401 gradually decreases in a direction approaching the rolling brush 201. For example, the scraper may be arranged to be inclined downward by 2° to 10° relative to the horizontal direction when placed at the first position. When the spray assembly 500 sprays water onto the rolling brush 201 to wet the rolling brush 201, liquid usually flows onto the scraper. In this case, the liquid on the scraper may be guided to the rolling brush 201 along the slope of the scraper, rather than to flow back to the floor brush base 100 of the cleaning apparatus. A specific liquid flow is as shown by the arrow in Figure 28. Apparently, in the second position, the inclination tendency of the plate 401 can remain the same as in the first position, that is, the plate 401 is tilt relative to the horizontal plane, and a height of the plate 401 gradually decreases in a direction approaching the rolling brush 201. At this position, the scraper can reach the extreme position close to the rolling brush 201. The plate 401 is designed to guide water to the rolling brush 201 in an entire rotation range. A rotation stroke of the plate 401 around the pivot 405 is usually in a range of 3° to 8°, which may be specifically designed based on a structural dimension and spatial relationship of the actual product. For example, the rotation stroke of the plate 401 around the pivot 405 may be 5.6°.

It should be noted that in some preferred embodiments, during the entire stroke of the plate of the scraper assembly 400 between the first position and the second position, the plate 401 always exceeds the spray assembly 500. In this way, no matter whether the rolling brush 201 is installed or not, liquid dripping from the spray assembly can be received and guided by the plate 401. In this case, the plate is at the second position, and an edge on a side of the plate for abutting against the rolling brush is at a position furthest from the spray assembly.

In an embodiment of the present disclosure, a limiting bar 502 is formed on a side of the spray assembly 500 toward the plate 401; and when in the second position, the plate 401 abuts against the limiting bar 502 under a driving force from the driver 600. The limit bar 502 on the spray assembly 500 is located on a side of the spray assembly 500 close to the rolling brush 201. The spray assembly can be used to limit a slope of the scraper at the first position of the scraper, to realize a reasonable limiting function. Limiting bars 502 are evenly distributed along the direction of the first axis, and the limiting bars 502 are arranged at intervals to adapt to the elongated structure of the scraper. In addition, the limiting strips 502 can form necessary gaps between the plate 401 and the spray assembly 500. The gaps would not be closed under the action of the driver 600. That is, portions between the spray assembly 500 and the plate 401 are designed without obstruction, except for the limiting bars 502 arranged at intervals as mentioned above. The gap formed between adjacent two of the limit bars 502 can facilitate cleaning and reducing residual accumulation of dirt between the spray assembly 500 and the scraper.

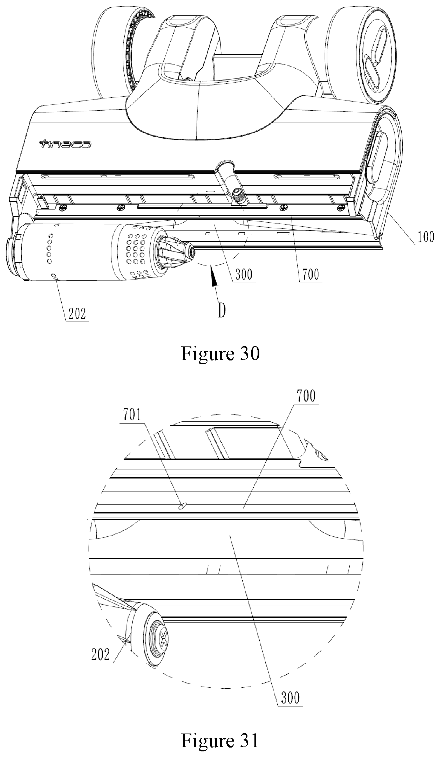

In some embodiments of the present disclosure, as shown in Figure 25 to Figure 31, the spray assembly 500 and the rolling brush 201 are both installed on the floor brush base 100. The floor brush base 100 under the plate 401 of the scraper assembly 400 is provided with a sealing strip 700. The sealing strip 700 is a long strip, and an extension length of the sealing strip is the same as the extension length of the plate 401. There is interference fit between the sealing strip 700 and a lower surface of the plate 401. Since the plate 401 in the embodiment of the present disclosure is movable, a gap which constantly changes is inevitably formed between a lower side of the plate 401 and the floor brush base 100. An interference sealing may be formed between a lower side of the sealing strip 700 and the plate 401. With the interference sealing, dirt entering the interior of the floor brush base 100 from the gap between the bottom of the plate 401 and the floor brush base 100 can be reduced. The sealing strip 700 is provided on the floor brush base 100 and is located above and close to the suction port 300. Thereby, dirt can enter only the suction port 300, without entering the floor brush base 100. Preferably, a drainage opening 701 penetrating up and down is provided in the sealing strip 700 at a position corresponding to a suction port 300 of the cleaning apparatus. Although the sealing strip 700 is provided on the floor brush base 100 below the plate body 401 of the scraper assembly 400, the sealing strip 700 is made of elastic material such as rubber, and a small amount of dirt may inevitably enter between the sealing strip 700 and the plate 401 during use. Based on this, a drainage opening 701 is opened in the sealing strip 700 at a position corresponding to the suction port 300. As shown in Figures 28 and 31, the negative pressure at the suction port 300 can be utilized to bring the dirt above the sealing strip 700 into the suction port 300. In another embodiment, the drainage opening 701 is a semi-open slot, that is, the drainage opening 701 has an open end on a side of the sealing strip 700 close to the rolling brush.

The scraper assembly 400 is preferably located behind a traveling direction of the rolling brush 201, and a contact position between the plate 401 and the rolling brush 201 is located at midpoint or higher in the vertical direction of the rolling brush 201. Thereby, a better scraping effect can be realized. In this case, regarding the position of the scraper on the spray assembly 500, as the rotation axis of the pivot 405 (i.e., the second axis) is closer to the first axis of the rolling brush 201 in the horizontal direction and farther away from the first axis of the rolling brush 201 in the vertical direction, an up-down displacement of the plate 401 during the rotation around the pivot 405 is smaller, so that the diameter of the rolling brush 201 can be reduced continuously, and great offset of a contact point between the scraper and the rolling brush 201 can be prevented. This is a guideline for designing a reasonable position of the scraper assembly 400. In some embodiments, the spray assembly 500 has a side wall parallel to the lug 402 of the scraper assembly 400, and the pivot 405 is rotationally connected to the side wall and deviates from a center of the side wall. Apparently, a specific position of the scraper assembly 400 should be determined in conjunction with an actual internal space of the product. For example, in some examples, a horizontal distance from the axis of the pivot 405 to the axis of the rolling brush 201 is determined to be 28mm, and a vertical distance from the axis of the pivot 405 to the axis of the rolling brush 201 is determined to be 19.3 mm, and the up-down displacement of the plate 401 during the rotation around the pivot 405 is small.

In an embodiment of the present disclosure, as shown in Figure 25, Figure 27 and Figure 29, the cleaning apparatus further includes a rolling brush cover 800 and a scraper blade 900. The spray assembly 500 is fixed to the rolling brush cover 800. The rolling brush cover 800 is capped over the rolling brush 201. The scraper blade 900 includes a first part 901 and a second part 902 connected to each other. The first part 901 extends obliquely downward from the rolling brush cover 800 to be in contact with the rolling brush 201. The second part 902 extends obliquely downward from an end of the first part 901 being in contact with the rolling brush 201 and gradually away from the rolling brush 201. In this implementation, the scraper blade 900 is disposed in front of the rolling brush 201, and extends along a direction of the first axis to come into contact with the rolling brush 201 in an entire axial dimension. with the scraper blade 900, water sprayed on the rolling brush 201 by a spraying plate can be evenly distribute, and the dirt can be brought out by the rolling brush 201 from the rolling brush cover 800 more smoothly, without accumulation. A second part 902 sloping downward is designed on the head of the scraper blade 900, forming an outward flanging structure, so that the dirt can be prevented from accumulating on the outer side of the scraper blade 900 due to a long-term interference operation of the rolling brush 201 and the scraper blade 900. The second part 902 can block the dirt inside the scraper blade 900.

In a conventional technology, a rolling brush motor 202 for driving the rolling brush 201 of most cleaning apparatus is placed on an outer side of the rolling brush 201, occupying space and resulting in inconsistency of the rolling brush 201 with a width of the overall machine. This may cause some areas such as a corner cannot be cleaned. Based on this, in some embodiments of the present disclosure, the rolling brush motor 202 is arranged inside the rolling brush 201. Specifically, the rolling brush assembly 200 has a rotatable rolling brush 201, and the motor assembly is arranged inside the rolling brush 201. That is, the rolling brush 201 is sleeved on the outside of the rolling brush motor 202, so that the space can be reasonably utilized. A size of the rolling brush 201 of the cleaning apparatus in an axial direction of the rolling brush may be the same as a size of the cleaning apparatus in an axial direction of the rolling brush 201, which is equivalent to increase of a length of the rolling brush 201. In this way, a cleaning area and a cleaning distance of sides of the rolling brush 201 are increased, and the problem that the corner cannot be cleaned is solved.

In some embodiments of the present disclosure, the driver 600 is selected to be a magnetic member, which may be a permanent magnet, or the like. A first permanent magnet is provided on the scraper assembly 400, and a second permanent magnet is provided on the spray assembly 500 directly opposite to the first permanent magnet. Same poles of the first permanent magnet and the second permanent magnet are arranged facing each other, driving the plate 401 to rotate relative to the spray assembly 500 by the magnetic force. In a case where the rolling brush 201 is not installed, the plate 401 is driven by the magnetic force to rotate to the second position. In a case where the rolling brush 201 is installed, the plate 401 is driven by the magnetic force to press against the surface of the rolling brush 201, that is, the plate 401 is at the second position.

The embodiments of the present disclosure further protect a cleaning assembly applied for a cleaning apparatus. The cleaning assembly includes a rolling brush cover, a spray assembly, a scraper assembly and a driver. The spray assembly is fixed inside the rolling brush cover. The scraper assembly is connected to the spray assembly and has a plate rotatable around a second axis. The plate is located below the spray assembly. The second axis is parallel to the first axis. The driver is configured for driving the plate to rotate relative to the spray assembly and pressing the plate against the rolling brush. In an embodiment, the rolling brush cover, the spray assembly, the scraper assembly and the driver are combined into an integral unit structure, which can be detachably installed on the cleaning apparatus as a whole, so that the cleaning apparatus is easy to use. It should be noted that the specific structures and working methods of the rolling brush cover, the spray assembly, the scraper assembly and the driver may refer to the cleaning apparatus embodiment provided by the embodiments of the present disclosure, and are not repeated here.

In the cleaning apparatus of the present disclosure, the driving device is arranged in the inner cavity of the cleaning device. Therefore, there is no need for an additional transmission device between the cleaning device and the driving device, so that a cleaning surface is enlarged. In addition, a heat dissipation channel is provided in the driving device to cool the cleaning device through an external airflow. The airflow after heat dissipation can further dry the inner cavity of the cleaning device.

In an embodiment of the present disclosure, as shown in Figure 1, Figure 2 and Figure 3, the cleaning apparatus includes a floor brush assembly 1. The floor brush assembly 1 is configured to carry components of the cleaning apparatus, such as a battery, a dust collection box, a sewage tank, and other component well known to those skilled in the art, which are determined according to the specific structure and function of the cleaning apparatus, and are not limited in the present disclosure. The floor brush assembly 1 is provided with a cleaning device for cleaning a to-be-cleaned surface. The cleaning device is provided with an inner cavity 25, and a driving device for driving the cleaning device is connected to the inner cavity 25 in a transmission manner. An end of the driving device is connected to the floor brush assembly 1, and the other end of the driving device extends into the inner cavity 25 of the cleaning device. The driving device is in direct contact with the cleaning device, for transmission connection, and no additional transmission components are necessary for connection. A method for the transmission connection may be a transmission connection method known to those skilled in the art, such as snap connection, bevel gear connection, and the like, which are not described in detail here.

A heat dissipation channel 6 is provided in the driving device. When the driving device works, the heat dissipation channel 6 aspires an airflow from the outside by utilizing the principle of negative pressure, to dissipate heat from an internal structure of the driving device. After the heat dissipation on the driving device, a temperature of the airflow rises, and flows out from an outlet of the heat dissipation channel 6. The airflow enters the inner cavity 25 of the cleaning apparatus and dries the inner cavity of the cleaning apparatus. Finally, the airflow can be discharged from the inner cavity 25 of the cleaning device. By arranging the driving device in the inner cavity of the cleaning device, no additional transmission device is needed for connection between the cleaning device and the driving device. Hence, it is avoided that the transmission device occupies a lateral space of the cleaning device. Additionally, a heat dissipation channel is provided in the driving device. The external airflow can not only cool the cleaning device, but also dry the inside of the cleaning device. Thereby, bacteria, odor, and the like, due to accumulation of sewage in the inner cavity of the cleaning device are avoided.

The cleaning device of the present disclosure may adopt a structure with cleaning functions that is well known to those skilled in the art. For example, the cleaning device is in a troweling plate structure. A rotation axis of the troweling plate structure is perpendicular to the to-be-cleaned surface, so that the troweling plate structure can clean the to-be-cleaned surface (e.g., a floor) while rotating along the axis. Apparently, in addition to the troweling plate structure, for those skilled in the art, the cleaning device may adopt other structures.

In a specific embodiment of the present disclosure, as shown in Figure 1, the cleaning device may be a cylindrical rolling brush assembly 2, and the inner cavity of the rolling brush assembly 2 runs through opposite ends of the rolling brush assembly. A cleaning cotton, bristles or other components for cleaning may be provided on an outer surface of the rolling brush assembly 2.

An end of the rolling brush assembly 2 is rotationally connected to the floor brush assembly 1, so that the floor brush assembly 1 support an end of the rolling brush assembly 2. An end of the driving device is connected to the floor brush assembly 1, and the other end of the driving device extends into the inner cavity 25 of the rolling brush assembly 2, and is connected with the rolling brush assembly 2 in a transmission manner. Thereby, the driving device can provide support for the rolling brush assembly 2. Through the rotation of an output end of the driving device, the rolling brush assembly 2 can be driven to rotate relative to the floor brush assembly 1, to complete cleaning of the to-be-cleaned surface.

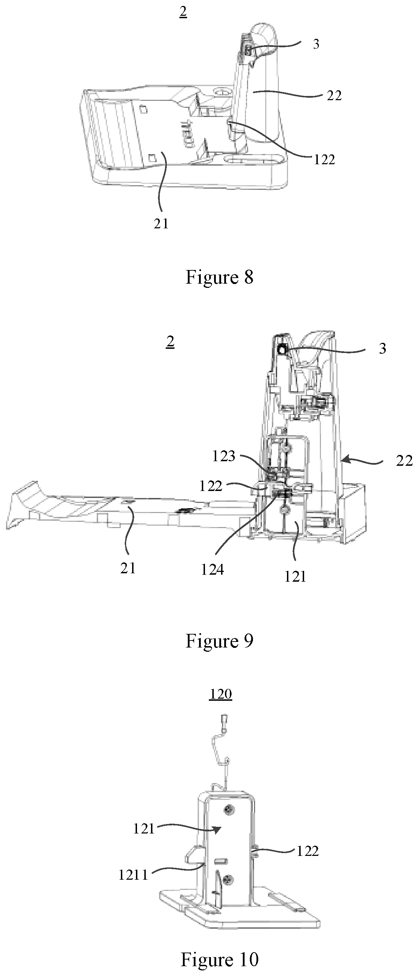

In an embodiment of the present disclosure, as shown in Figure 2, Figure 3 and Figure 8, the floor brush assembly 1 is further provided with two arms arranged oppositely. With the two arms, the driving device and the rolling brush assembly 2 are connected to the floor brush assembly 1. The two arms are respectively referred to as a first arm 13 and a second arm 14. In an embodiment, the first arm 13 and the second arm 14 are provided on opposite sides of the floor brush assembly 1. An end of the first arm 13 and an end of the second arm 14 are connected to the floor brush assembly 1, and the other end extends outward. Therefore, a U-shaped installation space is formed by the first arm 13, the second arm 14, and the floor brush assembly 1. The rolling brush assembly 2 and other components may be installed in the installation space. As shown in Figure 8, a buffer 15 is provided on each free ends of the first arm 13 and the second arm 14. The buffer member 15 wraps around the outer surface of the first arm 13 and the second arm 14. During a cleaning process, the cleaning apparatus may touch some hard objects such as a furniture. The buffer 15 can prevent the cleaning apparatus from being damaged when touching the hard objects. The buffer 15 may be made of rubber, foam, or other materials known to those skilled in the art, which is not described in detail here.

In an embodiment of the present disclosure, a side facing a user is referred to as a front side, and a side away from the user is referred to as a rear side. In an embodiment in which the cleaning apparatus of the present disclosure is a hand-held mopping machine, the user needs to hold the cleaning apparatus to clean the floor. Referring to Figure 9, the cleaning device of the cleaning apparatus is a floor brush, and a roller is provided on a side of the floor brush facing the user. The roller assists the floor brush in walking on the ground. A rolling brush assembly 2 is provided on a side of the floor brush away from the user. That is, the rolling brush assembly 2 is arranged on the rear side of the floor brush, and the roller is arranged on the front side of the floor brush.

The first arm 13 and the second arm 14 are respectively located at edges on sides of the floor brush assembly 1 of the floor brush, and extend toward the rear side of the floor brush assembly 1, forming a U-shaped installation space between the first arm 13 and the second arm 14 and the floor brush assembly 1. The rolling brush assembly 2 may be installed in this installation space. Referring to the viewing direction in Figure 9, the first arm 13 and the second arm 14 are respectively located on the left and right sides of the floor brush assembly 1, and extend from the left and right sides of the floor brush assembly 1 to the rear side of the body (lower portion as shown in Figure 9). Free ends of the two arms are configured for installing the rolling brush assembly 2.

The first arm 13 and the second arm 14 may be fixedly installed on both sides of the floor brush assembly 1, or may be installed in a detachable manner. Referring to Figure 9, for example, a mounting groove structure may be provided on the side wall of the floor brush assembly 1. An engaging structure matching the mounting groove structure may be provided on corresponding end surfaces of the two arms, so that the two arms are mounted on the side wall of the body. It is also possible to provide a groove on the side wall of the floor brush assembly 1, so that at least part of side walls of the first arm 13 and the second arm 14 are embedded in the groove, to prevent the first arm 13 and the second arm 14 from occupying a lateral dimension of the floor brush assembly 1. The structure of the second arm 14 is similar to that of the first arm 13. An end of the second arm 14 may be fixed on the floor brush assembly 1 through screws or other methods well known to those skilled in the art. Figure 8 shows a schematic structural diagram of the second arm 14. An end surface of the second arm 14 for fitting to the floor brush assembly 1 is flat, or is configured in a shape adapted to a side wall of the floor brush assembly 1. Alternatively, a groove is provided on the side wall of the floor brush assembly 1, so that at least part of a side wall of the second arm 14 is embedded in the groove, preventing the second arm 13 from occupying a lateral dimension of the floor brush assembly 1.

In a specific embodiment of the present disclosure, outer end surfaces of the first arm 13 and the second arm 14 are flush with an end surface of the side wall of the floor brush assembly 1.

Since the rolling brush assembly 2 is located between the two arms, the thickness of the two arms occupies a cleaning area of the rolling brush assembly 2. In an embodiment of the present disclosure, the thickness of the first arm 13 and the second arm 14 is set in a range of 4mm and 6mm. Hence, a lateral space of the floor brush assembly 1 occupied by the two arms is minimized while ensuring a structural strength between the two arms and the rolling brush assembly 2, so that the rolling brush assembly 2 can provide a larger cleaning surface, and both sides of the rolling brush assembly 2 can be as close to the cleaning dead corners such as wall edges and table corners as possible during a cleaning process. Hence, the cleaning area of the cleaning apparatus is increased, and edge cleaning is enabled. In addition, the driving device is built inside the rolling brush assembly 2, and both sides of the rolling brush assembly 2 are connected to the floor brush assembly via only the first arm 13 and the second arm 14 having small thicknesses, so that the rolling brush assembly 2 can achieve a "double welt" effect. Compared with the conventional technology, the solution of the present disclosure adopts thin arms to connect sides of the rolling brush assembly 2, so that a length of the rolling brush assembly 2 is actually increased. Therefore, a single cleaning area and a side cleaning distance of the rolling brush assembly 2 are improved, so that the problem of the corners being unable to be cleaned can be effectively solved.

In an embodiment of the present disclosure, as shown in Figure 9, the first arm 13 is detachably fixed on the floor brush assembly 1, and an end of the rolling brush assembly 2 may be rotationally connected to the first arm 13 in a detachable manner through a bearing or other methods known to those skilled in the art. For example, a bearing seat may be provided at a corresponding position of the first arm 13. An inner ring of the bearing may be fixed on the bearing seat, and an outer ring of the bearing may be fixed on the inner wall of the rolling brush assembly 2, or fixed on a mounting bracket provided on the inner wall of the rolling brush assembly 2. Thereby, support and relative rotation of the rolling brush assembly 2 and the first arm 13 is realized. Alternatively, the rolling brush assembly 2 and the first arm 13 are rotationally connected to each other in a detachable manner. On the basis of ensuring the rotational fit between the rolling brush assembly 2 and the first arm 13, the rolling brush assembly 2 may be removed from the first arm 13, to facilitate a user to replace or maintain the cleaning drum when the rolling brush assembly 2 is worn or damaged.

An end of the driving device is fixedly connected to the second arm 14, and the other end of the driving device penetrates into the inner cavity of the rolling brush assembly 2. The output end of the driving device is connected to the rolling brush assembly 2 in a transmission manner, so that the driving device can drive the rolling brush assembly 2 to rotate. Since the driving device is provided on the second arm 14, the first arm 13 can be removed so as to extract the rolling brush assembly 2 in a case where the cleaning apparatus needs to be maintained, for example, when the cleaning drum needs to be disassembled.

Specifically, the user usually performs a disassembly operation in a posture facing the rear side of the cleaning apparatus, that is, the cleaning apparatus is rotated so that the side where the rolling brush assembly 2 is located faces the user. In this state, the first arm 13 is on the right side of the floor brush assembly 1, and the second arm 14 is located on the left side of the floor brush assembly 1. When the user needs to disassemble the rolling brush assembly 2, since the first arm 13 is on the right side of the rolling brush assembly 2, the user can disassemble the first arm 13 with the right hand, which facilitates the user operation.

In an embodiment of the present disclosure, as shown in Figures 2 and Figure 3, the driving device is the driving device 5, and the driving device 5 is fixedly connected to the second arm 14 through a connection end. The fixed connection may be realized through bolts. Apparently, the fixed connection may be realized through other modes known to those in the art, which is not described in detail here. The driving device 5 extends toward the inside of the rolling brush assembly 2 and extends from an end of the rolling brush assembly 2 into the inner cavity 25 of the rolling brush assembly 2. The output end of the driving device 5 is in transmission fir with the inner wall of the rolling brush assembly 2. Rotation of the driving end drives the rolling brush assembly 2 to rotate to clean the to-be-cleaned surface.

In an embodiment of the present disclosure, as shown in Figure 4 and Figure 5, the driving device 5 includes a motor housing 51 and an output shaft 52. Apparently, for those skilled in the art, the driving device 5 further includes a stator and rotor in the motor housing 51, which is not described in detail here. The motor housing 51 is configured as a whole to have a shape adapted to the inner cavity 25 of the rolling brush assembly 2, such as a cylindrical shape. The output shaft 52 extends from an end of the motor housing 51, and the rolling brush assembly 2 is in transmission fit with the output shaft 52. Hence, the output shaft 52 can drive the rolling brush assembly 2 to rotate to clean the to-be-cleaned surface.

The driving device 5 is provided with a heat dissipation channel 6. When the driving device 5 operates, the external airflow can flow into the heat dissipation channel 6 due to a negative pressure. Specifically, referring to Figure 7, a cooling fan 27 is provided in the motor housing 51. The cooling fan 27 may be fixed on the rotor of the driving device 5. The rotor supplies power for the rotation of the cooling fan 27. Through the rotation of the cooling fan 27, negative pressure is generated to attract the external airflow to flow into the heat dissipation channel 6. During the flow of the external airflow in the heat dissipation channel 6, internal components of the driving device 5 can be cooled, so that the driving device 5 can be cooled down to avoid thermal protection caused by high temperature when the driving device 5 operates.

An end of the motor housing 51 for connecting the second arm 14 is provided with a heat dissipation channel entrance 61. Referring to Figure 5, the heat dissipation channel entrance 61 is provided at a middle position of the end of the motor housing 51 and is communicated with the heat dissipation channel 6. In this way, the external airflow is allowed to enter the heat dissipation channel 6 through the heat dissipation channel entrance 61.

In an embodiment of the present disclosure, referring to Figure 8, a connecting sleeve 141 is provided on the second arm 14.

During installation, the driving device 5 may be fixed on the second arm 14 through bolts. After the motor housing 51 is fixedly connected to the second arm 14, the connecting sleeve 141 is docked with the heat dissipation channel entrance 61 on the motor housing 51. An external airflow can enter the heat dissipation channel entrance 61 on the motor housing 51 through the connecting sleeve 141, and then enter the heat dissipation channel 6 inside the driving device 5 to cool the driving device 5.

The other end of the connecting sleeve 141 may penetrate the side wall of the second arm 14 to communicate with the outside. In an embodiment of the present disclosure, as shown in Figure 8 and Figure 10, a communication channel 142 is provided on the second arm 14. The communication channel 142 may extend along the extension direction of the second arm 14. An end of the communication channel 142 extends to communicate with the connecting sleeve 141, and the other end of the communication channel 142 forms a communication channel entrance 1421 on the second arm 14. The communication channel entrance 1421 may be a hole opened on the second arm 14, so that external airflow can directly enter the communication channel 142 from the hole and enter the heat dissipation channel entrance 61 through the connecting sleeve 141.

In an embodiment of the present disclosure, in order to allow smooth flow of the airflow in the communication channel 142 and ensure the heat dissipation effect of the driving device 5, a thickness (lateral dimension) of the communication channel 142 may be selected to be at least 3mm. The communication channel 142 with such dimension can be further used for penetrating the wiring connecting the driving device 5 to supply power to the driving device 5. That is, the communication channel 142 can not only provide airflow, but also serve as a wiring cavity for the driving device 5, so as to maximize the use of the space in the second arm 14.

In order to ensure the strength of the second arm 14, referring to Figure 10, the second arm 14 may include a main body 1400 and a cover plate 1401 fit to the main body 1400. The main body 1400 may be made of metal to ensure the strength of the second arm 14. The cover plate 1401 may be covered on an outer side of the main body 1400. The communication channel 142 is enclosed by the cover plate 1401 and the main body 1400. Such structure is beneficial to wiring operations in the communication channel 142. Material of the cover is not limited, which may be metal or plastic, and is not limited here.

In an embodiment of the present disclosure, as shown in Figure 3 and Figure 4, the driving device 5 further includes a motor shield 53. The shape of the motor shield 53 is similar to the shape of the motor housing 51, and is generally cylindrical. The motor shield 53 is arranged outside the motor housing 51. The sewage in the rolling brush assembly 2 can be blocked by the motor shield 53, and cannot directly enter the motor housing 51 and affect the operation of the driving device 5.

In an embodiment of the present disclosure, as shown in Figure 3 and Figure 7, the heat dissipation channel 6 includes a first cooling duct 63 and a second cooling duct 64. The first cooling duct 63 and the second cooling duct 64 are connected to each other. The first cooling air duct 63 is disposed inside the motor housing 51, and an air inlet of the first cooling duct 63 is the above-mentioned heat dissipation channel entrance 41. There is a gap between the motor shield 53 and the motor housing 51, and the gap between the two forms the second cooling duct 64. The motor housing 51 is provided with a communication hole 511, through which the first cooling duct 63 is communicated with the second cooling duct 64. The motor shield 53 is further provided with a heat dissipation channel outlet 42. After the external airflow flows out from the first cooling duct 63, the airflow enters the second cooling duct 64, and then enters the inner cavity 25 of the rolling brush assembly 2, that is, the airflow flows toward the first arm 13, so that the space in the inner cavity 25 of the rolling brush assembly 2 not occupied by the driving device 5 is dried.

In an embodiment of the present disclosure, there may be some intervals between the driving device 5 and the inner wall of the rolling brush assembly 2, and therefore a small amount of sewage may be stored in such gaps. In this embodiment, after the heat dissipation airflow flows out of the second cooling duct 64, most of the airflow flows toward the first arm 13, and a small part of the airflow flows toward the second arm 14. Thus, the entire inner cavity 25 of the rolling brush assembly 2 is dried, ensuring the drying effect of the inner cavity 25.

In an embodiment of the present disclosure, a gap needs to be left between the motor shield 53 and the motor housing 51 for relative rotation between the two. Therefore, in addition to the second cooling duct 64 for flowing toward the first arm 13, a third cooling duct 65 for flowing toward the second arm 14 is formed between the motor shield 53 and the motor housing 51. The third cooling duct 65 and the second cooling duct 64 are divided by the communication hole 511 provided on the motor housing 51. That is, after the airflow flows out from the communication hole 511 in the first cooling duct 64, part of the airflow may flow toward the first arm 13 along the second cooling duct 64, and part of the airflow may flow toward the second arm 14 along the third cooling duct 65.

In order to allow the airflow in the third cooling duct 65 to flow out, a heat dissipation outlet 650 may be provided on the motor shield 53 at a position corresponding to the third cooling duct 65. After the airflow in the third cooling duct 65 flows out of the heat dissipation outlet 650, most of the airflow may flow toward the second arm 14, that is, toward the connection end of the motor assembly, and flow out from a corresponding end of the rolling brush assembly 2, achieving the purpose of drying the side of the rolling brush assembly 2.

Referring to Figure 2, the heat dissipation channel outlet 42 may be disposed at an end of the motor shield 53 adjacent to the output shaft 52, and surrounds in the circumferential direction of the motor shield 53. In the embodiment, with the provision of the first cooling duct 63 and the second cooling duct 64, sewage in the rolling brush assembly 2 can be prevented from entering the inside of the motor housing 51 through the heat dissipation channel outlet 42.

In the present disclosure, the motor shield 53 may be fixedly connected with the motor housing 51. In an embodiment of the present disclosure, the motor shield 53 may be rotationally connected to the motor housing 51, so that the motor shield 53 can rotate relative to the motor housing 51. Specifically, an end of the motor shield 53 may be fixedly connected to the output shaft 52, and the other end of the motor shield may be rotationally connected to the motor housing 51.

Referring to Figure 4, Figure 5, and Figure 6, the motor shield 53 may form a transmission head 521 at an end adjacent to the output shaft 52. The transmission head 521 may be a truncated cone structure or in any other shape known to those skilled in the art. The transmission head 521 may be fixedly connected to the output shaft 52 through bolts or other forms known to those skilled in the art, and thereby rotation of the output shaft 52 can drive the motor shield 53 to rotate.

A transmission base 26 is provided on the inner wall of the rolling brush assembly 2, and reference may be made to Figure 3 and Figure 5. A transmission cavity 261 is provided on an end of the transmission base 26 facing the driving device 5. The transmission head 521 of the motor shield 53 may be in plug fit with the transmission cavity 261, so that the transmission head 521 can drive the transmission base 26 to rotate. That is, the transmission cavity 261 is configured to have a shape and size adapted to the transmission head 521. Figure 4 is a schematic sectional view of the transmission cavity 261 when separated from the transmission head 521. When installing the rolling brush assembly 2, the rolling brush assembly 2 may be handheld and moved toward the driving device 5, to allow the driving device 5 to penetrate into the inner cavity of the rolling brush assembly 2, and allow the transmission head 521 of the driving device 5 to insert into the transmission cavity 261 of the rolling brush assembly 2. In this way, the transmission cavity 261 is in transmission fit with the transmission head 521. When disassembly is required, the rolling brush assembly 2 can be separated from the driving device 5 by simply moving the rolling brush assembly 2 away from the driving device 5, referring to Figure 4 and Figure 9.

The transmission cavity 261 may be connected to the transmission head 521 in a transmission manner through a protrusion, a groove, or the like, in order to avoid slippage between the transmission cavity 261 and the transmission head 521. In an embodiment of the present disclosure, a spiral convex structure may be provided on the transmission head 521. After the spiral convex structure comes into fit with a corresponding structure on the inner wall of the transmission cavity 261, the transmission cavity 261 is in transmission fit with the transmission head 521. The transmission head 521 of the motor shield 53 is assembled in the transmission cavity 261. Two ends of the rolling brush assembly 2 are clamped by the first arm 13 and the second arm 14, so that the rolling brush assembly 2 is prevented from moving in the axial direction. Hence, stability of the rolling brush assembly 2 when rotating is ensured.

In an embodiment of the present disclosure, as shown in Figure 3 and Figure 4, a through hole 262 is provided on the transmission base 26. Therefore, the airflow flowing out from the heat dissipation channel exit 62 can pass through the through hole 262 and flow in the inner cavity 25 of the rolling brush assembly 2, so as to dry the inner cavity 25 of the rolling brush assembly 2.

In an embodiment of the present disclosure, as shown in Figure 5 and Figure 6, the driving device 5 further includes a decorative sleeve 54. The decorative sleeve 54 is annular as a whole. The motor shield 53 is rotationally connected to the motor housing 51 through the decorative sleeve 54. Specifically, the decorative sleeve 54 is rotationally connected to an end of the motor housing 51 through a bearing 55, and an end of the motor shield 53 extends to attach the decorative sleeve 54, for example, to be in contact fit or interference fit with the decorative sleeve 54. In this way, the motor shield 53 can rotate relative to the motor housing 51 under the action of the decorative sleeve 54. That is, an end of the motor shield 53 is supported on the decorative sleeve 54, or directly fit with the bearing 34 so that the bearing 34 supports an end of the motor shield 53. The other end of the motor shield 53 forms the transmission head 521 and is fixedly connected with the output shaft 52 of the driving device 5, so that the transmission head 521 of the motor shield 53 is supported by the output shaft 52.

In an embodiment of the present disclosure, in order to form a gap between the rolling brush assembly 2 and the connection end of the driving device 5, for the airflow to flow out from an end of the inner cavity 25 of the rolling brush assembly 2 adjacent to the second arm 14, a protruding rib can be provided on the decorative sleeve 54 and/or the motor shield 53. With the support from the rib and the inner wall of the rolling brush assembly 2, a gap between the driving device 5 and the rolling brush assembly 2 can be formed for airflow to escape.

The decorative sleeve 54 is provided in the driving device 5. On the one hand, the decorative sleeve can shield the bearing 55 that rotationally connects the motor shield 53 and the motor housing 51, so that the bearing 55 is not directly exposed to the external environment, and damage to the bearing 55 caused by sewage and dust in the external environment is avoided, which otherwise may shorten the service life of the bearing 55. On the other hand, the decorative sleeve 54 can play a certain decorative role on the connection between the second arm 14 and the motor housing 51, leading to a better appearance of the cleaning apparatus.

When the cleaning apparatus of the present disclosure operates, the rolling brush assembly 2 rotates under the driving by the driving device 5 through the transmission head 521 of the motor shield 53, so as to clean the to-be-cleaned surface. When the driving device 5 starts to operate, the external airflow enters the communication channel 142 through the communication channel entrance 1421 on the second arm 14 under the negative pressure formed by the driving device 5. Then, the airflow passes through the connecting sleeve 141 and the heat dissipation channel entrance 61 connected to the connecting sleeve 141, and enters the first cooling duct 63 in the motor housing 51. The airflow in the first cooling duct 63 performs heat dissipation to internal components in the motor housing 51. Then, the airflow enters the second cooling duct 64 through the communication hole 511, and enters the inner cavity 25 of the rolling brush assembly 2 through the heat dissipation channel exit 62 of the second cooling duct 64.

As the airflow after heat dissipation flows along the inner cavity 25 of the rolling brush assembly 2, the airflow may flow through the through hole 22 on the transmission base 22 and flow to the other end of the inner cavity 25, and finally flow out of the inner cavity 25. Thus, the inner cavity 25 of the rolling brush assembly 2 is dried.

In order to allow the airflow in the inner cavity 25 to flow out, an air outlet 7 may be provided at an end of the rolling brush assembly 2 connected to the first arm 13. For example, the air outlet 7 may be provided on the rolling brush assembly 2. A number of small holes penetrating the cylinder body are opened at the end of the rolling brush assembly 2 adjacent to the first arm 13, as the air outlet 7. Alternatively and preferably, the air outlet 7 may be a gap between the end of the rolling brush assembly 2 and the first arm 13. This gap is an assembly gap between the end of the rolling brush assembly 2 and a bracket of the first arm 13, rather than an additional opening provided for air outlet. Alternatively, the air outlet 7 may be provided on the first arm 13 and communicate with the inner cavity 25 of the rolling brush assembly 2, which is not limited in the present disclosure.

Compared with traditional wired cleaning apparatus, wireless cleaning apparatus is not restricted by a length of a power cord, so that a cleaning range is broadened, and user experience is improved. However, with the current market demand for miniaturization and lightweight of cleaning apparatuses, functional components such as batteries and main control boards are stacked and arranged in a limited space, occupying a large space. In addition, the main motor is noisy during operation and even more noisy at high power. The noise of most floor cleaning machine products on the market is around 80 decibels. When used for a long time, a temperature of the battery cell increases when the battery is discharged. Charging protection may occur when the temperature reaches a certain value. For most products on the market, the battery cannot be charged directly after a long-term use, and it takes more than half an hour to charge the battery. Therefore, how to perform noise reduction and cooling on these functional components is a problem to be solved.

In view of this, a cleaning apparatus is provided in the present disclosure. The cleaning apparatus includes a motor assembly. The motor assembly includes a motor shield, a silencing shield, a motor, and a partition. The silencing shield is disposed inside the motor shield. A first chamber is formed by an outer wall of the silencing shield and an inner wall of the motor shield. The first chamber is configured to extend along an axial direction of the silencing shield. An air inlet duct is provided inside the motor. At least part of the motor is arranged inside the silencing shield. A second chamber is formed by an outer wall of the motor and an inner wall of the silencing shield. The second chamber is configured to extend along an axial direction of the motor.

The partition is configured to divide the second chamber into a first compartment communicated to an outlet of the air inlet duct, and a second compartment separated from the first compartment. The air inlet duct, the first compartment, the first chamber, and the second compartment are communicated in the above-listed sequence, forming an air duct system of the motor assembly. An external airflow enters the first compartment through the air inlet duct of the motor, flows to the first chamber and finally flow out through the second compartment.

A working principle of the cleaning apparatus is as follows. The motor, when started, forms a negative pressure in the air duct system of the cleaning apparatus to generate a suction force. Thereby, an airflow flows directly or indirectly into the air inlet duct in the motor after passing through a main inlet on the motor shield. The airflow flows through the first compartment, the first chamber, the second compartment, and finally is discharged through a main outlet. In the cleaning apparatus or motor assembly of the present disclosure, the second chamber extending along the axial direction of the silencing shield is divided, by the partition, into the first compartment and the second compartment. Therefore, in the flowing of the airflow, the airflow in the second compartment does not directly enter the second compartment, but needs to first flow radially into the first chamber, and then radially flow into the second compartment which extends in the same axial direction as the first compartment, and flows out through the second compartment. In this way, the flow path for the airflow in the motor assembly is improved, allowing the airflow to have flow paths in different directions, which is conducive to gradually reducing a flow rate of the airflow. Thereby, noise of the motor assembly is reduced, and user experience is improved.

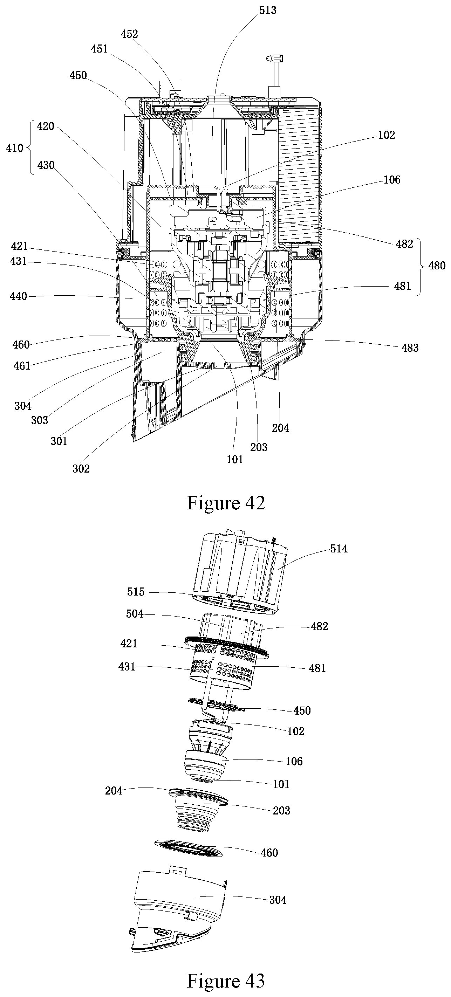

In order for a better understanding, a specific structure and working principle of the cleaning apparatus is described in detail below with reference to Figure 42 to Figure 49 in the accompanying drawings of the specification.

Referring to Figure 42, in an embodiment, the cleaning apparatus includes a motor assembly. The motor assembly includes a motor shield 304, a silencing shield 480, a motor 106 and a partition 204. The silencing shield 480 is located inside the motor shield 304. A first chamber 440 extending along an axial direction of the silencing shield 480 is formed by an outer wall of the silencing shield 480 and an inner wall of the motor shield 304.

Referring to Figure 42 to Figure 43, the motor 106 includes a first housing having an inner cavity and a second housing located in the inner cavity of the first housing. Referring to the view directions in Figure 42 and Figure 43, the first housing is cylindrical, and the second housing is installed in the inner cavity of the first housing and extends outward from the inner cavity of the first housing. An end of the second housing adjacent to the first housing shrinks radially inward, that is, the diameter gradually decreases, realizing a frustum structure, so that an air inlet duct 101 is formed between the first housing and the second housing. An outlet of the air inlet duct 101 is formed by the opening end of the first housing and a position with the smallest inner diameter of the second housing.

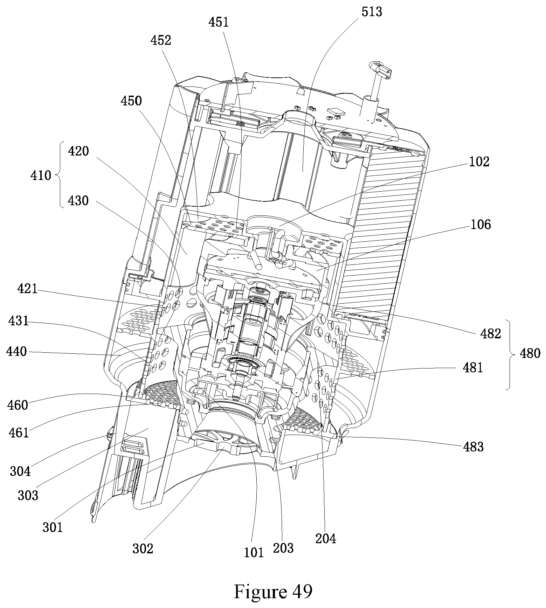

Specifically, referring to Figure 49, the first housing includes a first enclosure portion 103 located in the inner cavity of the second housing, a second enclosure located outside the second housing, and a connecting portion 104 connecting the first enclosure portion 103 and the second enclosure portion 105. A size of the first enclosure portion 103 is less than a size of the second enclosure portion 105. One end of the connecting portion 104 is connected to the second enclosure portion 105, and the other end of the connecting portion gradually shrinks to correspond to the size of the first enclosure portion 103, to be connected with the first enclosure portion 103. In other words, the connecting portion 104 is connected between the first enclosure portion 103 and the second enclosure portion 105, and the size of the connecting portion 104 gradually decreases from the position connected with the second enclosure portion 105 to the position connected with the first enclosure portion 103, so that the connecting portion 104 can smoothly transition between the first enclosure portion 103 and the second enclosure portion 105. The first enclosure portion 103, the connecting portion 104, and the second enclosure portion 105 may be integrally formed.

Reference is further made to Figure 49. There is a gap between the open end of the first housing and the connecting portion 104, and the gap serves as the outlet of the air inlet duct 101. Alternatively, there may be a gap between the open end of the first housing and the first enclosure portion 103, and the gap serves as the outlet of the air inlet duct 101.

The silencing shield 480 may have a cylindrical structure. The silencing shield 480 is installed behind the inner cavity of the motor shield 304, so that an annular first chamber 440 is formed between an outer wall of the silencing shield 480 and an inner wall of the motor shield 304. The first chamber 440 extends along the axial direction of the motor shield 304 and the silencing shield 480. In an embodiment of the present disclosure, the silencing shield 480 includes a first shield body 481 and a second shield body 482 that are connected to each other. The first chamber 440 may be formed at least by an outer wall of the first shield body 481 and an inner wall of the motor shield 304.

The motor 106 extends into the interior of the silencing shield 480, so that a second chamber 410 is formed by the motor housing of the motor 106 and the inner wall of the silencer cover 480. The second chamber 410 is an annular chamber and extends along the axial direction of the motor 106 and the silencing shield 480. A specific shape of the second chamber 410 is related to shapes of the silencing shield 480 and the motor 106 and is not discussed in detail here. Therefore, the first chamber 440 is distributed around the periphery of the second chamber 410, and the two chambers are separated by the side wall of the silencing shield 480.

The motor 106 has an air inlet duct 101. When the motor 106 operates, an external airflow enters from an entrance of the air inlet duct 101 under the action of a blade assembly. After flowing along the extension direction of the air inlet duct 101, the airflow is discharged from the outlet of the air duct 101. The outlet of the air inlet duct 101 is connected with the second chamber 410, so that the airflow discharged from the outlet of the air inlet duct 101 can enter and flow in the second chamber 410.

The partition 204 is disposed in the second chamber 410, and is configured to divide the second chamber 410 into a first compartment 420 communicated to an outlet of the air inlet duct 101, and a second compartment 430 separated from the first compartment 420.

Referring to Figure 42, the partition 204 extends from the position of the motor 106 to the position of the first shield body 481, and is sealed with the side wall of the motor 106 and the inner wall of the first shield body 481, thereby dividing the second chamber 410 into the first compartment 420 and the second compartment 430. The first compartment 420 and the second compartment 430 are distributed in the axial direction of the motor 106 and the silencing shield 480. Referring to the view direction in Figure 42, the first compartment 420 is located above the second compartment 430. In Figure 42, the partition 204 has a double-layer sealing structure. In other embodiments, the partition 204 may have a single-layer sealing structure.

The air inlet duct 101, the first compartment 420, the first chamber 440, and the second compartment 430 are communicated in the above-listed sequence, forming an air duct system of the motor assembly.

Specifically, when the cleaning apparatus operates, the motor 106 forms a negative pressure in the air duct system and generates a suction force, so that the external airflow enters the air inlet duct 101 inside the motor 106. The airflow enters the first compartment 420, and then flows to the second chamber 410. Then, the airflow flows to the second compartment 430 and flows from the second compartment 430 to the outside. Different chambers not only extend a flow path of the airflow, but also change a flow direction of the airflow, so that noise reduction is realized while the airflow flowing in the different chambers.

The partition 204 in the present disclosure may be independently disposed in the second chamber 410. In a specific embodiment of the present disclosure, a mounting base 301 is provided in the motor shield 304, and an end of the motor 106 is assembled in the mounting base 301 through a shock-absorbing pad 203. Thereby, a vibration amplitude of the motor 106 can be reduced, and noise caused by vibration when the motor 106 operates is reduced. A lower portion of the mounting base 301 is provided with a main inlet 302 to communicate with the entrance of the air inlet duct 101 of the motor 106. An opening fit to the mounting base 301 is provided at a corresponding position on the shock-absorbing pad 203, allowing an external airflow to flow into the air inlet duct 101 of the motor 106. The shock-absorbing pad 203 extends along an outer contour of the motor 106 into the second chamber 410 to form the partition 204.

That is, the partition 204 and the shock-absorbing pad 203 may be integrally formed. Referring to Figure 43, the shock-absorbing pad 203 has an inner cavity adapted to at least part of the outer contour of the motor 106, so that a part of the motor 106 can be assembled in the inner cavity of the shock-absorbing pad 203. Hence, the shock-absorbing pad 203 can provide a good buffer for the motor 106 and reduce the noise generated by the motor 106 during operation. An upper part of the shock-absorbing pad 203 extends radially outward to form the partition 204. The partition 204 divides the second chamber 410 into a first compartment 420 and a second compartment 430. With such arrangement, the channel for airflow is extended, so that the noise volume generated due to operation of the motor 106 is greatly reduced. By arranging the mounting base 301 and the shock-absorbing pad 203, the noise volume generated due to vibration of the motor 106 during operation is further alleviated, and thereby the purpose of noise reduction is achieved.

In an embodiment of the present disclosure, the shock-absorbing pad 203 has a hardness of 30 Shore A. From experimental tests, it is found that the shock-absorbing effect for the motor 106 is best when the hardness of the shock-absorbing pad 203 is 30 Shore A. In this case, the fit between the shock-absorbing pad 203 and the motor 106 can be ensured, and the buffering and shock-absorbing effect for the shock-absorbing pad 203 is best.

In this embodiment, the mounting base 301, the shock-absorbing pad 203, and the motor 106 may be detachably connected through threads, snaps, and other methods, which is not limited here. Such arrangement allows easy replacement of a component through simple disassembly when there is a problem and the replacement is required, so that a maintenance cost is saved.

Another advantage of the integral molding of the partition part 204 and the shock-absorbing pad 203 is that the partition part 204 is configured to extend radially outward from the shock-absorbing pad 203 to be in sealing contact with the interior of the silencing shield 480. Thereby, it can be ensured that there is no gap between the partition 204 and the shock-absorbing pad 203. Hence, the flow direction of the airflow is not affected by existence of a gap, thereby achieving the optimal noise reduction effect. Additionally, the partition 204 and the shock-absorbing pad 203 are configured to be integrally formed, realizing a compact overall structure of the cleaning apparatus.

In order to realize communication of the first compartment 420 and the second compartment 430 to the first chamber 440, in a specific embodiment of the present disclosure, a first through hole 421 communicating the first compartment 420 and the first chamber 440 is provided at a position on the side wall of the first shield body 481 corresponding to the first compartment 420, and a second through hole 431 communicating the second compartment 430 and the first chamber 440 is provided at a position on the side wall of the first shield body 481 corresponding to the second compartment 430. There are a plurality of first through holes 421 and the second through holes 431, and are evenly distributed in the circumferential direction of the corresponding positions of the first shield body 481.

With such configuration, the airflow in the first compartment 420 passes through the first through hole 421 before entering the first chamber 440, thereby reducing a speed of the airflow. The first through hole 421 may further play a role in flow equalization. The turbulent airflow can be equalized after passing through the first through hole 421. The airflow in the first chamber 440 then passes through the second through hole 431 for a second flow equalization and noise reduction. As the airflow flows along the above-mentioned air duct, energy of wind noise can be gradually lost, realizing the noise reduction.

In an embodiment of the present disclosure, referring to Figure 42, at least part of the end surface of the partition 204 is flush with the outlet of the air inlet duct 101, so that the partition 204 can guide the airflow flowing out from the outlet of the air inlet duct 101. The airflow flowing out from the outlet of the air inlet duct 101 can smoothly flow to the silencing shield 480 and flow to the first chamber 440 from the first through hole 421 on the silencing shield 480.

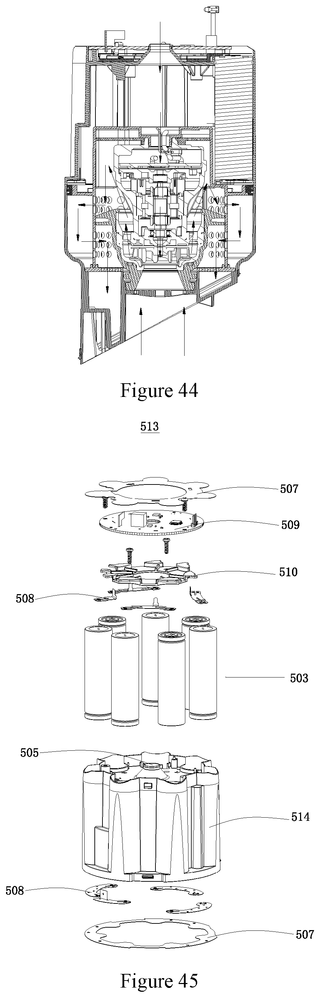

The cleaning apparatus or motor assembly of the present disclosure may be provided with additional noise reduction structures in each of the chambers. In a specific embodiment of the present disclosure, a first silencing plate 450 is provided in the first compartment 420. A silencing cavity 452 is formed by the first silencing plate 450 and an end of the silencing shield 480. An outer contour of the first silencing plate 450 is adapted to 402. Referring to Figure 42 and Figure 44, the motor 106 is located in the first shield body 481 and the second shield body 482, and an end position of the motor 106 is sealing connected to an end face of the second shield body 482. The first compartment 420 extends from the position of the first shield body 481 to the position of the second shield body 482. The first silencing plate 450 is disposed in the first compartment 420 at a position adjacent to the end of the second shield body 482 and defines the silencing cavity 452 with the end of the second shield body 482. The first silencing plate 450 is provided with evenly distributed silencing holes 451. By providing the first silencing plate 450, the airflow entering the first compartment 420 can flow into the silencing cavity 452, so as to achieve noise reduction.

Specifically, referring to the view direction in Figure 42, after the airflow enters the first compartment 420 from the outlet of the air inlet duct 101, part of the airflow flows into the first chamber 440, and part of the airflow flows upward and enters the sealed silencing cavity 452 through the silencing holes 451. With the silencing holes 451 and the silencing cavity 452, a flow rate of the airflow can be greatly reduced, and thereby silencing and noise reduction is performed.

In this embodiment, the first silencing plate 450 may be installed horizontally in the motor shield 304 or may be installed obliquely in the motor shield 304, which is not limited here. In order to ensure the silencing effect of the silencing cavity 452, a distance between the first silencing plate 450 and the end of the second shield body 482 is at least 5mm.

In a specific embodiment of the present disclosure, a second silencing plate 460 is provided in the second compartment 430, and a third through hole 461 is provided on the second silencing plate 460. The second compartment 430 is communicated with the main air outlet 303 on the motor shield 304 through the third through hole 461 on the second silencing plate 460. It can be understood that after the airflow passes through the first through hole 421 and the second through hole 431 for two rounds of flow equalization and noise reduction, the airflow flows into the second compartment 430 and then passes through the third through hole 461 on the second silencing plate 460 for the third round of silencing and noise reduction. The airflow is finally discharged through the main air outlet 303.

In a specific embodiment of the present disclosure, the second silencing plate 460 is installed inside the motor shield 304, and has an edge 483 configured to block the first chamber 440 defined by the silencing shield 480 and the motor shield 304. Specifically, an end of the silencing shield 480 abuts the second silencing plate 460, and the edge 483 of the second silencing plate 460 is sealed with the inner wall of the motor shield 304. In this way, blocking of the open ends of the first chamber 440 and the second chamber 410 by the second silencing shield plate 460 is realized. The third through hole 461 is provided on the second silencing plate 460 at a position corresponding to the second compartment 430, so that the airflow in the second compartment 430 can be discharged outward through the third through hole 461 and the main air outlet 303 of the motor shield 304.

The first chamber 440 is connected to the first compartment 420 and the second compartment 430 through only the first through hole 421 and the second through hole 431. The air flow in the first chamber 440 can only pass through the first through hole 421 and the second through hole 431. A direction of the airflow flowing through the first through hole 421 is opposite to a direction of the airflow flowing through the second through hole 431.

In this embodiment, the second silencing plate 460 may be installed horizontally in the motor shield 304 or may be installed obliquely in the motor shield 304, which is not limited here.

In a specific embodiment of the present disclosure, in order to further ensure the noise reduction effect, an aperture size of the first through hole 421 is set to be greater than an aperture size of the second through hole 431, and the aperture size of the second through hole 431 is set to be greater than an aperture size of the third through hole 461. Since the aperture sizes of the three through holes decreases sequentially, the wind pressure of the airflow when flowing can be gradually reduced, and the airflow can be gradually controlled to flow out evenly, so that a noise reduction degree of the airflow is improved.

Referring to Figure 42, in a specific embodiment of the present disclosure, an area where the first through hole 421 is located is defined as a first air outlet side, and a total air outlet area on the first air outlet side is represented by B. There are a plurality of the first through holes 421 on the silencing shield 480, which are distributed around a circumferential direction of the silencing shield 480. After flowing out from the outlet of the air inlet duct 101, the airflow flows into the first chamber 440 through the first through hole 421. On the silencing shield 480, an area where the first through hole 421 is provided is defined as a first air outlet side. A total air outlet area B of the first air outlet side is related to the quantity and aperture size of the first through hole 421. A larger quantity or greater aperture size of the first through hole 421 leads to a greater total air outlet area B of the first air outlet side.

Correspondingly, an area where the second through hole 431 are located is defined as a second air outlet side, and a total air outlet area on the second air outlet side is represented by A. There are a plurality of the second through holes 431 on the silencing shield 480, which are distributed around a circumferential direction of the silencing shield 480. An airflow in the first chamber 440 flows into the second compartment 430 through the second through hole 431. On the silencing shield 480, the area where the second through hole 431 is provided is defined as the second air outlet side. The total air outlet area A of the second air outlet side is related to the quantity and aperture size of the second through hole 431. A larger quantity or greater aperture size of the second through hole 431 leads to a greater total air outlet area A of the second through holes 431.

A total air outlet area of an outlet of the air inlet duct 101 is represented by C. As shown in Figure 42, the outlet of the air inlet duct 101 is arranged around a side portion of the motor 106. A greater outlet area of the air inlet duct 101 is more conducive to flow of an airflow in the air inlet duct 101. The total air outlet area C of the outlet of the air inlet duct 101, the total air outlet area A on the second air outlet side, and the total air outlet area B on the first air outlet side satisfy a relationship of A>B>C. Hence, it is ensured that the airflow can flow smoothly in the air duct, that is, the airflow in the air inlet duct 101 can flow out smoothly without clogging in the air duct.

In a specific embodiment of the present disclosure, an air inlet area of the main inlet 302 on the mounting base 301 is represented as D. The main inlet 302 provided on the mounting base 301 may be an opening, or may be provided as a pore plate. Air enters into the air inlet duct 101 from through holes on the pore plate. The total air outlet area C of the outlet of the air inlet duct 101 and the total air inlet area D of the main inlet 302 satisfy a relationship of C>2.5D, so that the motor 106 can suck air from the main inlet 302 smoothly.

Reference is made to Figure 49. In some embodiments of the present disclosure, the cleaning apparatus further includes a soundproof plate 470 disposed in the first chamber 440. The soundproof plate 470 divides the first chamber 440 into two cavities connected to the first through hole 421 and the second through hole 431, respectively. A fourth through hole 471 is provided on the soundproof plate 470. By adding the soundproof plate 470, the airflow in the first chamber 440 can be combed, such that the airflow flows evenly and noise is reduced.

In an embodiment of the present disclosure, on the basis of ensuring the air outlet area, the quantity and aperture size of the fourth through hole 471 on the soundproof plate 470 are designated so that the aperture size of the fourth through hole 471 is less than the aperture size of the first through hole 421 and the aperture size of the second through hole 421.

In an embodiment of the present disclosure, the aperture size of the third through hole 461 and the aperture size of the fourth through hole 471 may be in a range from 1.3mm to 3mm; and the aperture size of the first through hole 421 and the aperture size of the second through hole 431 are in a range from 3mm to 6mm. This is because when the air flows in the air duct, the aperture sizes set for the first through hole 421 and the second through hole 431 need to ensure that the air outlet area is greater than the air outlet area of the motor 106, so as to ensure smooth flow of the airflow in the air duct. The aperture sizes of the third through hole 461 and the fourth through hole 471 are less than the aperture sizes of the first through hole 421 and the second through hole 431, so that a turbulent airflow can be balanced when flowing through the third through hole 461 and the fourth through hole 471, realizing flow equalization and noise reduction. On the basis of ensuring the air outlet area of the third through hole 461 and the fourth through hole 471, the aperture sizes of the third through hole 461 and the fourth through hole 471 are set in a range of 1.3mm to 3mm. Hence, the flow equalization and noise reduction for the airflow can be better performed.

For example, in a specific embodiment of the present disclosure, as shown in Figure 44, the aperture size of the first through hole 421 is greater than the aperture size of the second through hole 431, and the aperture size of the second through hole 431 is greater than the aperture size of the third through hole 461. Due to the gradual reduction of the aperture sizes, a wind pressure of the airflow gradually decreases, which is beneficial to noise reduction. Specifically, the aperture size of the first through hole 421 may be 4mm; the aperture size of the second through hole 431 may be 3.5mm; and the aperture size of the third through hole 461 may be 2mm. In the example shown in Figure 49, the first through hole 421, the second through hole 431, and the third through hole 461 are in a same design as in the example in Figure 44, and an aperture size of the fourth through hole 471 may be 2mm. The fourth through hole 471 is mainly for further noise reduction.

In a specific embodiment of the present disclosure, a diameter of the motor 106 is represented by D0, a diameter of the silencing shield 480 is represented by D1, and a diameter of the motor shield 301 is represented by D2. In this case, in order for smooth flow of an airflow in the air duct and to achieve a best noise reduction effect, the D0, D1, and D2 satisfy a relationship of D1/D0=1.2~1.6, D2/D0=1.8~2.2.

In an embodiment of the present disclosure, the cleaning apparatus further includes a battery pack assembly 513. The battery pack assembly 513 may be disposed on the silencing shield 480 and/or the motor shield 304. For example, the battery pack assembly 513 is installed on the silencing shield 480 and/or the motor shield 304 in a fixed or detachable manner. A heat dissipation channel 102 is provided in the motor 106. The heat dissipation channel 102 of the motor 106 is connected with the inner cavity of the battery pack assembly 513. Through the heat dissipation channel 102, a negative pressure can be formed in the inner cavity of the battery pack assembly 513, so that the airflow can pass through the inner cavity of the battery pack assembly 513, flows into the heat dissipation channel 102 of the motor 106, and is finally discharged through the main air outlet 303.

Specifically, after the motor 106 is started, the external airflow flows into the heat dissipation channel 102 of the motor 106 through the inner cavity of the battery pack assembly 513. The airflow in the heat dissipation channel 102, while flowing, can take away the heat emitted by the battery pack assembly 513, to cool the battery pack assembly 513. The airflow is finally discharged from the main air outlet 303. Thereby, the battery pack assembly 513 is cooled.

The motor 106 of the present disclosure may include a motor outer casing and a motor inner casing disposed in the motor outer casing. The rotor, stator and other components of the motor assembly may be all installed in the motor inner casing. The heat dissipation channel 102 is provided in the motor inner casing. This heat dissipation channel may be configured for heat dissipation of the motor. For example, during operation, the motor generates a large amount of heat during high-speed rotation. By introducing part of the airflow generated by the motor into the heat dissipation and then discharging therefrom, heat dissipation of the motor can be realized. Design of the heat dissipation channel is well-known to those skilled in the art and is not described in detail here.

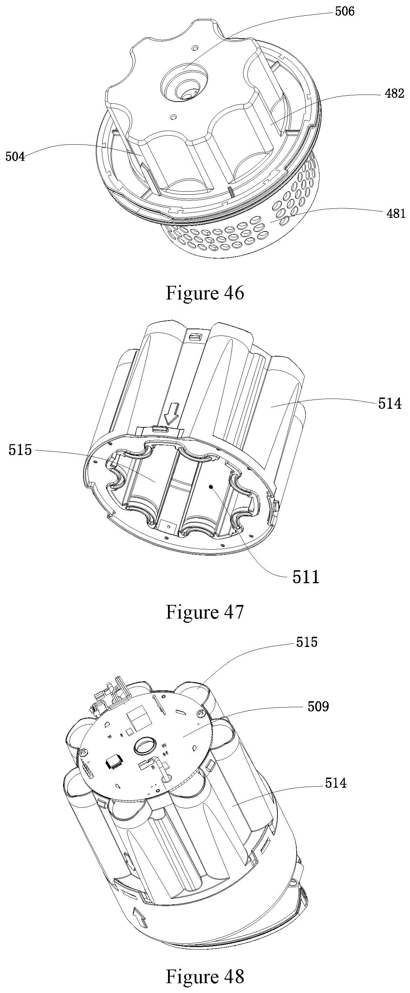

In a specific embodiment of the present disclosure, the second shield body 482 of the silencing shield 480 extends into the inner cavity of the battery pack assembly 513. An end of the second shield body 482 is configured to have a heat dissipation through hole 506 adapted to the heat dissipation channel 102 of the motor 106. Referring to Figure 46, the second chamber 410 is blocked through fit of the remaining positions on the motor 106 with the second shield body 482. It can be understood that the gas in the inner cavity of the battery pack assembly 513 can enter the motor 106 only through the heat dissipation channel 102.

In a specific embodiment of the present disclosure, with reference to Figure 45, the battery pack assembly 513 includes a heat dissipation shell 514. Battery compartments 515 are provided within the heat dissipation shell 514, and the battery compartments 515 are arranged in the circumferential direction of the heat dissipation shell 514, and are configured for accommodating a cell assembly 503. The battery compartments 515 are configured in order to isolate the battery assembly to prevent vapor (containing acidic substances and other corrosive impurities) in the airflow from contacting the cell assembly 503 for a long time and affecting performance of the cell assembly. Moreover, it is not necessary to consider a connection relationship between the cell assembly 503 and the heat dissipation shell 514, and only needs to place the cell assembly into the battery compartments 515 and maintain an electrical connection between the cell assembly with electronic devices. The disassembly and assembly process of the cell assembly 503 is simple and easy to implement.

In a specific embodiment of the present disclosure, a side walls of the heat dissipation shell 514 protrude radially outward and forms a semi-open battery compartment 515 structure. Referring to Figure 45 and Figure 47, each battery compartment 515 is formed by protruding from the heat dissipation shell 514, and the battery compartments 515 are arranged at intervals in the circumferential direction of the heat dissipation shell 514. The battery compartment 515 is formed in a semi-enclosed open structure on the inner wall of the heat dissipation shell 514. When the cell assembly 503 is placed in the battery compartment 515, at least part of the outer wall of the cell assembly 503 is exposed to the inner cavity of the heat dissipation shell 514, to facilitate heat dissipation of the cell assembly 503.

The cell assembly 503 is arranged on a circumferential direction of the heat dissipation shell 514, so that the cell assembly 503 defines an annular inner cavity 511 in the inner cavity of the heat dissipation shell 514, as shown in Figure 47. Each battery compartment 515 is formed by protruding from the heat dissipation shell 514, and the battery compartments 515 are arranged at intervals in the circumferential direction of the heat dissipation shell 514. Therefore, when the cell assembly 503 is installed in the battery compartment 515, the cell assembly 503 is arranged surrounding inside the heat dissipation shell 514, forming an annular inner cavity 511. The second shield body 482 of the motor assembly extends into the annular inner cavity 511. The first shield body 481 is located outside the annular inner cavity 511. That is, a part of the motor assembly extends into the annular inner cavity 511, and the other part of the motor assembly is located outside the annular inner cavity 511. A side wall of the motor shield 304 of the motor assembly may be flush with an outer edge of the heat dissipation shell 514. This may be understood as the side wall of the motor shield 304 being flush with the outer edge of the battery compartment 515, so that an overall structure has a better consistency.

In an embodiment of the present disclosure, the outer wall of the second shield body 482 is provided with heat dissipation grooves 504 in one-to-one correspondence with the battery compartments 502. Referring to Figure 46, the heat dissipation grooves 504 are configured to be in fit, such as clearance fit or contact fit, with at least part of the surface of the cell assembly 503 exposed from the battery compartments 502. Such arrangement allows the heat of the cell assembly 503 in the battery compartments 515 to be transferred to the second shield body 482 as much as possible, and be dissipated through the airflow in the first compartment 420.

In this embodiment, the heat dissipation shell 514 may be in any other shape, such as a square, cylindrical, or other shapes well known to those skilled in the art, which is not limited here.

In an embodiment of the present disclosure, the second shield body 482 extends into part of the inner cavity of the battery pack assembly 513. For example, a depth to which the second shield body 482 extends may be approximately equal to half the height of the battery pack assembly 513. In this way, at least part of the cell assembly 503 is still exposed in the inner cavity of the heat dissipation shell 514, and is cooled through the heat dissipation channel 102 of the motor. On the other hand, the outer wall of the second shield body is in contact or clearance fit with part of the surface of the cell assembly 503. As a result, the cell assembly 503 can be cooled through the airflow in the second shield body.

In a specific embodiment of the present disclosure, the end surface of the heat dissipation shell 514 is provided with a heat dissipation inlet 505 connected to the inner cavity of the heat dissipation shell 514. Referring to Figure 45 and Figure 46, the second shield body 482 is provided with a heat dissipation through hole 505 connected to the heat dissipation channel 102 of the motor 106. Specifically, after an external airflow enters the heat dissipation shell 514, the airflow heats up after exchanging heat with the cell assembly 503, flows into the heat dissipation channel 102 of the motor 106, and is finally discharged from the main air outlet 303 channel. Thereby, quick cooling of the heat dissipation shell 514 is realized.

In an embodiment of the present disclosure, the motor 106 is not necessarily provided with an additional heat dissipation channel 102. When the motor 106 operates, the external airflow flows in the air inlet duct, the first compartment, the first chamber, and the second compartment as mentioned above, and perform heat dissipation on the motor. In this embodiment, the second shield body 482 extends into the annular inner cavity 511. When the motor 106 operates, the heat emitted by the cell assembly 503 can be taken away in time through the second shield body 401. That is, while dissipating heat from the motor 106, the heat in the annular inner cavity 511 is also taken away through the second shield body 482 located in the annular inner cavity 511. Thereby, quick heat dissipation of the annular inner cavity 511 and the cell assembly 503 is realized. Half of the height of the second shield body 482 extending into the battery pack assembly 513 is an optimal position for heat dissipation of the cell assembly 503 and noise reduction in the air duct. It is found, through experiments, that the heat dissipation effect of the cell assembly 503 is optimal in this case. The heat generated by the cell assembly 503 during operation can be diffused into the annular inner cavity 511 to the greatest extent, so that the cell assembly 503 can be maintained at a suitable temperature. After a long-term use of the cleaning apparatus, a user can directly control to charge the cell assembly 503 without waiting for the cell assembly 503 to cool down. Hence, safety of the cleaning apparatus and user experience are improved.

In this embodiment, the heat dissipation through hole 506 illustrated in Figure 45 and Figure 46 are used only as a wiring hole, that is, wiring harness of the battery pack assembly may be connected to the motor assembly through the wiring hole. Therefore, the battery pack assembly can supply power to the motor assembly, which is not explained in further detail here.

In an embodiment of the present disclosure, a radial size of the first shield body 481 is greater than a radial size of the second shield body 482. The second shield body 482 extends into the annular inner cavity 511 surrounded by the cell assembly 503. The first shield body 481 is located outside the heat dissipation shell 514, and the first shield body 481 may extend to a front projection area of the cell assembly 503. When the motor assembly operates, part of the heat emitted by the cell assembly 503 can be directly or indirectly transferred to the first shield body 481 and taken away through the air duct. Thereby, the heat dissipation efficiency of the cell assembly 503 is improved.

Referring to Figure 42, a motor assembly is provided in an embodiment of the present disclosure. The motor assembly includes a motor shield 304, a silencing shield 480, a motor 106 and a partition 204. The silencing shield 480 is located inside the motor shield 304. A first chamber 440 extending along an axial direction of the silencing shield 480 is formed by the silencing shield 480 and an inner wall of the motor shield 304. An air inlet duct 101 is provided in the motor 106. The motor 106 is at least partially located inside the silencing shield 480. The motor 100, together with an inner wall of the silencing shield 480, defines a second chamber 410 extending along an axial direction of the motor 100. The partition 201 is configured to divide the second chamber 410 into a first compartment 420 communicated to an outlet of the air inlet duct 101, and a second compartment 430 separated from the first compartment 420. The air inlet duct 101, the first compartment 420, the first chamber 440, and the second compartment 430 are communicated in the above-listed sequence.

The structure and function of the motor assembly in this embodiment may be consistent with the structure and function of the motor assembly in the first embodiment, and is not described in detail here.

In addition to being applied to the above-mentioned cleaning apparatus, the motor assembly of the present disclosure is applied to other apparatus that requires noise reduction and temperature reduction. Examples thereof are not listed here in detail.

A tray is further provided in the present disclosure. The tray is configured for holding the cleaning apparatus described above. A charging male plug is provided on the tray, and a first pole piece is provided on each of opposite sides of the charging male plug in the X-axis direction. Alternatively, a charging female plug is provided on the tray, and a second pole piece is provided on each of opposite sides of the charging female plug in the X-axis direction.

In an embodiment of the present disclosure, the tray 2 is provided with a charging male plug 3 , and the body 11 of the cleaning apparatus 1 is provided with a charging female plug 4 in fit with the charging male plug 3. A second pole piece 41 is provided on the charging female plug 4 at a position corresponding to the charging male plug 3. After the charging male plug 3 and the charging female plug 4 are mated, the first pole piece 31 and the second pole piece 41 are in contact and electrically connected, so that the tray can charge the cleaning apparatus.

In an embodiment of the present disclosure, the tray 2 is provided with a charging female plug 4, and the body 11 of the cleaning apparatus 1 is provided with a charging male plug 3 fit to the charging female plug 4. A first pole piece 31 is provided on the charging male plug 3 at a position corresponding to the charging female plug 4. After the charging male plug 3 and the charging female plug 4 are mated, the first pole piece 31 and the second pole piece 41 are in contact and electrically connected, so that the tray can charge the cleaning apparatus.

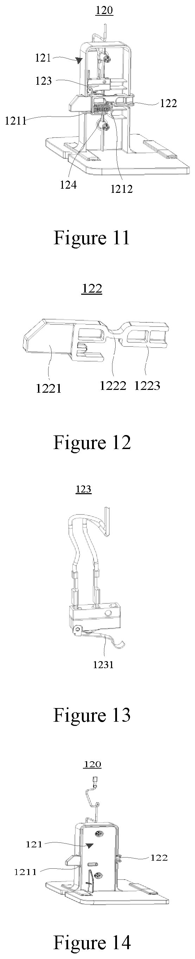

Figure 8 shows a schematic three-dimensional structural view of a tray 2 according to an embodiment of the present disclosure. Figure 9 shows a sectional view of a tray 2 according to an embodiment of the present disclosure. Figure 10 shows a schematic three-dimensional structural view of an upright arm 120 according to an embodiment of the present disclosure. Figure 11 shows a sectional view of an upright arm 120 according to an embodiment of the present disclosure. Figure 12 shows a schematic three-dimensional structural view of a trigger 122 according to an embodiment of the present disclosure. Figure 13 shows a schematic structural diagram of a microswitch 123 according to an embodiment of the present disclosure.

Referring to Figure 1 to Figure 13, a charging base station is provided in an embodiment of the present disclosure, for supplying power to the cleaning apparatus 20. The cleaning apparatus 20 includes a charging female plug 4 and a pusher 24. The tray 2 includes a positioning seat 22 and a base 21. The positioning seat 22 is connected to the base 21.

The positioning seat 22 includes a charging male plug 3 and an upright arm 120 disposed in the positioning seat 22, where the charging male plug 3 can be in contact with the charging female plug 4.

The upright arm 120 includes a supporter 121, a trigger rod 122, and a microswitch 123.

Specifically, the supporter 121 has a receiving groove 1211, and the receiving groove 1211 has a first position and a second position spaced apart from each other.

The trigger 122 is movably disposed in the receiving groove 1211, the pusher 24 is capable of abutting against the trigger 122 and pushing the trigger 122 to move linearly between the first position and the second position.

The microswitch 123 is connected to the trigger 122, and the microswitch 123 is electrically connected to the charging male plug 3. When the trigger 122 is placed at the first position, the microswitch 123 is in an off state, and the charging female plug 4 is not conductive to the charging male plug 3. When the trigger 122 is placed at the second position, the microswitch 123 is in an on state, and the charging female plug 4 is conductive to the charging male plug 3.

With the optimized design of the structure of the charging base station, it is capable of solving the problem of an increased oxidation area of the second charging element of the charging device and a reduced contact area for conduction between the charging base station and the cleaning apparatus, caused by the sparking due to conduction between the traditional charging device and the cleaning apparatus. Specifically, the charging base station is configured as a combined component integrating at least a tower and a base. The tower integrates at least the second charging element and the upright arm. The upright arm is disposed inside the tower. The upright arm is configured as a combined component that integrates at least the supporter, the trigger and the microswitch. The supporter at least has an effect of supporting other components. The trigger is arranged in conjunction with the microswitch on the supporter. Movement of the trigger realizes the electrical conduction or disconnection of the microswitch, thereby realizing the electrical conduction or disconnection of the internal circuit of the charging base station through the upright arm, thereby realizing the charging operation or noncharging operation of the charging base station. Specifically, when the cleaning apparatus needs to be charged, the cleaning apparatus is placed at the charging base station. An electrical conduction process between the first charging element of the cleaning apparatus and the second charging element of the charging base station can be performed at least through the manipulation by the composite component composed of the " trigger -microswitch" mechanism, so as to realize electrical conduction between the two. Such design prevents the first charging element of the cleaning apparatus from being directly electrically conductive with the second charging element of the charging base station, and thereby prevents the sparking. Thus, an increased oxidation area on a surface of the second charging element and a reduced contact area between the second charging element and the first charging element caused by the long-term sparking on the second charging element of the charging base station is prevented. This is conducive to improving the sensitivity and effectiveness of the charging base station in charging the cleaning apparatus, shortening the charging time of the cleaning apparatus, and avoiding the situation where the cleaning apparatus cannot be charged on the charging base station.

In this embodiment, with the optimized design of the tray 2, it is capable of solving the problem of an increased oxidation area of the charging contact piece (the charging male plug 3) of the charging device and a reduced contact area for conduction between the tray 2 and the cleaning apparatus 20, caused by the sparking due to electrical conduction between the traditional charging device and the cleaning apparatus 20.

Specifically, the tray 2 includes a positioning seat 22 and a base 21, where the positioning seat 22 is disposed in the base 21 and extends from the base along a vertical direction. When the cleaning apparatus 10 is placed on the tray 2, the cleaning apparatus 20 is placed in the base 21 to facilitate self-cleaning of the cleaning apparatus. Meanwhile, the cleaning apparatus 20 abuts against the positioning seat 22, so that the charging female plug 4 of the cleaning apparatus 20 is electrically connected to the charging male plug 3 of the positioning seat 22, and the cleaning apparatus 20 is charged through the tray 2. The charging male plug 3 is located at the top of the positioning seat 22, in order to be better electrically connected with the charging female plug 4 of the cleaning apparatus 20.

At least a first charging element 110 and an upright arm 120 are integrated in the positioning seat 22. The upright arm 120 is a combined component integrating at least the supporter 121, the trigger 122, and the microswitch 123. The supporter 121 at least has an effect of supporting other components. The trigger 122 is arranged in conjunction with the microswitch 123 on the supporter 121. Movement of the trigger 122 realizes the electrical connection or disconnection of the microswitch 123, thereby realizing the electrical connection or disconnection of the internal circuit of the tray 2 through the upright arm 120. The contact conduction between the tray 2 and the cleaning apparatus 20 is in turn realized to charge the cleaning apparatus 20, or the contact disconnection between the tray 2 and the cleaning apparatus 20 is realized to disconnected charging of the cleaning apparatus 20.

Specifically, when the cleaning apparatus 20 needs to be charged, the cleaning apparatus is placed on the tray 2. An electrical conduction process between the charging female plug 4 (charging contact piece) of the cleaning apparatus 20 and the charging male plug 3 (charging contact piece) of the tray 2 can be performed at least through the manipulation by the composite component composed of the " trigger 122-microswitch 123" mechanism, so as to realize electrical conduction between the two. Such design prevents the charging female plug 4 (charging contact piece) of the cleaning apparatus 20 from being directly electrically conductive with the charging male plug 3 (charging contact piece) of the tray 2, and thereby prevents the sparking. Thus, an increased oxidation area on a surface of the charging male plug 3 and a reduced contact area between the charging male plug 3 and the charging female plug 4 of the cleaning apparatus 20 caused by the long-term sparking on the charging male plug 3 of the tray 2 is prevented. This is conducive to improving the sensitivity and effectiveness of the tray 2 in charging the cleaning apparatus 20, shortening the charging time of the cleaning apparatus 20, and avoiding the situation where the cleaning apparatus 20 cannot be charged on the tray 2.

Specifically, in order to protect the upright arm 120, the upright arm 120 is placed in the positioning seat 22, so as to isolate the upright arm 120 from damage/scratches caused by the external environment.

Specifically, in order to accommodate the trigger 122, a receiving groove 1211 is provided on the supporter 121, and the trigger 122 is accommodated and movable in the receiving groove 1211. For example, but not limited to, the trigger 122 is a triggering rod. In addition, the microswitch 123 is connected to the trigger 122, so that the movement of the trigger 122 drives the microswitch 123 to be electrically connected or disconnected, thereby realizing electrical connection or disconnection between the microswitch 123 and the charging male plug 3, thereby achieving electrical connection or disconnection of the internal circuit of the tray 2 having the upright arm 120.

In an embodiment, the microswitch 123 is connected and secured to the supporter 121 through fasteners such as screws/bolts, so as to maintain the stability of the microswitch 123 and prevent the microswitch 123 from falling and becoming disabled for normal operation. Apparently, in other embodiments, the microswitch 123 may be detachably connected to the supporter 121 through a snap or other structures, as long as it is ensured that the microswitch 123 does not fall off from the supporter 121. It should be noted that the specific connection mode between the microswitch 123 and the supporter 121 is not limited as in the embodiment.

Furthermore, a triggering mode in which the trigger 122 and the microswitch 123 act in conjunction is further provided in an embodiment. In this triggering mode, an end of the microswitch 123 abuts against the trigger 122 and can be switched off or on under the driving of the trigger 122. Specifically, when the trigger 122 is in the first position, the microswitch 123 is driven to be opened, and thereby the microswitch is in an off state. When the trigger 122 is in the second position, the microswitch 123 is driven to be closed, and thereby the microswitch 123 is in an on state. It can be understood that in this triggering mode, the trigger 122 moves linearly between the first position and the second position, so as to drive the microswitch 123 to switch curvedly between the open state and the closed state. The trigger 122 moves linearly to trigger the microswitch 123. On the one hand, it can prevent the trigger 122 of the positioning seat 22 from being accidentally triggered by a user or other objects in the vertical direction. On the other hand, it can improve stability of relative motion between the trigger 122 and the microswitch 123, so that a service life is prolonged.

From the above, the internal space of the positioning seat 22 is fully used in the embodiment, so that the upright arm 120 is additionally provided in the positioning seat 22, which is conducive to miniaturizing the tray 2. Moreover, the upright arm 120 provides a linkage control mechanism composed by the "trigger 122-microswitch 123" mechanism. Such control mechanism can prevent the cleaning equipment 20 from sparking when charging on the tray 2, and improve the service life of the tray 2.

Apparently, in other embodiments, in order to improve the adaptability to different cleaning apparatus 20, the tray 2 is further integrated with other functional modules arranged in the positioning seat 22, such as a self-cleaning module. Thereby, the tray 2 has more complete functions.

Referring to Figure 12, in a possible implementation, the trigger 122 includes a first section 1221, a second section 1222, and a third section 1223 connected in the listed sequence. The first section 1221 is disposed toward the pusher 24.

The microswitch 123 includes a cantilevered moving member 1231. The microswitch 123 is in the off state when a free end of the moving member 1231 away from the microswitch 123 abuts against the second section 1222, and the microswitch 123 is in the on state when the free end of the moving member 1231 abuts against the first section 1221.

In this embodiment, specific structure of the trigger 122 is optimized. Specifically, a three-section composite component including at least a first section 1221, a second section 1222, and a third section 1223 is provided. The first section 1221 is for directly withstanding an external squeezing/pushing force (which may come from the pusher of the cleaning apparatus 20, or from manual pushing). Under the action of the squeezing/pushing force, the first section drives the second section 1222 and the third section 1223 to move along the direction of the force. The second section 1222 is for connecting the first section 1221 and the third section 1223, and forming a protrusion or depression between the first section 1221 and the third section 1223 to fit with the moving member 1231. The third section 1223 is for restricting the moving member 1231 from falling out of the trigger 122. When in the second position, the third section 1223 applies on the moving member 1231 a pushing force along an extension direction, thus preventing the moving member 1231 from coming into contact with other components in the positioning seat 22 when moving continuously in the same direction after exceeding the second position, which otherwise causes irreversible mechanical injure/damage to the moving member 1231.

Apparently, it can be understood that when the trigger 122 moves in the same direction in the receiving groove 1211, the trigger 122 passes through the first position and the second position of the receiving groove 1211. In this way, in the charging and conduction process, the trigger 122 moves from the first position to the second position. In this case, the moving member 1231 is driven by the trigger 122 to rotate and electrically communicate with the microswitch 123, completing the electrical connection of the microswitch 123. In the disconnection process, the trigger 122 moves from the second position to the first position. In this case, the moving member 1231 is driven by the trigger 122 to rotate in a reverse direction and disconnect the microswitch 123 from the electrical connection.

In an embodiment, to facilitate processing, the first section 1221, the second section 1222, and the third section 1223 are integrally formed, so that subsequent assembly and connection processes can be saved. Apparently, in other embodiments, the first section 1221, the second section 1222, and the third section 1223 may be processed individually, and then connected through a gluing or welding process.

In a possible implementation, the first section 1221 is disposed protruding toward the moving member 1231.

In an embodiment, specific settings of the first section 1221 and the second section 1222 are further optimized. Specifically, the first section 1221 and the second section 1222 are arranged at staggered heights to form a convex/step at the connection between the first section 1221 and the second section 1222. In this way, when the trigger 122 moves from the first position to the second position, the moving member 1231 is driven to close and the two electrodes of the microswitch 123 are conducted. It should be understood that the closing direction of the moving member 1231 is perpendicular to the movement direction of the trigger 122.

Alternatively, the first section 1221 and the second section 1222 may be arranged in a Z-shape, that is, the first section 1221 and the second section 1222 are connected perpendicularly. Apparently, in other embodiments, the first section 1221 and the second section 1222 may be configured to be smoothly connected, that is, a smooth concave surface is formed on a side of the first section 1221 and the second section 1222 facing the moving member 1231. In this way, a friction force experienced by the moving member 1231 when moving on the trigger 122 is reduced.

In a possible implementation, the second section 1222 is recessed in a direction away from the moving member 1231 to form a groove between the first section 1221, the second section 1222, and the third section 1223.

In an embodiment, specific settings of the first section 1221, the second section 1222, and the third section 1223 are further optimized. Specifically, the first section 1221, the second section 1222 and the third section 1223 are arranged at staggered heights to form a convex/step at the connection between the first section 1221 and the second section 1222, and form a convex/step at the connection between the second section 1222 and the third section 1223. In this way, when the trigger 122 moves from the first position to the second position, the moving member 1231 is driven to close and the two electrodes of the microswitch 123 are conducted.

Moreover, when the trigger 122 continues to move in the same direction after reaching the second position, the movable member 1231 can be driven to abut against the third section 1223 and receive a pushing force along the extension direction of the moving member. Thereby, the moving member 1231 is prevented from falling out of the trigger 122, and coming into contact with other parts and causing damage.

In a possible implementation, the second section 1222 is disposed protruding toward the moving member 1231.

In an embodiment, specific settings of the first section 1221 and the second section 1222 are further optimized. Specifically, the second section 1222 is disposed in a protruding manner to form a convex/step at the second section 1222. In this way, when the trigger 122 moves from the first position to the second position, the moving member 1231 abuts against the second section 1222, so that the moving member 1231 is closed in the movement direction perpendicular to the trigger 122, and thereby the two electrodes of the microswitch 123 are conducted.

For example, but not limited to, the second section 1222 is smoothly connected to the first section 1221/third section 1223. Of course, in other embodiments, the connection between the second section 1222 and the first section 1221 or third section 1223 is at a right angle.

Referring to Figure 12, in a possible implementation, the first section 1221 has an abutment slope. The abutment slope is located on a side of the first section 1221 away from the second section 1222, and the abutment slope is disposed toward the moving member 1231.

In this embodiment, specific structure of the first section 1221 is optimized. Specifically, an abutment slope is provided on the first section 1221, and dispersion of an external push force is completed on the abutment slope.

The abutment slope is arranged toward the moving member 1231. In this way, when the cleaning apparatus 20 is placed on the tray 2, the charging female plug 4 is in contact with the charging male plug 3, and the pusher 24 abuts against the abutment slope of the first section 1221. Due to the gravity of the cleaning apparatus 20 itself, the trigger 122 is pushed to move in the receiving groove 1211. In this case, the abutment slope receives a downward push force which is perpendicular to the abutment slope. The push force is dispersed on the abutment slope, resulting in a horizontal component force and a vertical downward component force. The horizontal component force is actually the force that actually pushes the trigger 122 to move along the receiving groove 1211. It should be understood that the horizontal component force is greater than a friction force experienced by the trigger 122 when moving in the receiving groove 1211.

From the above, setting of the abutment slope facilitates processing, and enables a more convenient and labor-saving procedure in applying force to the trigger 122. Hence, the abutment slope is conducive to improving the sensitivity of the switch assembly composed of the "trigger 122-microswitch 123" mechanism, and reducing a response time.

It should be understood that the external push force may be applied to the abutment slope of the first section 1221 by the pusher 24 of the cleaning apparatus 20. In other embodiments, the external push force may be triggered by other components or manually.

Referring to Figure 9 and Figure 11, in a possible implementation, the upright arm 120 further includes an elastic member 124. A blocking portion 1212 is formed on a side of the receiving groove 1211 away from the microswitch 123. The elastic member 124 is provided between the first section 1221 of the trigger 122 and the blocking portion 1212.

In this embodiment, the switch assembly composed of the "trigger 122-microswitch 123" mechanism is further optimized. Specifically, an elastic member 124 is provided between the trigger 122 and the supporter 121 to provide an elastic force to the trigger122. Hence, in the second position, after the cleaning apparatus 20 is removed/taken away, the trigger 122 returns to the first position under the action of the elastic force, to facilitate use of a next cleaning apparatus 20. Specifically, a blocking portion 1212 is provided on the supporter. The blocking portion 1212 is spaced correspondingly from the first section 1221 of the trigger 122. In this way, the elastic member 124 is installed between the first section 1221 and the blocking portion 1212.

For example, but not limited to, the elastic member 124 is a spring. In other embodiments, the elastic member 124 may be a soft elastomer.

In a possible implementation, a limiting sink groove and a first limiting bump are provided on a side of the first section 1221 away from the moving member 1231. The first limiting bump is disposed at the bottom of the limiting sink groove and extends in a direction close to the second section 1222. The blocking portion 1212 is provided with a second limiting bump corresponding to the limiting sink groove. An end of the elastic member 124 is inserted into the limiting sink groove and sleeved on the first limiting bump. The other end of the elastic member 124 abuts against the second limiting bump.

In this embodiment, specific connection mode of the elastic member 124 with the trigger 122 and the supporter 121 is optimized. Specifically, there is an elastic distance between the first limiting bump and the second limiting bump, for the elastic member 124 to extend. The arrangement of the limiting sink groove further enhances a tightness of the connection between the elastic member 124 and the trigger 122.

Apparently, in other embodiments, in a case where it is necessary to further enhance the tightness of the connection between the elastic member 124 and the supporter 121, a sink groove may be further provided at a corresponding position of the second bump, to prevent the elastic member 124 from falling off from the second bump.

In a possible implementation, the receiving groove 1211 extends in the horizontal direction, the microswitch 123 is disposed above the trigger 122, and the moving member 1231 is disposed toward the trigger 122.

In this embodiment, a movement mode of the trigger 122 and the microswitch 123 is optimized. Specifically, the receiving groove 1211 is set horizontally, so that the moving member 1231 can abut against the trigger 122 and maintain in such state by utilizing the gravity, so that the moving member 1231 can be driven to rotate through the linear movement of the trigger 122. In this case, the movement direction of the trigger 122 is perpendicular to a closing direction of the moving member 1231, that is, the trigger is at an angle of 90° to the moving member.

It should be explained that the horizontal direction refers to a direction parallel to the ground when the tray 2 operates.

In a possible embodiment, the receiving groove 122 is inclined, the microswitch 123 and the trigger 122 are arranged in parallel, and the microswitch 123 is located on a side of the trigger 122 away from the cleaning apparatus 20, and the moving member 1231 is arranged toward the trigger 122.

In this embodiment, a movement mode of the trigger 122 and the microswitch 123 is optimized. Specifically, the receiving groove 1211 is arranged tilted, and the microswitch 123 is arranged tilted (mainly considering the direction of the connecting lines of the two electrodes of the microswitch 123) to keep in parallel to the trigger 122. In this way, due to the position characteristics of the moving member 1231, part of the gravity of the moving member is converted into a push force for pushing the moving member 1231 to move toward the other electrode close to the microswitch 123. It is conducive to alleviating the stress that the trigger 122 provides the push force for the moving member 1231, improving a response speed of the trigger 122, improving sensitivity of the trigger 122 acting on the moving member1231. In this case, the movement direction of the trigger 122 is perpendicular to a closing direction of the moving member 1231, that is, the trigger is at an angle of 90° to the moving member.

It should be noted that the receiving groove 1211 arranged tilted means that when the tray 2 is operates, a plane where the extension direction of the receiving groove 1211 is located is at an angle to the ground.

In a possible embodiment, the receiving groove 122 is inclined, the microswitch 123 and the trigger 122 are arranged at an angle, and the microswitch 123 is located on a side of the trigger 122 away from the cleaning apparatus 20, and the moving member 1231 is arranged toward the trigger 122.

In this embodiment, a movement mode of the trigger 122 and the microswitch 123 is optimized. Specifically, the receiving groove 1211 is arranged tilted, and the microswitch 123 is arranged vertically (mainly considering that the connecting line between the two electrodes of the microswitch 123 is perpendicular to the ground), so that the microswitch is at an angle with the trigger 122. In this way, an end of the trigger 122 directly abuts against the moving member 1231. Due to the position characteristics of the trigger 122, all the force along the axial direction of the trigger 122 on the trigger 122 can act on the moving member 1231, providing a push force to the moving member 1231, which is conducive to increasing a closing speed of the moving member 1231. At this time, the movement direction of the trigger 122 is at an acute angle to the closing direction of the moving member 1231, that is the trigger is at an angle less than 90° to the moving member.

It should be noted that the microswitch 123 arranged vertically means that when the tray 2 operates, the microswitch 123 (the connecting line between the two electrodes of the microswitch 123) is perpendicular to the ground.

Reference is made to Figure 13. In a possible embodiment, the microswitch 123 further comprises a first electrode and a second electrode. The first electrode and the second electrode are electrically connected to the charging male plug 3 through wires. The moving member 1231 is cantilevered from the first electrode, and the microswitch 123 is in an on state when the free end of the moving member 1231 is in contact with the second electrode.

The moving member 1231 includes a straight part and a bent part connected in sequence. An end of the straight part away from the bent part is rotationally connected to the first electrode, and the bent part abuts against the trigger 122.

Alternatively, the moving member 1231 includes a straight part, an end of the straight part is rotationally connected to the first electrode, and the other end of the straight part abuts against the trigger 122.

In this embodiment, specific structure of the moving member 1231 is optimized. Specifically, the moving member 1231 is provided as a combined component composed of the straight part and the bent part. For example, but not limited to, the straight part is a straight rod and the bent part is a hook. The hook is connected to an end of the straight rod, an end of the straight rod away from the hook is rotationally connected to the first electrode, and the hook is movably abutted on the trigger 122. It should be understood that in order to reduce friction, an open end of the hook is arranged away from the trigger 122, so as to reduce mechanical damage/wear to the trigger 122 caused by a reciprocating motion of the hook on the trigger 122. In other embodiments, the straight part may be a straight sheet structure, and the bent part may be a curved sheet structure.

Apparently, structure of the moving member 1231 is not limited to what described above. In another embodiment, the moving member 1231 is configured as a combined component composed of a straight part and a spherical part. For example, but not limited to, the straight part is a straight rod, and the spherical part is a spherical bead. The spherical bead is connected to an end of the straight rod, and an end of the straight rod away from the spherical bead is rotationally connected to the first electrode. The spherical bead is movably abutted on the trigger 122. It should be understood that the spherical bead has an arc surface, which can reduce scratches/damage to the trigger 122 caused by movement of the moving member 1231.

In another embodiment, the moving member 1231 is configured to include only the straight part. For example, but not limited to, the straight part is a straight rod, an end of the straight rod is rotationally connected to the first electrode, and the other end of the straight rod abuts against the trigger 122. Such design enables the structure of the moving member 1231 to be simple and easy to process. However, movement of the moving member 1231 may cause scratches/damage to the trigger 122 to varying degrees.

Figure 8 shows a schematic three-dimensional structural diagram of a charging base station 10 according to an embodiment of the present disclosure. Figure 9 shows a sectional view of a tray 2 according to an embodiment of the present disclosure.

Referring to Figure 8 and Figure 9, a charging base station is further provided in an embodiment of the present disclosure. The charging base station includes a positioning seat 22 and a base 21. The positioning seat 22 is connected to the base 21.

The positioning seat 22 includes a charging male plug 3 and an upright arm 120 disposed in the positioning seat 22. The upright arm 120 includes a support member 121, a trigger 122 and a microswitch 123.

The supporter 121 has a receiving groove 1211. The receiving groove 1211 has a first position and a second position spaced apart from each other.

The trigger 122 is movably disposed in the receiving groove 1211. The trigger is capable of moving linearly between the first position and the second position.

The microswitch 123 is connected to the trigger 122, and the microswitch 123 is electrically connected to the charging male plug 3. When the trigger 122 is placed at the first position, the microswitch 123 is in an off state. When the trigger 122 is placed at the second position, the microswitch 123 is in an on state.

In this embodiment, a tray 2 is designed, in order to solve the problem of damage to the charging device caused by sparking generated when charging a to-be-charged device by a traditional charging device. The tray 2 is provided with an upright arm 120 in the positioning seat 22, intended to manipulate the electrical connection of the two charging pieces of the positioning seat 22 through the upright arm 120. Specifically, the upright arm 120 is a combined component at least integrating the supporter 121, the trigger 122, and the microswitch 123. The supporter 121 at least has an effect of supporting other components. The trigger 122 is arranged in conjunction with the microswitch 123 on the supporter 121. Movement of the trigger 122 realizes the electrical connection or disconnection of the microswitch 123, thereby realizing the electrical connection or disconnection of the internal circuit of the tray 2 through the upright arm 120. The contact conduction between the tray 2 and the cleaning apparatus 20 is in turn realized to charge the cleaning apparatus 20, or the contact disconnection between the tray 2 and the cleaning apparatus 20 is realized to disconnected charging of the cleaning apparatus 20.

From the above, the tray 2 provided in this embodiment can effectively prevent the tray 2 from sparking, so that a service life, performance and safety of the tray 2 is improved.

Figure 14 shows a schematic three-dimensional structural diagram of an upright arm according to an embodiment of the present disclosure. Figure 15 shows a sectional view of an upright arm according to an embodiment of the present disclosure.

Referring to Figure 14 to Figure 15, an upright arm is further provided in an embodiment of the present disclosure. The upright arm includes a supporter 121, a trigger 122, and a microswitch 123.

The supporter 121 has a receiving groove 1211, and the receiving groove 1211 has a first position and a second position spaced apart from each other.

The trigger 122 is movably disposed in the receiving groove 1211.

The microswitch 123 is connected to the trigger 122. When the trigger 122 is placed at the first position, the microswitch 123 is in an off state. When the trigger 122 is placed at the second position, the microswitch 123 is in an on state.

In this embodiment, the upright arm 120 is optimized and designed to be suitable for a device with an internal circuit. The upright arm 120 can regulate the conduction or disconnection of the internal circuit of the device. Specifically, the upright arm 120 is at least a combined component integrating the supporter 121, the trigger 122, and a microswitch 123. The supporter 121 at least has an effect of supporting other components. The trigger 122 is arranged in conjunction with the microswitch 123 on the supporter 121. Movement of the trigger 122 realizes the electrical conduction or disconnection of the microswitch 123, thereby realizing the electrical conduction or disconnection of the internal circuit of the device.

Specifically, in order to accommodate the trigger 122, a receiving groove 1211 is provided on the supporter 121, and the trigger 122 is accommodated and movable in the receiving groove 1211. For example, but not limited to, the trigger 122 is a triggering rod. In order to realize the linkage between the microswitch 123 and the trigger 122, an end of the moving member 1231 is connected to the trigger122. In this way, movement of the trigger 122 drives the moving member 1231 to rotate and enables the moving member 1231 to conduct or disconnect the two electrodes of the microswitch 123. Thereby, an energization state between the two electrodes of the microswitch 123 is changed, thereby realizing conduction or disconnection of the internal circuit of the device having the upright arm 120.

In an embodiment, the microswitch 123 is connected and secured to the supporter 121 through fasteners such as screws/bolts, so as to maintain the stability of the microswitch 123. Apparently, in other embodiments, the microswitch 123 may be detachably connected to the supporter 121 through a snap or other structures, as long as it is ensured that the microswitch 123 does not fall off from the supporter 121. It should be noted that the specific connection mode between the microswitch 123 and the supporter 121 is not limited as in the embodiment.

Furthermore, a triggering mode in which the trigger 122 and the microswitch 123 act in conjunction is further provided in an embodiment. In this triggering mode, part of the structure of the microswitch 123 is configured as a combined component including the moving member 1231, the first electrode and the second electrode. An end of the moving member 1231 is rotationally and electrically connected to the first electrode, and the other end of the moving member 1231 is connected to the trigger 122. In this way, the trigger 122 can be driven to realize the conduction or disconnection between the moving member 1231 and the second electrode. It can be understood that in this triggering mode, the trigger 122 moves linearly in the receiving groove 1211, so as to drive the moving member 1231 to move curvedly.

Referring to Figure 14, in a possible implementation, the supporter 121 includes a support box and a mounting plate. The support box is arranged vertically on the mounting plate.

The receiving groove 1211 is opened in the support box, and the microswitch 123 is connected to the support box.

In this embodiment, specific structure of the supporter 121 is optimized. Specifically, the supporter 121 is provided as a combined component including at least a support box and a mounting plate. The support box at least has a supporting effect and is configured to store the trigger 122/microswitch 123. The mounting plate at least configured to provide a mounting position for the support box and enable connection of the supporter 121 with other components in the positioning seat 22.

In a possible implementation, the support box includes a first housing 1 and a second housing 2. The first housing 1 is arranged perpendicularly on the mounting plate, and the first housing 1 has an open end. The second housing 2 is covered on the open end of the first housing 1 to form an accommodation chamber.

The receiving groove 1211 is disposed at the open end of the first housing 1, and the microswitch 123 is disposed in the accommodation chamber.

Figure 16 shows a schematic three-dimensional structural diagram of a cleaning system according to an embodiment of the present disclosure. Figure 17 shows a partial sectional view of a cleaning system in a first position according to an embodiment of the present disclosure. Figure 18 shows a partial sectional view of a cleaning system in a second position according to an embodiment of the present disclosure.

Specific structure and principle of the tray can be referred to the above-described cleaning system, and are not introduced in further detail here.

For ease of understanding, the technical solution provided in the present disclosure is described below in combination with specific application scenarios. In the following application scenarios, the cleaning apparatus is a floor scrubber, as an example.

### Application Scenario 1

In the cleaning system, the charging male plug 3 is disposed on the positioning seat 22 of the tray 2, and the charging female plug 4 is disposed on the body 11. When the floor scrubber is placed from top to bottom onto the tray 2, the floor brush assembly 12 is fitted on the base 21 of the tray 2, and the body 11 is fitted on the positioning seat 22, so that the limiting part 221 can support the rear side of the body 11. After the body 11 is fitted with the positioning seat 22, the charging female plug 4 can be in plug fit with the charging male plug 3 on the positioning seat 22. The charging male plug 3 is arranged in a direction consistent with a direction in which the body 11 is supported on the limiting part 221. The two first pole pieces 31 on the charging male plug 3 are arranged on the left and right sides, and extend out of the opening 331 of the receiving cavity 330 under the action of the elastic device 32. The charging male plug 3 extends into the slot of the charging female plug 4, and is squeezed by the second pole pieces 41, so that the first pole pieces 31 at least partially retract into the receiving cavity 330. Thereby, the first pole pieces 31 are pre-pressed against the corresponding second pole pieces 41 under the action of the elastic device 32, realizing electrical conduction between the first pole pieces and the second pole pieces. When the body 11 shakes back and forth, although the first pole pieces 31 and the second pole pieces 41 located on the left and right sides move relative to each other, it is ensured that the first pole pieces 31 and the second pole pieces 41 are maintained in contact with each other. Therefore, charging of the cleaning apparatus is not affected.

### Application Scenario 2

In the cleaning system, the charging female plug 4 is disposed on the positioning seat 22 of the tray 2, and the charging male plug 3 is disposed on the body 11. When the floor scrubber is placed from top to bottom onto the tray 2, the floor brush assembly 12 is fitted on the base 21 of the tray 2, and the body 11 is fitted on the positioning seat 22, so that the limiting part 221 can support the rear side of the body 11. After the body 11 is fitted with the positioning seat 22, the charging male plug 3 can be in plug fit with the charging female plug 4 on the positioning seat 22. The slot of the charging female plug 4 is arranged in a direction consistent with a direction in which the body 11 is supported on the limiting part 221. The two first pole pieces 31 on the charging male plug 3 are arranged on the left and right sides, and extend out of the opening 331 of the receiving cavity 330 under the action of the elastic device 32. The charging male plug 3 extends into the slot of the charging female plug 4, and is squeezed by the second pole pieces 41, so that the first pole pieces 31 at least partially retract into the receiving cavity 330. Thereby, the first pole pieces 31 are pre-pressed against the corresponding second pole pieces 41 under the action of the elastic device 32, realizing electrical conduction between the first pole pieces and the second pole pieces.

Described above are embodiments of the present disclosure. The above description is illustrative, not exhaustive, and is not limited to the disclosed embodiments. Many modifications and alternations are apparent to those skilled in the art without departing from the scope and spirit of the described embodiments. The terminology used herein is determined to best explain principles, practical applications, or technical improvements in the market of the embodiments, or to enable other persons of ordinary skill in the art to understand the embodiments disclosed herein. The scope of the present disclosure is defined by the appended claims.

### Application Scenario 3

A tray 2 includes a positioning seat 22 and a base 21. The positioning seat 22 includes a charging male plug 3 and an upright arm 120 disposed in the positioning seat 22. The upright arm 120 specifically includes a supporter 121, a trigger rod, a spring, and a microswitch 123. The supporter 121 includes a mounting plate and a support box formed by assembling a rear shell and a transparent front shell. The support box is vertically connected to the mounting plate, and an accommodation chamber is formed between the rear shell and the transparent front shell. For example, but not limited to, the transparent front shell is made of acrylic material. A horizontal receiving groove 1211 is defined on the support box in a direction parallel to the mounting plate. The receiving groove 1211 penetrates the support box, and the trigger rod is movably disposed in the receiving groove 1211. The spring is arranged below the receiving groove 1211. An end of the spring is sleeved outside a limiting bump of the trigger rod, and the other end is nested in the limiting groove of the support box. In this way, elastic connection between the trigger rod and the support box is realized. The microswitch 123 is arranged above the receiving groove 1211. Specifically, the microswitch 123 includes a metal guide rod, a first electrode and a second electrode. The first electrode is connected to a pole of a charging contact piece of the tray 2 through a wire. The second electrode is connected to another pole of the charging contact piece of the tray 2 through another wire. An end of the metal guide rod is rotationally connected to the first electrode, and the other end of the metal guide rod is connected to the trigger rod. In this way, movement of the trigger rod drives the metal guide rod to rotate around the first electrode, so that the other end of the metal guide rod comes into contact with the second electrode. Thereby, an electrical conduction of the microswitch 123 is achieved and in turn an electrical conduction of an internal circuit of the tray 2 is realized.

In a case where the upright arm 120 is applied to the tray 2, the electrical conduction or disconnection of the internal circuit of the positioning seat 22 can be manipulated through the upright arm 120, so as to adjust the electrical conduction and disconnection of the microswitch 123 of the upright arm 120. Hence, an electrical conduction or disconnection of the internal circuit of the charging device is enabled, thereby realizing a charging function and power-off function of the charging device. In this way, when a to-be-charged device is placed on the tray 2 for charging, sparking due to direct electrical conduction between the charging contact piece of the to-be-charged device and the tray 2 can be avoided, where the sparking may cause damage/destruction of the charging contact piece of the tray 2, and the like.

### Application Scenario 4

Referring to Figure 16, the cleaning apparatus 20 is a floor scrubber, and the tray 2 is a tower of the floor scrubber. Specifically, the floor scrubber includes a body assembly, a universal head and a floor brush assembly. The floor brush assembly is connected to the bottom end of the body assembly through the universal head. The tower of the floor scrubber includes a positioning seat 22 and an upright arm 120. The upright arm 120 is disposed inside the positioning seat 22 for regulating electrical conduction and electrical disconnection of an internal circuit of the positioning seat 22.

Alternatively, the body assembly includes a body, a lower decorative cover of the body, and a charging assembly of the body. The charging assembly of the body is connected and fastened to a rear cover of the body, and is covered by the lower decorative cover of the body, and locked with a screw/bolt. In this way, the charging assembly of the body is disposed inside the body assembly, in order to prevent damage to the charging assembly of the body from an external environment. It should be understood that the lower decorative cover of the body is arranged toward the floor brush assembly.

Further, the charging assembly of the body includes an outer casing, a first charging contact piece (i.e., the charging female plug 4), and a first charging contact piece bracket. The first charging contact piece and the first charging contact piece bracket are glued and fixed together, and then disposed within the outer casing and faces the floor brush assembly. The outer casing has an open end. The open end of the outer casing caps on the back cover of the body, and a sealed chamber is formed between the outer casing and the back cover. The first charging contact piece and the first charging contact piece bracket are arranged in the sealed chamber. It should be understood that an exposure opening is provided at the lower decorative cover of the body to expose the first charging contact piece, so as to facilitate electrical conduction between the first charging contact piece and the tower of the floor scrubber.

Alternatively, the floor brush assembly includes a floor brush body and a floor brush lower cover (i.e., the pusher 24). The floor brush lower cover is fixed to the bottom of the floor brush body through screws/screws.

Alternatively, a second charging contact piece (i.e., charging male plug 3) is provided on the top of the positioning seat 22. The second charging contact piece is used in conjunction with the first charging contact piece. A lower position of the positioning seat 22 is provided with a movable hole. The upright arm 120 is disposed inside the positioning seat 22, and the receiving groove 1211 of the upright arm 120 is correspondingly arranged and connected with the movable hole on the positioning seat 22 to form a r-the receiving groove 1211. The trigger 122 is movably disposed in the receiving groove 1211. The first electrode and the second electrode of the microswitch 123 are respectively connected to two ends of the second charging contact piece. An end of the moving member 1231 of the microswitch 123 is rotationally and electrically connected to the first electrode, and the other end is connected to the trigger 122; The moving member 1231 can move under the driving of the trigger 122 to be conducted to or disconnected from the second electrode. Thereby, conduction or disconnection of the internal circuit of the tower of the floor scrubber is realized.

Referring to Figure 17 and Figure 18, a charging operation of the floor scrubber is as follows. First, the floor scrubber is placed on the positioning seat 22 for charging (placing the floor scrubber from top to bottom). The first charging contact piece of the body assembly is first in contact with the second charging contact piece of the tower of the floor scrubber. The floor brush lower cover of the floor brush assembly is not in contact with the trigger 122. In this case, the trigger 122 is placed at the first position, the moving member 1231 is not electrically conducted to the second electrode, the microswitch 123 has not realized the conduction of the internal circuit of the positioning seat 22, and the tower of the floor scrubber cannot charge the floor scrubber. Then, the floor scrubber is placed lower, by about 10 mm, and the first charging contact piece of the body assembly is completely electrically connected to the second contact piece of the tower of the floor scrubber. The floor brush lower cover of the floor brush assembly abuts the trigger 122, and pushes the trigger 122 to move in the receiving groove 1211. In this case, the trigger 122 moves from the first position to the second position, the moving member 1231 is electrically connected to the second electrode, and the microswitch 123 is closed, and the internal circuit of the positioning seat 22 is conducted. Thereby, the tower of the floor scrubber starts charging the floor scrubber.

After charging of the floor scrubber is completed, the floor scrubber is directly taken out from the tower of the floor scrubber.

It can be understood that in this embodiment, the electrical connection between the floor scrubber and the tower of the floor scrubber is not achieved as soon as the first charging contact piece comes into contact with the second charging contact piece. A "trigger 122-microswitch 123" mechanism is added to regulate and control, such that the electrical conduction between the first charging contact piece and the second charging contact piece occurs when the moving member 1231 of the microswitch 123 is electrically conductive with the second electrode. In this way, direct electrical conduction between the first charging contact piece and the second charging contact piece is avoided. Meanwhile, a problem of an increased oxidation area of the second charging contact piece, and a reduced contact area between the second charging contact piece and the first charging contact piece caused by the sparking due to conduction between the floor scrubber and the tower of the floor scrubber is avoided. Hence, it is beneficial to shortening a charging time of the floor scrubber and reducing a disadvantageous situation where the floor scrubber cannot be charged on the tower of the floor scrubber.

### Application Scenario 5

The cleaning apparatus provided in the embodiments of the present disclosure can be adopted for cleaning dirt on a floor. Since the dirt on the floor is a mixture of solid and liquid, when the cleaning apparatus is controlled to travel over the dirt area on the floor, a bottom surface of the rolling brush 201 of the rolling brush assembly 200 directly corresponds to the floor, so that the surface of the rolling brush 201 is in contact with the dirt area, so that the solid and liquid in the dirt area are adhered to the surface of the rolling brush 201. With the rotation of the rolling brush 201, the surface of the rolling brush 201 with the solid and liquid is rotated to the area of the scraper assembly 400 for separation. The plate 401 of the scraper assembly 400 comes into contact with the surface of the rolling brush 201, so as to clean up the solid from the surface of the rolling brush 201 and squeeze out the liquid from the surface of the rolling brush 201. The solid and liquid are sucked and collected through the suction port 300 below through a negative pressure. With the use of the cleaning device, fluff on the rolling brush 201 is degraded in resilience, water absorption and other properties as the use term becomes longer, resulting in loss of the fluff on the rolling brush 201, and a reduced diameter of the rolling brush 201. Under the driving of the driver 600, the plate 401 of the rolling brush assembly 200 has a first position. In the first position, the plate 401 is always pressed against the rolling brush 201 under the driving force of the driver 600. That is, the scraper assembly 400 is changed from a fixed mode to a rotatable and movable mode, so that the first position is not a unique fixed specific position throughout the use period of the cleaning apparatus. With the reduction of the diameter of the rolling brush 201, the first position of the plate 401 changes accordingly. That is, as the diameter of the rolling brush 201 decreases due to wear and tear, the rotating scraper assembly can always keep squeezing the rolling brush 201. Therefore, when the rolling brush 201 is used for a long time, the scraper still has a good scraping effect. Hence, occurrence of water marks after use of the apparatus is reduced, and the time for the floor to dry remains short.

### Application Scenario 6

The rolling brush assembly 200 is detachably installed on the cleaning apparatus. The rolling brush assembly 200 includes a fixing member located at an axial end of the rolling brush 201. The fixing member is for detachably fixing the rolling brush 201 to the floor brush base 100. The spray assembly 500 is fixed on the rolling brush cover 800 through a screw. A torsion spring is preloaded on the spray assembly 500. The torsion spring is installed at both ends of the scraper assembly 400. The scraper assembly 400 is installed on the spray assembly 500 through the torsion spring at ends. Specifically, the pivot 405 is installed on the spray assembly 500 through the shaft hole 404 of the scraper. The plate 401 extends in the axial direction of the rolling brush 201, and comes into contact with the rolling brush 201 in the axial direction. The torsion spring exerts on the scraper assembly 400 a force toward the rolling brush 201. In a case where the rolling brush 201 is not installed, the plate 401 of the scraper assembly 400 is in the second position (initial position). After the rolling brush 201 is installed, the plate 401 of the scraper assembly 400 is pushed by the rolling brush 201 and rotates in a direction away from the rolling brush 201. The rotation direction in this case is shown by the arrow in Figure 26. Thereby, the plate 401 of the scraper assembly 400 is located in the first position. When the rolling brush 201 is worn or bristles are docile, the force of the torsion spring enables the scraper assembly 400 to rotate around the pivot 405 toward the second position and keep pressing against the rolling brush 201 tightly.

Some embodiments in the present disclosure are described in a progressive or parallel manner, and each of the embodiments focuses on its differences from the other embodiments. The same or similar parts among the embodiments may be referred to each other.

### Application Scenario 7

The cleaning apparatus of the present disclosure may be a floor scrubber. When a user starts the cleaning apparatus to clean a floor, the cleaning apparatus pumps water to the rolling brush assembly 2, so that the rolling brush assembly 2 can clean up remaining stains on the floor. Since much water is applied on the rolling brush assembly 2, a problem that sewage enters into the inner cavity 25 of the rolling brush assembly 2 inevitably occurs during the rotation of the rolling brush assembly 2.

As the driving device 5 drives the rolling brush assembly 2 to rotate, an external airflow enters the communication channel 142 through a communication channel entrance 1421 on the second handle 12 under an action of negative pressure. Then, the airflow flows in the communication channel 142 and arrives at the connecting sleeve 141, and then enters the heat dissipation channel 6 of the driving device 5 through the heat dissipation channel entrance 61. After entering the heat dissipation channel 6, the airflow flows along the heat dissipation channel 6 to cool the driving device 5. Then, the airflow flows out from the heat dissipation channel exit 62 and enters the inner cavity 25 of the rolling brush assembly 2, to dry the inner cavity 25 of the rolling brush assembly 2. In this way, bacteria, odor, and the like, due to accumulation of the sewage in the inner cavity of the cleaning device are avoided.

In addition, in the cleaning apparatus of the present disclosure, the driving device 5 is located in the inner cavity of the rolling brush assembly 2, and the output end of the driving device 5 is connected to the inner wall of the rolling brush assembly 2 in a transmission manner. Thereby, a transmission relationship between the driving device 5 and the rolling brush assembly 2 is simplified, and therefore a traditional transmission mechanism is no longer necessary for transmission. Hence, the cleaning surface of the rolling brush assembly 2 is increased.

### Application Scenario 8

When entering the heat dissipation channel 4, the external airflow first enters the first heat dissipation channel 63 to cool the internal components in the driving device 5. Then, the airflow flows out from the first heat dissipation channel 63 and enters the second heat dissipation channel 64 formed by the motor housing 51 and the motor shield 53. Finally, the airflow flows out from the heat dissipation channel exit 62 and enters the inner cavity 25 of the rolling brush assembly 2, to dry the inner cavity 25 of the rolling brush assembly 2. In this way, bacteria, odor, and the like, due to accumulation of the sewage in the inner cavity of the cleaning device are avoided. The cleaning apparatus of the present disclosure is provided with the second heat dissipation channel 64 formed by the motor housing 51 and the motor shield 53. In this way, a passage from the heat dissipation channel exit 62 to the inside of the motor housing 51 is extended, and therefore the sewage in the rolling brush assembly 2 is prevented from entering the inside of the motor housing 51 through the heat dissipation channel 62. Even if some sewage enters the second heat dissipation channel 64, the sewage can be dried or blown dry by the cooling airflow during operation.

### Application Scenario 9

The cleaning apparatus of the present disclosure may be, for example, a floor scrubber. When the floor scrubber is working, the cleaning device of the floor scrubber is configured to clean the floor. The motor assembly forms a negative pressure in a sewage suction channel, so that sewage on the floor can be sucked into a sewage tank for storage through the suction port of the floor scrubber. When the motor assembly is working, the airflow formed by the motor assembly in the cleaning machine is transmitted through the air inlet duct 101 and discharged from the main air outlet 303 of the motor shield 304. Part of the airflow enters the motor 106 from the inner cavity of the battery pack assembly 513 through the heat dissipation channel 102 of the motor, and then is discharged from the main air outlet 303 of the motor shield 304.

The airflow flows to the first compartment 420 through the air inlet duct 101 of the motor. Part of the airflow flows into the silencing cavity 452 through the silencing hole 451 of the first silencing plate 450. The airflow is decelerated through the silencing hole 451 provided on the first silencing plate 450, and then enters the silencing cavity 452. Through the silencing cavity 452, a flow rate of the airflow is reduced, and thereby a noise is eliminated. The other part of the airflow flows into the first chamber 440 through the first through hole 421. The airflow entering the silencing cavity 452 flows further into the first compartment 420 and merges with other airflows, and the above-mentioned split flow pattern is repeated continuously. The airflow entering the first chamber 440 flows into the second compartment 430 through the second through hole 431. The airflow entering the second compartment 430 passes through the third through hole 461 and is then discharged from the main air outlet 303. During the transmission of the airflow in the first compartment 420, the first chamber 440, and the second compartment 430, a flow rate is gradually reduced and a flow direction is continuously changed. Therefore, a noise is reduced.

### Application Scenario 10

The cell assembly 503 surrounds in a circumferential direction of the heat dissipation shell 514, so that the cell assembly 503 defines an annular inner cavity 511 in the inner cavity of the heat dissipation shell 514. The second shield body 482 of the motor assembly extends into the annular inner cavity 511. The first shield body 481 and the motor shield 304 are located outside the heat dissipation shell 514. When the cleaning apparatus is working, the cell assembly 503 supplies power to the motor 106 of the cleaning apparatus, and causes an increase in a temperature of the cell assembly 503. When the motor 106 is working, the external airflow passes through the air inlet duct 101, the first compartment 420, the first chamber 440, and the second compartment 430, and finally flows out from the main air outlet 303. With the flow of the airflow, the motor 106 is cooled. That is, the battery pack assembly 513 can be quickly cooled through the second shield body 482 extending into the annular inner cavity 511.

The second shield body 482 extends to a half the height of the battery pack assembly 513. In this way, part of the heat emitted by the cell assembly 503 can be quickly dissipated into the annular inner cavity 511, and the other part of the heat can be directly conducted to the second shield body 482. Half of the height of the second shield body 482 extending into the battery pack assembly 513 is an optimal position for heat dissipation of the cell assembly 503 and noise reduction in the air duct. It is found, through experiments, that the heat dissipation effect of the cell assembly 503 is optimal in this case. The heat generated by the cell assembly 503 during operation can be taken away by the second shield body 482 to the greatest extent, so that the cell assembly 503 can be maintained at a suitable temperature. After a long-term use of the cleaning apparatus, a user can directly control to charge the cell assembly 503 without waiting for the cell assembly 503 to cool down. Hence, safety of the cleaning apparatus and user experience are improved.

### Application Scenario 11

In this application scenario, a battery pack assembly 513 is disposed above the motor shield 304. An inner cavity of the battery pack assembly 513 is connected with the heat dissipation channel 102 of the motor 106. When the motor 106 operates, a negative pressure is formed in the heat dissipation channel 102, thereby forming an air flow in the inner cavity of the battery pack assembly. When the cell assembly 503 supplies power to the motor and other electronic devices, the heat generated by the cell assembly is taken away by the airflow in the inner cavity of the battery pack assembly and discharged from the motor assembly through the heat dissipation channel 102 of the motor 106 itself. Hence, heat dissipation is realized for the battery pack assembly 513.
1. A charging base station for supplying electricity to a cleaning apparatus, wherein
   the cleaning apparatus comprises a first charging element and a pusher,
   the charging base station comprises a base and a tower provided on the base, the tower comprises a second charging element and an upright arm disposed in the tower, and the second charging element is able to be in contact with the first charging element;
   the upright arm comprises a supporter having a receiving groove, and the receiving groove has a first position and a second position spaced apart from each other;
   a trigger movably disposed in the receiving groove, wherein the pusher is capable of abutting against the trigger and pushing the trigger to move linearly between the first position and the second position; and
   a microswitch connected to the trigger, wherein the microswitch is electrically connected to the second charging element; when the trigger is placed at the first position, the microswitch is in an off state, and the first charging element is not conductive to the second charging element; and when the trigger is placed at the second position, the microswitch is in an on state, and the first charging element is conductive to the second charging element.
2. The charging base station according to item 1, wherein the trigger comprises a first section, a second section and a third section which are connected in the listed sequence, and the first section is arranged towards the pusher; and
   the microswitch comprises a cantilevered moving member, the microswitch is in the off state when a free end of the moving member away from the microswitch abuts against the second section, and the microswitch is in the on state when the free end of the moving member abuts against the first section.
3. The charging base station according to item 2, wherein the first section protrudes toward the moving member.
4. The charging base station according to item 3, wherein the second section is recessed toward a direction away from the moving member, and a groove is formed among the first section, the second section, and the third section.
5. The charging base station according to item 2, wherein the second section protrudes toward the moving member.
6. The charging base station according to item 2, wherein the upright arm further comprises an elastic member, a blocking portion is formed on a side of the receiving groove away from the microswitch, and the elastic member is disposed between the first section of the trigger and the blocking portion.
7. The charging base station according to item 2, wherein the receiving groove extends in a horizontal direction, the microswitch is disposed above the trigger, and the moving member is disposed toward the trigger.
8. The charging base station according to item 2, wherein the receiving groove is inclined, the microswitch and the trigger are arranged in parallel to each other, and the microswitch is located on a side of the trigger away from the cleaning apparatus, and the moving member is arranged toward the trigger.
9. The charging base station according to item 2, wherein the receiving groove is inclined, the microswitch and the trigger are arranged at an angle, and the microswitch is located on a side of the trigger away from the cleaning apparatus, and the moving member is arranged toward the trigger.
10. The charging base station according to item 2, wherein the microswitch further comprises a first electrode and a second electrode, the first electrode and the second electrode are electrically connected to the second charging element through wires, the moving member is cantilevered from the first electrode, and the microswitch is in an on state when the free end of the moving member is in contact with the second electrode.
11. A charging base station, comprising a base and a tower provided on the base, wherein the tower comprises a second charging element and an upright arm disposed in the tower, and the upright arm comprises:
   a supporter having a receiving groove, wherein the receiving groove has a first position and a second position spaced apart from each other;
   a trigger movably disposed in the receiving groove, wherein the trigger is capable of moving linearly between the first position and the second position; and
   a microswitch connected to the trigger, wherein the microswitch is electrically connected to the second charging element, the microswitch is in an off state when the trigger is placed at the first position; and the microswitch is in an on state when the trigger is placed at the second position.
12. A cleaning system comprising:
   a cleaning apparatus comprising a first charging element and a pusher;
   a charging base station comprising a base and a tower provided on the base, wherein the tower comprises a second charging element and an upright arm disposed in the tower, and the second charging element is able to be in contact with the first charging element;
   wherein the upright arm comprises: a supporter having a receiving groove, wherein the receiving groove has a first position and a second position spaced apart from each other; a trigger movably disposed in the receiving groove, wherein the pusher is capable of abutting against the trigger and pushing the trigger to move linearly between the first position and the second position; and a microswitch connected to the trigger, wherein the microswitch is electrically connected to the second charging element; and
   the first charging element is not conductive to the second charging element in a case where the trigger of the charging base station is pushed by the pusher to the first position; and the first charging element is conductive to the second charging element in a case where the trigger is pushed by the pusher to the second position.

1. A cleaning apparatus, comprising:
   a rolling brush rotatable around a first axis;
   a spray assembly for supplying a liquid to the rolling brush;
   a scraper assembly connected to the spray assembly and having a plate rotatable around a second axis, the plate is located below the spray assembly, and the second axis is parallel to the first axis;
   a driver configured for exerting on the scraper assembly a force toward the rolling brush, to drive the plate to rotate relative to the spray assembly;
   the plate has a first position and a second position; at the first position, the plate is maintained abutting against the rolling brush under a driving force from the driver; the second position is a limit position that the scraper assembly reaches under an action of the driver in a case where the rolling brush is not installed; and in a case where the rolling brush is installed, the plate rotates from the second position in a direction away from the rolling brush.
2. The cleaning apparatus according to item 1, wherein an edge of the plate, on a side close to the rolling brush, exceeds the spray assembly.
3. The cleaning apparatus according to item 1, wherein the second position is a position where the plate is closest to the rolling brush.
4. The cleaning apparatus according to item 1, wherein the driver is a torsional spring pre-stressed and loaded on the spray assembly, and the scraper assembly is provided with an installation position for fixing an end of the torsional spring.
5. The cleaning apparatus according to item 1, wherein the plate extends in a direction of the first axis, and lugs are formed on both ends of the plate in the extension direction, the lugs are located on a same side of the plate and are perpendicular to the plate, and the lugs are rotationally connected to the spray assembly through a pivot.
6. The cleaning apparatus according to item 5, wherein a shaft hole is defined on each lug for fitting to the pivot, and the shaft hole is obround.
7. The cleaning apparatus according to item 6, wherein the spray assembly has a side wall parallel to the lug, and the pivot is rotationally connected to the side wall and deviates from a center of the side wall.
8. The cleaning apparatus according to item 1, wherein the plate is provided with a reinforcing rib, and the reinforcing rib is a bulge convex toward the spray assembly.
9. The cleaning apparatus according to item 1, wherein when in the first position, the plate is tilted relative to a horizontal plane, and a height of the plate gradually decreases in a direction approaching the rolling brush.
10. The cleaning apparatus according to item 1, wherein a limiting bar is formed on a side of the spray assembly toward the plate; and when the plate in the second position, the plate abuts against the limiting bar under a driving force from the driver.
11. The cleaning apparatus according to item 10, wherein there are a plurality of the limiting bars, the limiting bars are arranged at intervals from each other, and a gap is formed between adjacent ones of the limiting bars.
12. The cleaning apparatus according to item 1, further comprising a base, wherein the base is provided with a sealing strip at a position below the plate, and the sealing strip is in interference fit with a bottom surface of the plate.
13. The cleaning apparatus according to item 12, wherein a drainage opening penetrating up and down is provided in the sealing strip at a position corresponding to a suction port of the cleaning apparatus.
14. The cleaning apparatus according to item 1, further comprising a rolling brush cover and a scraper blade, wherein the rolling brush cover is connected to the spray assembly and is located above the rolling brush; the scraper blade comprises a first part and a second part connected to each other, the first part extends obliquely downward from the rolling brush cover to be in contact with the rolling brush, and the second part extends obliquely downward from an end of the first part being in contact with the rolling brush and gradually away from the rolling brush.
15. The cleaning apparatus according to item 1, wherein the driver is an elastic member or a magnetic member.
16. A cleaning assembly applied to a cleaning apparatus, comprising:
   a rolling brush cover;
   a spray assembly fixed inside the rolling brush cover;
   a scraper assembly connected to the spray assembly and having a plate rotatable around a second axis, wherein the plate is located below the spray assembly; and
   a driver configured to drive the plate to rotate relative to the spray assembly and press the plate tightly against the rolling brush.

1. A cleaning system comprising:
   a cleaning apparatus, comprising a body (11) and a floor brush assembly (12), wherein the floor brush assembly is provided with a roller (120), the roller (120) is configured to rotate around an X-axis, and the floor brush assembly (12) is configured to be rotatable relative to the body (11) at least around an X-axis direction;
   a tray (2), configured for holding the cleaning apparatus; and
   a charging assembly, comprising a charging male plug (3) and a charging female plug (4) fit to the charging male plug (3), one of the charging male plug (3) and the charging female plug (4) is arranged on the body (11), and the other one is arranged on the tray (2); a first pole piece (31) is provided on each of opposite sides of the charging male plug (3) in the X-axis direction; and a second pole piece (41) is provided on the charging female plug (4) at a position corresponding to the first pole piece on the charging male plug (3).
2. The cleaning system according to item 1, wherein the charging male plug (3) is provided with an elastic device (32), and the elastic device (32) is configured to drive the first pole piece (31) to pre-press against the second pole piece (41).
3. The cleaning system according to item 2, wherein the charging male plug (3) comprises a housing (33) with a receiving cavity (330), and an opening (331) communicating with the receiving cavity (330) is provided on each of opposite sides of the housing (33), the first pole piece (31) is configured to at least partially stretch out of the opening (331) of the receiving cavity (330) under an elastic force from the elastic device (32), and to at least partially retract into the receiving cavity (330), overcoming the elastic force from the elastic device (32), in response to compression by the second pole piece (41).
4. The cleaning system according to item 3, wherein the elastic device (32) is disposed in the receiving cavity (330), and opposite ends of the elastic device (32) fit to two first pole pieces (31) respectively, and push the two first pole pieces (31) to move in opposite directions, until the two first pole pieces at least partially stretch out of the openings (331).
5. The cleaning system according to item 3, wherein a moving block (34) is movably connected in the receiving cavity (330) of the housing (33), and the first pole piece (31) is fixed on an end surface of the moving block (34) extending out of the opening; two ends of the elastic device (32) are respectively fitted to two moving blocks (34); the end surface of the moving block (34) extending out of the opening (331) is configured as an inclined guide surface, and the first pole piece (31) is disposed on the guide surface.
6. The cleaning system according to item 3, wherein a protrusion (311) is provided on an end surface of the first pole piece (31) for fitting to the second pole piece (41), and the protrusion (311) is configured for fitting to the second pole piece (41).
7. The cleaning system according to any one of items 1 to 6, wherein the tray (2) comprises a base (21) for fitting to the floor brush assembly (12), and a positioning seat (22) provided on the base, the charging female plug (4) is provided on the positioning seat (22) and is configured to fit to the charging male plug (3) on the body (11); or
   the charging male plug (3) is provided on the positioning seat and is configured to fit to the charging female plug (4) on the body (11).
8. The cleaning system according to item 7, wherein the charging female plug (4) or charging male plug (3) on the positioning seat is configured as extending vertically upward or obliquely upward.
9. The cleaning system according to item 8, wherein a limiting part (221) is further provided on the positioning seat (22), and the limiting part (221) is configured for blocking a rotation of the body (11) in the X-axis direction; the limiting part (221) defines a semi-open groove, a wall of the groove is configured as an inclined surface, and at least part of the body (11) is limited within an interval between the inclined surface and the charging male plug (3) or charging female plug (4) on the positioning seat.
10. A charging assembly, comprising a charging male plug (3) and a charging female plug (4) for fitting to the charging male plug (3), wherein the charging male plug (3) is configured to be rotatable relative to the charging female plug (4) at least around an X-axis direction;
   at least two first pole pieces (31) are provided on opposite sides of the charging male plug (3) in the X-axis direction; at least two second pole pieces (41) are provided on the charging female plug (4) at positions corresponding to the first pole pieces on the charging male plug (3).
11. A cleaning apparatus, configured to be placed on a tray (2), wherein the cleaning apparatus comprises a body (11) and a floor brush assembly (12), the floor brush assembly (12) is provided with a roller (120), the roller (120) is configured to rotate around an X-axis, and the floor brush assembly (12) is configured to be rotatable relative to the body (11) at least around an X-axis direction;
   a charging male plug (3) is provided on the body (11), and a first pole piece (31) is provided on each of opposite sides of the charging male plug (3) in the X-axis direction; or
   a charging female plug (4) is provided on the body (11), and a second pole piece (41) is provided on each of opposite sides of the charging female plug (4) in the X-axis direction.
12. A tray, configured for holding the cleaning apparatus according to item 11, wherein a charging male plug (3) is provided on the tray, and the first pole piece (31) is provided on each of opposite sides of the charging male plug (3) in an X-axis direction; or
   a charging female plug is provided on the tray, and the second pole pieces (41) is provided on each of opposite sides of the charging female plug (4) in the X-axis direction.

1. A cleaning apparatus, comprising:
   a body(1);
   a cleaning device configured to rotate relative to the body (1) to clean a to-be-cleaned surface, wherein the cleaning device has an inner cavity (21);
   a driving device connected to the body(1), wherein the driving device has a heat dissipation channel (4), and the driving device is configured to extend into the inner cavity (21) of the cleaning device and be in drive fit with the cleaning device; wherein
   an external airflow enters the heat dissipation channel (4) from a connection end between the driving device and the body, and enters the inner cavity (21) of the cleaning device through the heat dissipation channel.
2. The cleaning apparatus according to item 1, wherein the cleaning device is a cleaning drum (2), the body (1) is provided with a first arm (11) and a second arm (12) which are arranged oppositely, and the driving device is connected to the second arm (12); an end of the cleaning drum (2) is rotationally connected to the first arm (11); the driving device extends from the other end of the cleaning drum (2) into the inner cavity (21) of the cleaning drum (2), and is connected to the cleaning drum (2) in a transmission way.
3. The cleaning apparatus according to item 2, wherein the inner cavity (21) runs through two opposite ends of the cleaning drum (2), and an air outlet (15) is formed at an end of the cleaning drum (2) adjacent to the first arm (11).
4. The cleaning apparatus according to item 2, wherein the inner cavity (21) runs through two opposite ends of the cleaning drum (2), and an air outlet (15) is formed at an end of the cleaning drum (2) adjacent to the first arm (11).
5. The cleaning apparatus according to item 2, wherein the driving device is a motor assembly (3), a connection end of the motor assembly (3) is fixedly connected to the second arm (12), and an output end of the motor assembly (3) is connected to an inner wall of the cleaning drum (2) in a transmission way.
6. The cleaning apparatus according to item 5, wherein the motor assembly (3) comprises a motor housing (31) and an output shaft (32) extending out of the motor housing (31); the heat dissipation channel (4) comprises a heat dissipation channel entrance (41) provided on an connection end of the motor housing (31), a connecting sleeve (121) is provided on the second arm (12), the connecting sleeve (121) is docked with the heat dissipation channel entrance (41) of the motor housing (31); and an external airflow is supplied to pass through the connecting sleeve (121) and enter the heat dissipation channel entrance (41) of the motor housing (31).
7. The cleaning apparatus according to item 6, wherein a communication channel (122) is provided on the second arm (12), an end of the communication channel (122) is communicated to the connecting sleeve (121), and the other end of the communication channel extends along an extension direction of the second arm (12), and a communication channel entrance (1221) is formed on a side wall of the second arm (12).
8. The cleaning apparatus according to item 7, wherein a thickness of the communication channel (122) is at least 3mm or more, and the communication channel (122) is configured for wiring for electrical connection to the motor assembly (3).
9. The cleaning apparatus according to item 7, wherein a side facing a user is defined as a front side, and a side facing away from the user is defined as a rear side; the first arm (11) and the second arm (12) are configured as extending from an edge of the body (1) toward the rear side; and each of the first arm (11) and the second arm (12) has a thickness in a range from 4mm to 6mm.
10. The cleaning apparatus according to item 7, wherein the motor assembly (3) comprises a motor shield (33) sleeved outside the motor housing (31), and the motor shield (33) is configured in a shape adapted to the motor housing (31), an end of the motor shield (33) is fixedly connected to an output shaft (32) of the motor assembly (3), and the other end of the motor shield is rotationally connected to the motor housing (31).
11. The cleaning apparatus according to item 10, wherein the motor assembly (3) further comprises a decorative sleeve (34), the decorative sleeve (34) is rotationally connected to the connection end of the motor housing (31) through a bearing (35), and an end of the motor shield (33) extends to fit with the decorative sleeve (34).
12. The cleaning apparatus according to item 10, wherein a transmission base (22) is provided on the inner wall of the cleaning drum (2), the transmission base (22) has a transmission cavity (221) facing the motor assembly (3); an end of the motor shield (33) adjacent to the output shaft (32) forms a transmission head (321); and the transmission head (321) is configured to be detachable fit with the transmission cavity (221) by plugging.
13. The cleaning apparatus according to item 12, wherein the cleaning drum (2) is rotationally connected to the first arm (11) in a detachable manner; or the cleaning drum (2) is rotationally connected to the first arm (11), and the first arm (11) is detachably connected to the floor brush assembly (1).
14. The cleaning apparatus according to item 12, wherein the transmission base (22) is provided with a through hole (222) for airflow to pass through.
15. The cleaning apparatus according to item 10, wherein the heat dissipation channel (4) comprises a first heat dissipation channel (43) provided inside the motor housing (31), and a second heat dissipation channel (44) provided between the motor housing (31) and the motor shield (33); the motor housing (31) is provided with a intercommunicating hole (42) connecting the first heat dissipation channel (43) and the second heat dissipation channel (44); and a heat dissipation channel outlet (42) communicated to the second heat dissipation channel (44) is provided on the motor shield (33) at a position close to the output end.

1. A cleaning apparatus, comprising a motor assembly, wherein the motor assembly comprises:
   a motor shield (300);
   a silencing shield (400) located inside the motor shield (300), wherein the silencing shield (400), together with an inner wall of the motor shield (300), defines a first chamber (440) extending along an axial direction of the silencing shield (400);
   a motor (100), wherein an air inlet duct (101) is provided in the motor (100), the motor (100) is at least partially located inside the silencing shield (400), and the motor (100), together with an inner wall of the silencing shield (400), defines a second chamber (410) extending along an axial direction of the motor (100); and
   a partition (201) configured to divide the second chamber (410) into a first compartment (420) communicated to an outlet of the air inlet duct (101), and a second compartment (430) separated from the first compartment (420); wherein the air inlet duct (101), the first compartment (420), the first chamber (440), and the second compartment (430) are communicated in the above-listed sequence.
2. The cleaning apparatus according to item 1, wherein a mounting base (301) is provided inside the motor shield (300), and an end of the motor (100) is assembled in the mounting base (301) through a shock-absorbing pad (200); an entrance of the air inlet duct (101) of the motor (100) is connected to a main inlet (302) provided on the mounting base (301); and the shock-absorbing pad (200) extends along an outer contour of the motor (100) into the second chamber (410) and forms the partition (201).
3. The cleaning apparatus according to item 2, wherein the partition (201) is integrally formed with a shock-absorbing pad (200), and the partition (201) extends radially outward from the shock-absorbing pad (200) to be in sealing contact with an inner wall of the silencing shield (400).
4. The cleaning apparatus according to item 1, wherein at least part of an end surface of the partition (201) is configured to be flush with an outlet of the air inlet duct (101).
5. The cleaning apparatus according to item 2, wherein a first through hole (421) connecting the first compartment (420) and the first chamber (440) is provided on a side wall of the silencing shield (400) at a position corresponding to the first compartment (420); a second through hole (431) connecting the second compartment (430) and the first chamber (440) is provided on a side wall of the silencing shield (400) at a position corresponding to the second compartment (430); a second silencing plate (460) is provided in the second compartment (430), and the second silencing plate (460) is provided with a third through hole (461); and the second compartment (430) is connected to the main outlet (303) provided on the motor shield (300) through the third through hole (461) in the second silencing plate (460).
6. The cleaning apparatus according to item 5, wherein the second silencing plate (460) is installed inside the motor shield (300), and has an edge configured to block the first chamber (440) defined by the silencing shield (400) and the motor shield (300).
7. The cleaning apparatus according to item 5, wherein a diameter of the first through hole (421) is greater than a diameter of the second through hole (431), and the diameter of the second through hole (431) is greater than a diameter of the third through hole (461).
8. The cleaning apparatus according to item 5, wherein a region where the first through hole (421) is located is defined as a first air outlet side, and a region where the second through hole (431) is located is defined as a second air outlet side; and a total air outlet area A on the second air outlet side, a total air outlet area B on the first air outlet side, and a total air outlet area C of an exit of the air inlet duct (101) satisfy a relationship of A>B>C.
9. The cleaning apparatus according to item 5, wherein a total air inlet area D of the main inlet (302) on the mounting base (301) and the total air outlet area C of the exit of the air inlet duct (101) satisfy a relationship of C>2.5D.
10. The cleaning apparatus according to item 5, further comprising a soundproof plate (470) disposed in the first chamber (440), wherein the soundproof plate (470) divides the first chamber (440) into two cavities connected to the first through hole (421) and the second through hole (431), respectively; a fourth through hole (471) is provided on the soundproof plate (470); and a diameter of the fourth through hole (470) is less than the diameter of the first through hole (421) and the diameter of the second through hole (431).
11. The cleaning apparatus according to item 10, wherein the diameter of the third through hole (461) and the diameter of the fourth through hole (471) are in a range from 1.3mm to 3mm; and the diameter of the first through hole (421) and the diameter of the second through hole (431) are in a range from 3mm to 6mm.
12. The cleaning apparatus according to any one of items 1 to 11, further comprising a battery pack assembly (500), wherein the battery pack assembly (500) comprises a heat dissipation shell (501) and a cell assembly (503) located inside the heat dissipation shell (501); the cell assembly (503) is arranged surrounding in a circumferential direction of the heat dissipation shell (501), and defines an annular inner cavity (511) inside the heat dissipation shell (501); and
   a part of the motor assembly extends into the annular inner cavity (511), and the other part of the motor assembly is located outside the heat dissipation shell (501).
13. The cleaning apparatus according to item 12, wherein the silencing shield (400) comprises a first shield body (401) located in the motor shield (300), and the first shield body (401) and the inner wall of the motor shield (300) form the first chamber (440); and the silencing shield (400) further comprises a second shield body (402) connected to the first shield body (401) and extending into the annular inner cavity (511) of the battery pack assembly (500).
14. The cleaning apparatus according to item 13, wherein the second shield body (402) extends to a position at a half of the height of the battery pack assembly (500).
15. The cleaning apparatus according to item 13, wherein in the heat dissipation shell (501), a plurality of battery compartments (502) is provided in the circumferential direction of the heat dissipation shell (501), and the cell assembly (503) is installed in the battery compartments (502).
16. The cleaning apparatus according to item 15, wherein a side wall of the heat dissipation shell (501) protrudes radially outward and forms a semi-open battery compartment (502); an outer wall of the second shield body (402) is provided with heat dissipation grooves (504) in one-to-one correspondence with the battery compartments (502), and the heat dissipation grooves (504) are configured to be in fit with at least part of the surface of the cell assembly (503) exposed from the battery compartments (502).
17. The cleaning apparatus according to item 13, wherein an end surface of the heat dissipation shell (501) is provided with a heat dissipation inlet (505) connected to the annular inner cavity (511); the motor (100) is provided with a heat dissipation channel (102), and the second shield body (402) is provided with a heat dissipation through hole (506) connecting the heat dissipation channel (102) and the annular inner cavity (511); when the motor (100) operates, a negative pressure is formed in the heat dissipation channel (102), enabling an external airflow to flow through the annular inner cavity (511) via the heat dissipation inlet (505), to perform heat dissipation for the cell assembly (503).
18. A motor assembly, comprising:
   a motor shield (300);
   a silencing shield (400) located inside the motor shield (300), wherein the silencing shield (400), together with an inner wall of the motor shield (300), defines a first chamber (440) extending along an axial direction of the silencing shield (400);
   a motor (100), wherein an air inlet duct (101) is provided in the motor (100), the motor (100) is at least partially located inside the silencing shield (400), and the motor (100), together with an inner wall of the silencing shield (400), defines a second chamber (410) extending along an axial direction of the motor (100); and
   a partition (201) configured to divide the second chamber (410) into a first compartment (420) communicated to an outlet of the air inlet duct (101), and a second compartment (430) separated from the first compartment (420); wherein the air inlet duct (101), the first compartment (420), the first chamber (440), and the second compartment (430) are communicated in the above-listed sequences.

## Claims

1. A cleaning apparatus, comprising:
a floor brush base (100);
a rolling brush (201) installed on the floor brush base (100) and rotatable around a first axis;
a spray assembly (500) installed on the floor brush base (100) and configured for supplying a liquid to the rolling brush (201);
a scraper assembly (400) connected to the spray assembly (500) and having a plate (401) rotatable around a second axis, the plate (401) is located below the spray assembly (500);
a driver (600) configured for driving the plate (401) to rotate, so as to maintain the plate (401) abutting against the rolling brush (201).

2. The cleaning apparatus according to claim 1, wherein a gap is between the floor brush base (100) and the plate (401), and the floor brush base (100) is provided with a sealing strip (700) for sealing the gap.

3. The cleaning apparatus according to claim 2, wherein the sealing strip (700) is located between the plate (401) and a suction port (300) of the cleaning apparatus.

4. The cleaning apparatus according to claim 1, wherein the floor brush base (100) is provided with a sealing strip (700) at a position below the plate (401), and the sealing strip (700) is in interference fit with a bottom surface of the plate (401).

5. The cleaning apparatus according to any of claims 2 to 4, wherein a drainage opening (701) penetrating up and down is provided in the sealing strip (700) at a position corresponding to a suction port (300) of the cleaning apparatus.

6. The cleaning apparatus according to any of claims 1 to 4, wherein the plate (401) extends along an axial direction of the rolling brush (201), and on a side of the spray assembly (500) close to the rolling brush (201), an edge of the plate (401) exceeds the spray assembly (500).

7. The cleaning apparatus according to claim 6, wherein the edge of the plate (401) exceeds water outlets (501) of the spray assembly (500), the plate (401) or a portion of the plate (401) exceeding the spray assembly (500) is tilted relative to a horizontal plane, and a height of the plate (401) or a height of the portion of the plate (401) gradually decreases in a direction approaching the rolling brush (201).

8. The cleaning apparatus according to claim 6 or 7, wherein the edge of the plate (401) extends into fluff on the rolling brush (201).

9. The cleaning apparatus according to claim 1, wherein the rolling brush (201) is detachably installed on the floor brush base (100), and in a case where the rolling brush (201) is not installed, the plate (401) is in an initial position, and in a case where the rolling brush (201) is installed, the plate (401) rotates from the initial position in a direction away from the rolling brush (201).

10. The cleaning apparatus according to claim 9, wherein in the case where the rolling brush (201) is installed, a force exerted by the plate (401) on the rolling brush (201) is in a range of 5N to 15N.

11. The cleaning apparatus according to claim 9, wherein the driver (600) is a torsional spring pre-stressed and loaded on the spray assembly (500), and the scraper assembly (400) is provided with an installation position for fixing an end of the torsional spring; and wherein the plate (401) extends in a direction of the first axis, and lugs (402) are formed on both ends of the plate (401) in the extension direction, the lugs (402) are located on a same side of the plate (401) and are perpendicular to the plate (401), and the lugs (402) are rotationally connected to the spray assembly (500) through a pivot.

12. The cleaning apparatus according to claim 9, wherein a limiting bar (502) is formed on a side of the spray assembly (500) toward the plate (401); and in the case where the rolling brush (201) is not installed, the plate (401) abuts against the limiting bar (502) under a driving force from the driver (600).

13. The cleaning apparatus according to claim 1, wherein a rotation stroke of the plate (401) around the second axis is in a range of 3° to 8°.

14. The cleaning apparatus according to claim 1, wherein the scraper assembly (400) is located behind a traveling direction of the rolling brush (201), and a contact position between the plate (401) and the rolling brush (201) is located at midpoint or higher in a vertical direction of the rolling brush (201).

15. The cleaning apparatus according to claim 1, further comprising a rolling brush cover (800), and the rolling brush cover (800), the spray assembly (500), the scraper assembly (400) and the driver (600) are combined into an integral unit structure, the integral unit structure is detachably installed on the cleaning apparatus.
